# EUROPEAN PATENT SPECIFICATION

(11) **EP 2 884 552 B1**
(45) Date of publication and mention of the grant of the patent: **19.05.2021**
(21) Application number: 13827709.0
(22) Date of filing: 23.07.2013
(51) Int. Cl.: H01L 51/54, G09F 9/30, C09K 11/06

(54) **ORGANIC ELECTROLUMINESCENT ELEMENT, LIGHTING DEVICE AND DISPLAY DEVICE**
ORGANISCHES ELEKTROLUMINESZENTES ELEMENT, BELEUCHTUNGSVORRICHTUNG UND ANZEIGEVORRICHTUNG
ÉLÉMENT ÉLECTROLUMINESCENT ORGANIQUE, DISPOSITIF D'ÉCLAIRAGE ET DISPOSITIF D'AFFICHAGE

(30) Priority: 07.08.2012 JP 2012174915
(43) Date of publication of application: 17.06.2015
(73) Proprietor: Konica Minolta, Inc., Tokyo 100-7015 (JP)
(72) Inventor: OTSU, Shinya, Tokyo 100-7015 (JP); KATOH, Eisaku, Tokyo 100-7015 (JP); HIKIME, Mayuka, Tokyo 100-7015 (JP)
(74) Representative: Henkel & Partner mbB
(86) International application number: PCT/JP2013/069842
(87) International publication number: WO 2014/024668

(56) References cited:
- WO-A1-2007/018067
- WO-A1-2007/018067
- WO-A1-2008/096609
- WO-A1-2008/096609
- WO-A1-2008/140114
- JP-A- 2006 128 634
- JP-A- 2006 128 634
- JP-A- 2007 524 585
- JP-A- 2009 526 071
- JP-A- 2011 068 848
- US-A1- 2006 024 522
- US-A1- 2012 018 714

## Description

### Technical Field

The present invention relates to an organic electroluminescent element, a lighting device, and a display device.

### Background Art

An organic electroluminescent element (hereinafter, also referred to as organic EL element) is a light emitting element which is configured to include a light emitting layer containing a luminescent compound between a negative electrode and a positive electrode, and which produces excitons by allowing the holes injected from the positive electrode and the electrons injected from the negative electrode to recombine within the light emitting layer when an electric field is applied, and utilizes the emission of light occurring when these excitons are deactivated (fluorescence/phosphorescence). Furthermore, an organic EL element is an all-solid element constituted by films of organic materials having a thickness in the order of submicrons only, interposed between an electrode and another electrode. Since organic EL elements are capable of emitting light at a voltage of about several volts (V) to several ten volts (V), utilization thereof in the next-generation flat displays or lightings is highly expected.

In regard to the development of organic EL elements under an expectation for practicalization, there has been a report from Princeton University on an organic EL element that uses phosphorescent luminescence from excited triplets (see, for example, Non-Patent Literature 1). Since then, research on materials that exhibit phosphorescence at room temperature is being conducted actively (see, for example, Patent Literature 1 and Non-Patent Literature 2).

Furthermore, since organic EL elements that utilize phosphorescent luminescence can realize in principle a luminescence efficiency that is about four times higher compared to existing organic EL elements that utilize fluorescent luminescence, development of the relevant materials as well as the research and development on the layer configuration of a luminescent element or the electrodes are being carried out all over the world. For example, investigations are conducted on the synthesis of many compounds centered around heavy metal complexes such as iridium complex systems (see, for example, Non-Patent Literature 3).

As such, the phosphorescent luminescence system is a system of very high potential. However, an organic EL device that utilizes phosphorescent luminescence is significantly different from an organic EL device that utilizes fluorescent luminescence, and thus, the method for controlling the position of the luminescence center, particularly the question of how stably light emission can be achieved by inducing recombination inside the light emitting layer, has become a critical technical problem for securing the efficiency and service life of an element.

Thus, in recent years, multilayer lamination type elements having a hole transport layer that is located on the positive electrode side of the light emitting layer, and an electron transport layer that is located on the negative electrode side of the light emitting layer, both in the form of being positioned adjacent to the light emitting layer, are well known (see, for example, Patent Literature 2). Furthermore, for the light emitting layer, mixed layers that use a host compound and a phosphorescence luminescent compound as a dopant are used in many cases.

On the other hand, from the viewpoint of material, there is a demand for a material which has high carrier transportability or which is thermally and electrically stable. Particularly, on the occasion of utilizing blue phosphorescent luminescence, since a blue phosphorescence luminescent compound itself has high triplet excitation energy (T1), there is a strong demand for the development of applicable peripheral materials and precise control of the luminescence center.

A known representative blue phosphorescence luminescent compound is FIrpic, and a shift to shorter wavelength is realized by substituting the phenylpyridine of the main ligand with fluorine, and by using picolinic acid as an auxiliary ligand. High efficiency of elements has been achieved by combining these dopants with carbazole derivatives or triarylsilanes as host compounds. However, since the light emission lifetime of elements is deteriorated thereby to a large extent, an improvement in the trade-off is demanded.

As a means for improving this trade-off, an investigation is conducted on converting a metal complex into a basket-like form and thereby increasing thermal stability. For example, there is available a technology of preventing the generation of decomposition products at the time of vapor deposition and enhancing the element performance by improving the thermal stability of a metal complex that serves as a material for an organic EL element.

Also, in recent years, metal complexes having particular ligands have been found as blue phosphorescence luminescent compounds having high potential (see, for example, Patent Literatures 3 and 4). Organic electroluminescent elements that have high luminous efficiency and are capable of emitting blue light by including an iridium complex compound as the dopant are further known from Patent Literatures 5 to 7.

### Citation List

### Patent Literatures

Patent Literature 1: US 6,097,147 A
Patent Literature 2: JP 2005-112765 A
Patent Literature 3: US 2011/0057559 A1
Patent Literature 4: WO 2011/086089 A1
Patent Literature 5: WO 2008/096609 A1
Patent Literature 6: WO 2007/018067 A1
Patent Literature 7: JP 2006-128634 A

### Non-Patent Literatures

Non-Patent Literature 1: M.A. Baldo et al., Nature, Vol. 395, pp. 151∼154 (1998)
Non-Patent Literature 2: M.A. Baldo et al., Nature, Vol. 403, No. 17, pp. 750∼753 (2000)
Non-Patent Literature 3: S. Lamansky et al., J. Am. Chem. Soc., Vol. 123, p. 4304 (2001)

### Summary of Invention

### Technical Problem

However, the conventional metal complexes described above do not have sufficient blue color purity, and there is a further demand for an enhancement of performance. Furthermore, such a blue phosphorescence luminescent material having a shorter wavelength is required to have thermal stability as well as stability of excitons and stability at the time of carrier conduction, which are attributable to the width of the band gap.

Therefore, it is an object of the present invention to provide an organic electroluminescent element having high luminescence efficiency and a long service life, by enhancing thermal stability of the organic electroluminescent element material, stability of excitons, and stability at the time of carrier conduction, and ameliorating the waveform of the light emission spectrum, and to provide a lighting device and a display device that include the element. The invention is defined by the claims.

### Solution to Problem

In a first aspect, the present invention thus relates to an organic electroluminescent element as defined in claim 1. The electroluminescent element comprises at least one organic layer including a light emitting layer interposed between a positive electrode and a negative electrode, wherein the light emitting layer contains an iridium complex compound represented by any one of the following formulas (2) to (4): 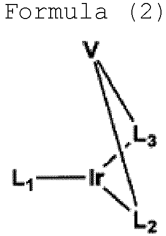 in formula (2), V represents a divalent linking group, and is linked to L₂ and L₃ by covalent bonding; and L₁ to L₃ are each represented by formula (5) described below: 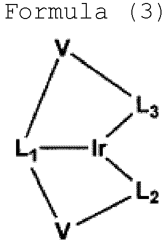 in formula (3), V's each represent a divalent linking group, and are respectively linked to L₁, L₂ and L₃ by covalent bonding; and L₁ to L₃ are each represented by formula (5) described below; 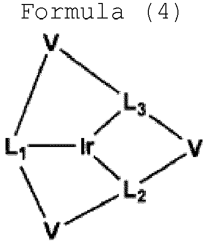 in formula (4), V's each represent a divalent linking group, and are respectively linked to L₁, L₂ and L₃ by covalent bonding; and L₁ to L₃ are each represented by formula (5) described below; 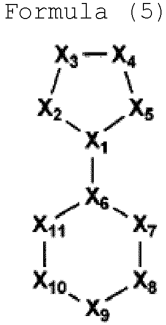 in formula (5), X₁ to X₅ represent a group of elements that form a nitrogen-containing heterocyclic ring and are selected from a carbon atom and a nitrogen atom; at least one of X₄ and X₅ represents a nitrogen atom; X₅ forms a coordination bond with Ir in the above formulas (2) to (4); X₆ to X₁₁ represent a group of elements that form a 6-membered aromatic ring, and are selected from a carbon atom and a nitrogen atom; X₇ forms a covalent bond with Ir in the above formulas (2) to (4).

In one variant of the present invention, the maximum emission wavelength of the iridium complex compound is 470 nm or less, and, regarding at least one of L₁ to L₃ among L₁ to L₃ in formulas (2) to (4), formula (5) is represented by the following formula (6) or the following formula (8): 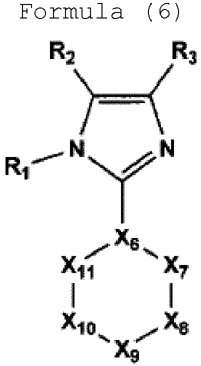 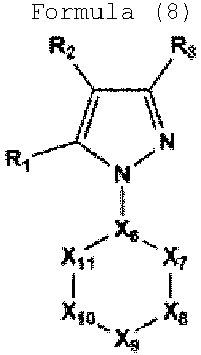 wherein in formulas (6) and (8), X₆ to X₁₁ have the same meanings as defined for X₆ to X₁₁ in the formula (5); R₁, R₂ and R₃ each represent a hydrogen atom or a substituent; and R₁ and X₁₁ may form a ring.

In another variant of the present invention, the maximum emission wavelength of the iridium complex compound is 460 nm or less, and in at least one of L₁ to L₃ among L₁ to L₃ in formulas (2) to (4), the nitrogen-containing heterocyclic ring formed by X₁ to X₅ in the formula (5) is a triazole ring.

In a second aspect, the present invention relates to a lighting device as defined in claim 8. The lighting device comprises the organic electroluminescent element of the first aspect.

In a third aspect, the present invention relates to a display device as defined in claim 9. The display device comprises the organic electroluminescent element of the first aspect.

### Advantageous Effects of Invention

According to the present invention, an organic electroluminescent element which has excellent thermal stability as well as excellent stability in an excited state of the complex and excellent stability at the time of carrier conduction, uses an organic electroluminescent element material having a satisfactory wave form of the light emission spectrum, and has high luminescence efficiency and a long service life; a light device and a display device that use the relevant element.

### Brief Description of Drawings

Fig. 1 is a schematic diagram illustrating an example of a display device configured to include an organic EL element.
Fig. 2 is a schematic diagram illustrating a display unit A.
Fig. 3 is a schematic diagram illustrating a pixel.
Fig. 4 is a schematic diagram of a passive matrix type full color display device.
Fig. 5 is an outline diagram of a lighting device.
Fig. 6 is a schematic diagram of a lighting device.
Fig. 7A illustrates an outline configuration diagram of an organic EL full color display device.
Fig. 7B illustrates an outline configuration diagram of an organic EL full color display device.
Fig. 7C illustrates an outline configuration diagram of an organic EL full color display device.
Fig. 7D illustrates an outline configuration diagram of an organic EL full color display device.
Fig. 7E illustrates an outline configuration diagram of an organic EL full color display device.

### Description of Embodiments

Hereinafter, embodiments for carrying out the present invention will be described in detail, but the present invention is not intended to be limited to these.

### <<Constituent layers of organic EL element>>

The constituent layers of the organic EL element of the present invention will be explained. In regard to the organic EL element of the present invention, specific preferred examples of the layer configuration of the various organic layers interposed between a positive electrode and a negative electrode are described below, but the present invention is not intended to be limited to these.

(i) Positive electrode/light emitting layer unit/electron transport layer/negative electrode
(ii) Positive electrode/hole transport layer/light emitting layer unit/electron transport layer/negative electrode
(iii) Positive electrode/hole transport layer/light emitting layer unit/hole blocking layer/electron transport layer/negative electrode
(iv) Positive electrode/hole transport layer/light emitting layer unit/hole blocking layer/electron transport layer/negative electrode buffer layer/negative electrode
(v) Positive electrode/positive electrode buffer layer/hole transport layer/light emitting layer unit/hole blocking layer/electron transport layer/negative electrode buffer layer/negative electrode

Furthermore, the light emitting layer unit may be non-luminescent intermediate layers between plural light emitting layers, and the intermediate layers may be configured as a multiphoton unit, which is a charge generating layer. In this case, examples of the charge generating layer include electroconductive inorganic compound layers of ITO (indium tin oxide), IZO (indium zinc oxide), ZnO₂, TiN, ZrN, HfN, TiOₓ, VOₓ, CuI, InN, GaN, CuAlO₂, CuGaO₂, SrCu₂O₂, LaB₆, RuO₂ and the like; bilayer films such as Au/Bi₂O₃; multilayer films such as SnO₂/Ag/SnO₂, ZnO/Ag/ZnO, Bi₂O₃/Au/Bi₂O₃, TiO₂/TiN/TiO₂, and TiO₂/ZrN/TiO₂; fullerenes such as C60; electroconductive organic layers of oligothiophene and the like; and electroconductive organic compound layers of metal phthalocyanines, metal-free phthalocyanines, metal porphyrins, metal-free porphyrins, and the like.

The light emitting layer in the organic EL element of the present invention is preferably a white light emitting layer, and a lighting device using these is preferred.

The various layers constituting the organic EL element of the present invention are described below.

### <<Light emitting layer>>

The light emitting layer related to the present invention is a layer that emits light when the electrons and holes injected from the electrodes or from the electron transport layer and the hole transport layer are recombined. The portion that emits light may be the interior of the light emitting layer, or may be the interface between the light emitting layer and an adjacent layer.

The sum of the film thicknesses of the light emitting layer is not particularly limited, but from the viewpoint of obtaining homogeneity of the film, preventing application of an unnecessary high voltage at the time of light emission, and enhancing stability of the emitted light color against the driving current, the sum of the film thicknesses is preferably adjusted to the range of 2 nm to 5 µm, more preferably adjusted to the range of 2 nm to 200 nm, and particularly preferably adjusted to the range of 5 nm to 100 nm.

For the production of the light emitting layer, the light emitting layer can be formed by forming a film using a luminescent dopant and a host compound described below, and using, for example, a vacuum deposition method or a wet method (also called a wet process, and examples thereof include a spin coating method, a casting method, a die coating method, a blade coating method, a roll coating method, an inkjet method, a printing method, a spray coating method, a curtain coating method, and an LB method (Langmuir-Blodgett method)).

It is preferable that the light emitting layer of the organic EL element of the present invention contains a luminescent dopant (phosphorescence luminescent dopant (also called phosphorescent dopant or phosphorescence luminescent dopant group), fluorescent dopant, or the like) compound and a luminescent host compound.

### (1) Luminescent dopant compound

The luminescent dopant compound (also referred to as a luminescent dopant, a dopant compound, or simply a dopant) will be explained.

Regarding the luminescent dopant, a fluorescent dopant (also called fluorescent compound) can be used, and a phosphorescent dopant (also called phosphorescence luminescent body, phosphorescent compound, phosphorescence luminescent compound, or the like) is used.

### (1.1) Phosphorescent dopant (also called phosphorescence luminescent dopant)

The phosphorescent dopant related to the present invention will be explained.

The phosphorescent dopant compound related to the present invention is a compound in which light emission from an excited triplet is observed, and is specifically defined as a compound that emits phosphorescent light at room temperature (25°C) and has a phosphorescence quantum yield of 0.01 or more at 25°C. However, a preferred phosphorescence quantum yield is 0.1 or more.

The phosphorescence quantum yield can be measured by the method described in Jikken Kagaku Koza (Lecture on Experimental Chemistry) 7 - Spectroscopy II, 4th Edition, p. 398 (1992, Maruzen Corp.). The phosphorescence quantum yield in a solution can be measured using various solvents; however, it is desirable if the phosphorescent dopant related to the present invention allows the aforementioned phosphorescence quantum yield (0.01 or more) to be achieved in any one of arbitrary solvents.

There are available two principles for the light emission of a phosphorescent dopant, and one of them is energy transfer type emission in which recombination of carriers occurs on a host compound to which carriers are transported, an excited state of the luminescent host compound is produced, this energy is transferred to a phosphorescent dopant, and thereby luminescence is obtained from the phosphorescent dopant. The other is carrier trap type emission in which a phosphorescent dopant serves as a carrier trap, recombination of carriers occurs on the phosphorescent dopant, and luminescence is obtained from the phosphorescent dopant compound. In both cases, a condition is assumed that the energy of the excited state of the phosphorescent dopant be lower than the energy of the excited state of the host compound.

Here, the inventors of the present invention repeatedly conducted thorough investigations in order to achieve the objects of the present invention, and as a result, they found that when an iridium complex dopant represented by any one of the following formulas (2) to (4) is incorporated into an organic layer of an organic EL element, the exciton stability and carrier stability of the organic EL element are enhanced. That is, when plural ligands coordinating an iridium atom are linked to one another, that is, the ligands are formed into a basket-like form, separation of the Ir atom and the ligands of an iridium complex in an excited state, a radical anion state or a radical cation state is prevented, and an enhancement of the exciton stability and carrier stability was achieved. Furthermore, the inventors found that the waveform of the light emission spectrum can be ameliorated by the iridium complex compound represented by any one of formulas (2) to (4), and specifically, light emission on the longer wavelength side could be suppressed. The inventors also found that when the iridium complex dopant is incorporated in an organic EL element, high emission luminance of the organic EL element and lengthening of the service life of the emission lifetime can be achieved.

Therefore, the organic EL element of the present invention is configured to contain an iridium complex compound represented by any one of the following formulas (2) to (4) as an organic EL element material in the light emitting layer.

The iridium complex compound represented by any one of the following formulas (2) to (4) related to the present invention is such that the residual ratio of luminance obtainable when the distance between a light source and a sample is set to 10 mm, and the sample is irradiated with UV-LED light (5 W/cm²) for 20 minutes, is preferably 60% or more, more preferably 70% or more, and most preferably 80% or more.

The ratio "second wave intensity/first wave intensity" in the light emission spectrum of the iridium complex compound represented by any one of the following general formulas (2) to (4) related to the present invention in a 2-methyltetrahydrofuran solution is preferably 0.95 or less, more preferably 0.85 or less, and even more preferably 0.75 or less. Here, the first wave intensity represents the intensity of the maximum wavelength on the shortest wavelength side, and the second wave intensity represents the intensity of the maximum wavelength on the second shortest wavelength side.

### (1.1.1) Iridium complex compound represented by any one of formulas (2) to (4)

The iridium complex compound represented by any one of formulas (2) to (4) related to the present invention will be explained. The iridium complex compound contained in the light emitting layer of the organic EL element related to the present invention is represented by the following formulas (2) to (4) .

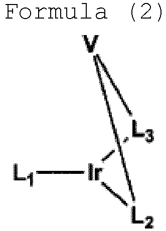

In formula (2), V represents a divalent linking group, and is linked to L₂ and L₃ by covalent bonding.

In formula (2), L₁ to L₃ are each represented by the following formula (5).

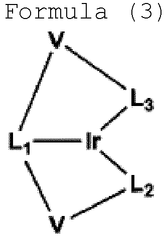

In formula (3), V's each represent a divalent linking group, and are respectively linked to L₁, L₂ and L₃ by covalent bonding.

In formula (3), L₁ to L₃ are each represented by the following formula (5).

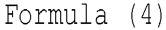

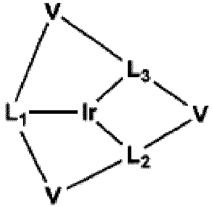

In formula (4), V's each represent a divalent linking group, and are respectively linked to L₁, L₂ and L₃ by covalent bonding.

In formula (4), L₁ to L₃ are each represented by the following formula (5).

Here, L₁ to L₃ in the formulas (2) to (4) are each represented by the following formula (5).

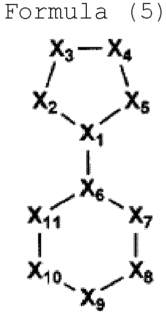

In formula (5), X₁ to X₅ represent a group of elements that form a nitrogen-containing heterocyclic ring and are selected from a carbon atom and a nitrogen atom; at least one of X₄ and X₅ represents a nitrogen atom; and X₅ forms a coordination bond with Ir in formulas (2) to (4).

In formula (5), examples of the nitrogen-containing heterocyclic ring represented by X₁ to X₅ include an imidazole ring, a pyrazole ring, and a triazole ring.

In formula (5), X₆ to X₁₁ are a group of elements that form a 6-membered aromatic ring and are selected from a carbon atom and a nitrogen atom; X₇ forms a covalent bond with Ir in formulas (2) to (4).

In formula (5), examples of the 6-membered aromatic ring represented by X₆ to X₁₁ include a benzene ring and a pyridine ring, and preferred examples include a benzene ring.

In formula (5), the 6-membered aromatic ring represented by X₆ to X₁₁ may further have a substituent, and the substituent may be bonded to other groups and form a fused ring. Examples of the substituent include an alkyl group (for example, a methyl group, an ethyl group, a trifluoromethyl group, or an isopropyl group), an alkoxy group (for example, a methoxy group or an ethoxy group), a halogen atom (for example, a fluorine atom), a cyano group, a nitro group, a dialkylamino group (for example, a dimethylamino group), a trialkylsilyl group (for example, trimethylsilyl), a triarylsilyl group (for example, a triphenylsilyl group), a triheteroarylsilyl group (for example, a tripyridylsilyl group), a benzyl group, an aryl group (for example, a phenyl group), and a heteroaryl group (for example, a pyridyl group or a carbazolyl group).

Furthermore, the maximum emission wavelength of the iridium complex compound represented by any one of formulas (2) to (4) related to the present invention is 470 nm or less.

Here, the measurement method for measuring the maximum emission wavelength of the iridium complex compound is explained.

First, the dopant compound to be measured is dissolved in 2-methyltetrahydrofuran solvent that has been thoroughly deoxygenated, the solution is introduced into a cell for phosphorescence measurement, subsequently excitation light is irradiated thereto, and the light emission spectrum is measured. Meanwhile, for a compound that cannot be dissolved in the aforementioned solvent, any arbitrary solvent capable of dissolving the compound may be used.

The method subsequently includes determination of the maximum emission wavelength, and the maximum wavelength appearing on the shortest wavelength side in the emission spectrum obtained by the measurement method described above is designated as the maximum emission wavelength.

In one variant of the present invention, at least one of L₁ to L₃ among L₁ to L₃ in formulas (2) to (4) is represented by the following formula (6):

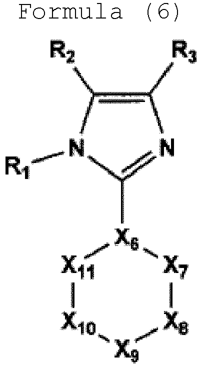

In formula (6), X₆ to X₁₁ have the same meanings as defined for X₆ to X₁₁ in formula (5).

In formula (6), R₁, R₂ and R₃ each represent a hydrogen atom or a substituent; and R₁ and X₁₁ may form a ring.

In formula (6), examples of the substituent represented by R₁, R₂ and R₃ include the same substituents as those which may be carried by the ring represented by X₆ to X₁₁ in formula (5).

Furthermore, the formula (5) described above is preferably represented by the following formula (7):

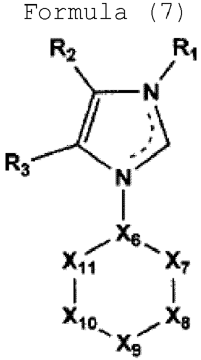

In formula (7), X₆ to X₁₁ have the same meanings as X₆ to X₁₁ in formula (5).

In formula (7), R₁, R₂ and R₃ each represent a hydrogen atom or a substituent, and R₃ and X₁₁ may form a ring.

In formula (7), examples of the substituent represented by R₁, R₂ and R₃ include the same substituents as those which may be carried by the ring represented by X₆ to X₁₁ in formula (5).

In another variant of the present invention, at least one of L₁ to L₃ among L₁ to L₃ in formulas (2) to (4) is represented by the following formula (8):

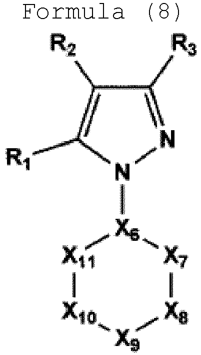

In formula (8), X₆ to X₁₁ have the same meanings as defined for X₆ to X₁₁ in formula (5).

In formula (8), R₁, R₂ and R₃ have the same meanings as defined for R₁, R₂ and R₃ in formula (6) .

Furthermore, the formula (5) described above is preferably represented by the following formula (9):

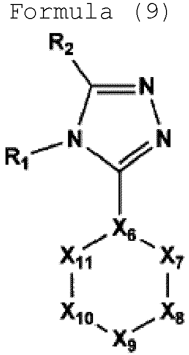

In formula (9), X₆ to X₁₁ have the same meanings as defined for X₆ to X₁₁ in formula (5).

In formula (9), R₁ and R₂ have the same meanings as defined for R₁ and R₂ in formula (6) .

The divalent or trivalent linking group represented by V in formulas (2) to (4) may have any structure as long as the linking group can be linked to the various ligands represented by L₁ to L₃ by covalent bonding. Furthermore, the linking group represented by V may be linked to the nitrogen-containing heterocyclic ring in the above formulas (5) to (9), or may be linked to the ring represented by X₆ to X₁₁, or may be linked to substituents carried by these rings.

### (1.1.2) Specific examples

Hereinbelow, specific examples of the iridium complex compound represented by any one of formulas (2) to (4) related to the present invention are described.
Compound Example 1 (not according to the invention) 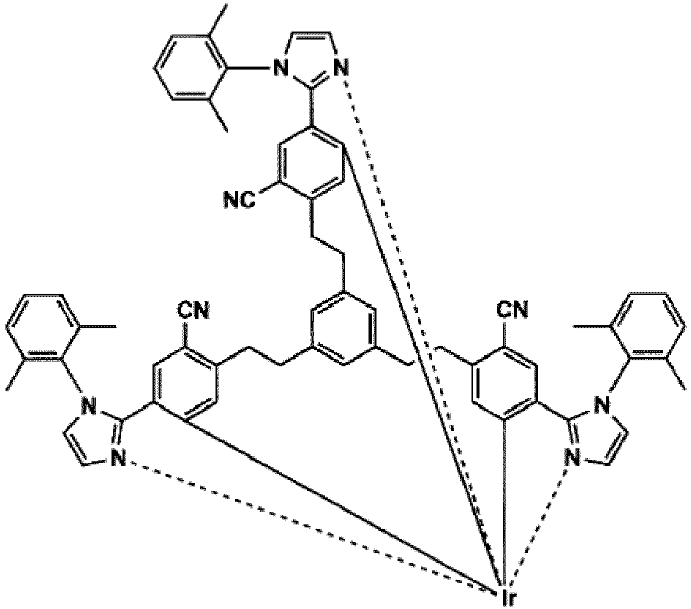
Compound Example 2 (not according to the invention) 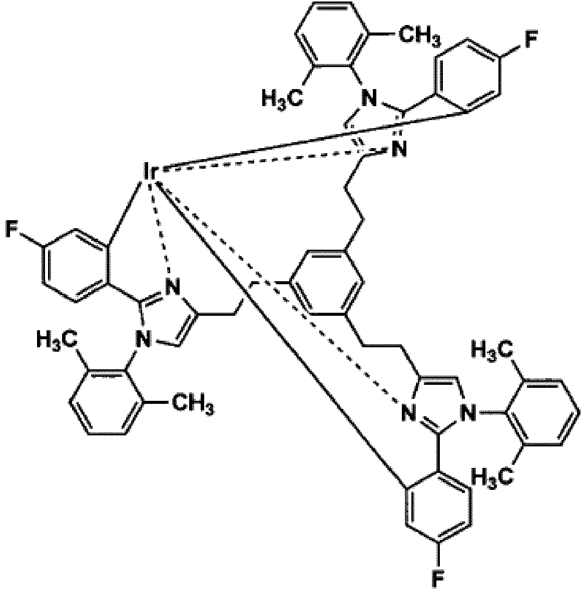
Compound Example 3 (not according to the invention) 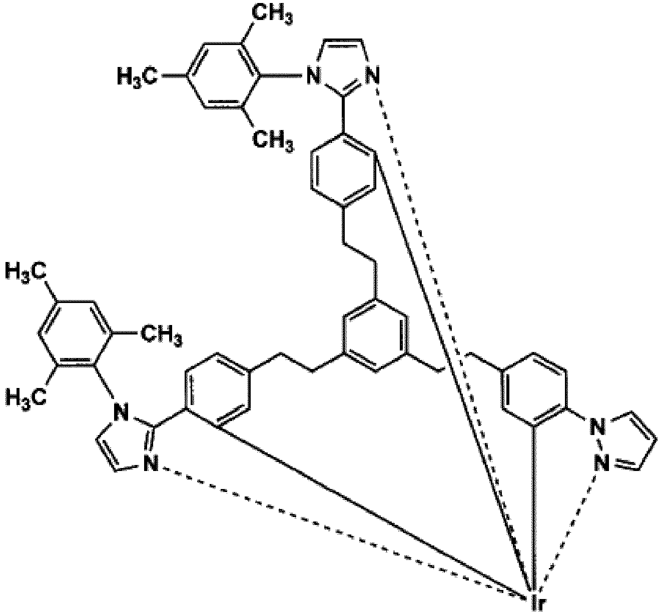
Compound Example 4 (not according to the invention) 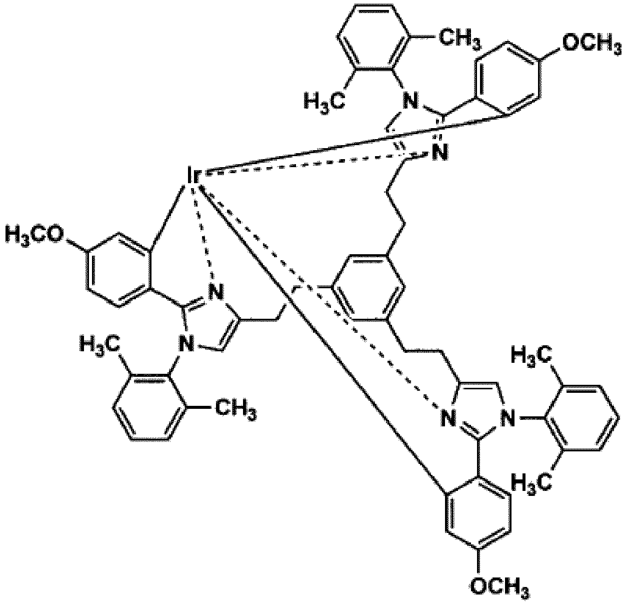
Compound Example 5 (not according to the invention) 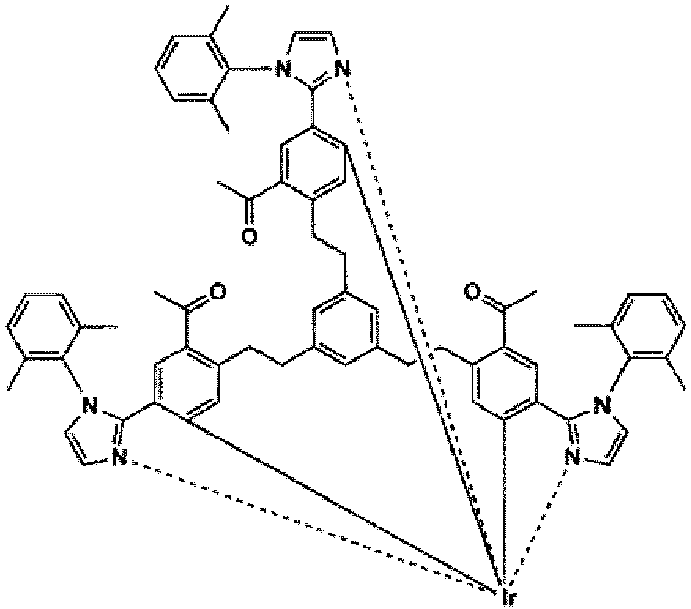
Compound Example 6 (not according to the invention) 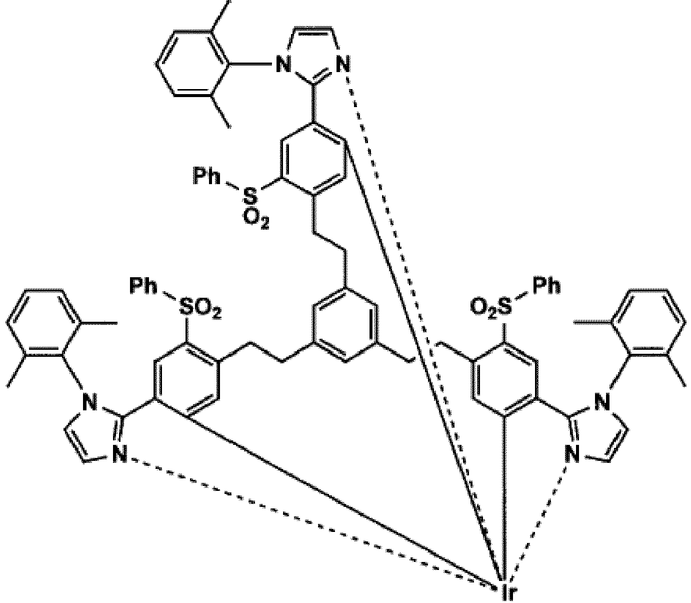
Compound Example 7 (not according to the invention) 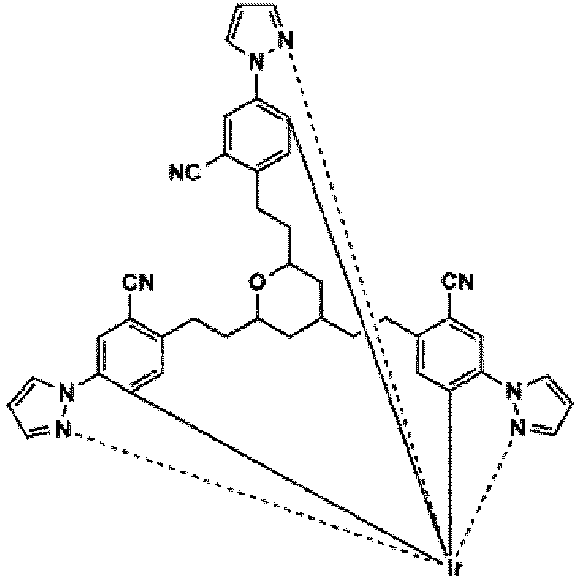
Compound Example 8 (not according to the invention) 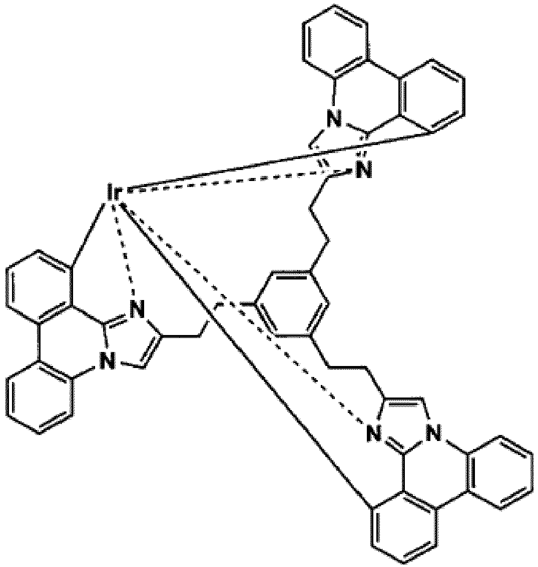
Compound Example 9 (not according to the invention) 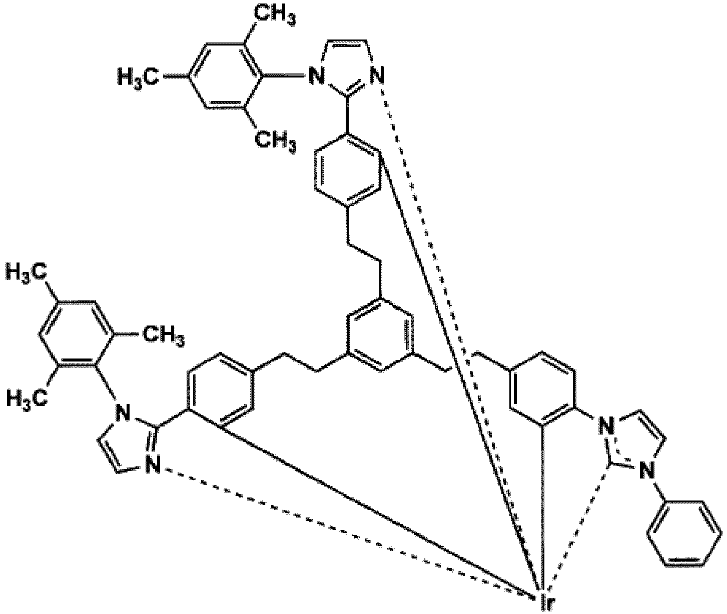
Compound Example 10 (not according to the invention) 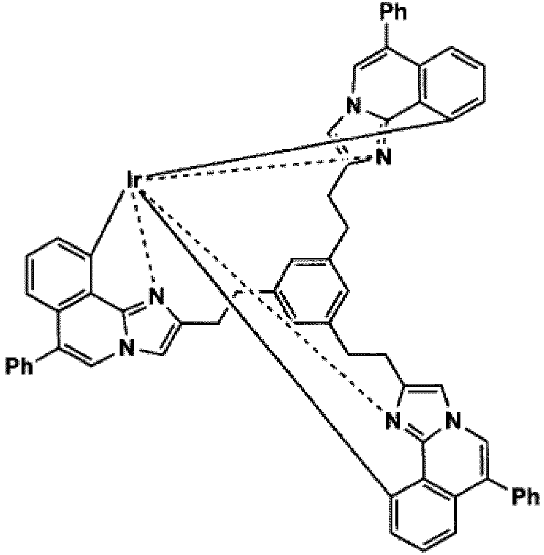
Compound Example 11 (not according to the invention) 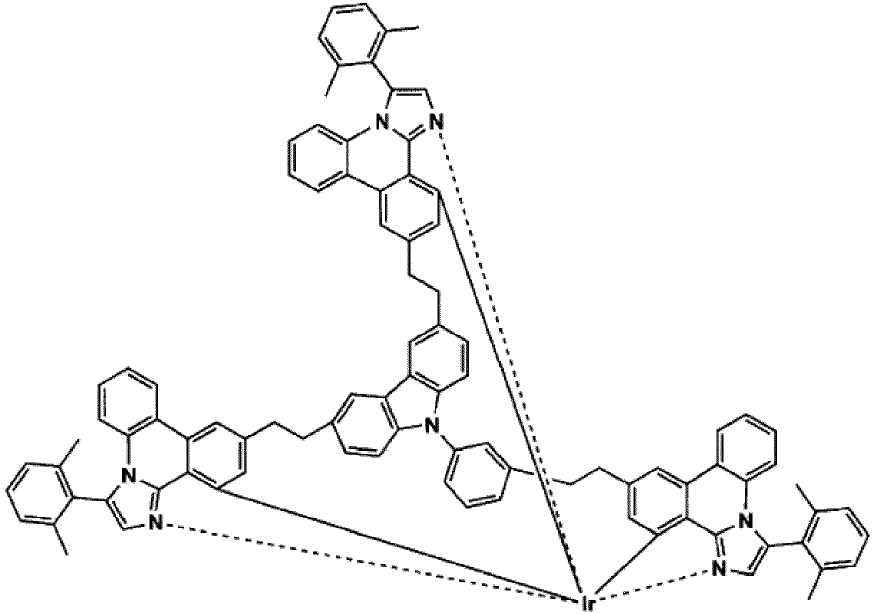
Compound Example 12 (not according to the invention) 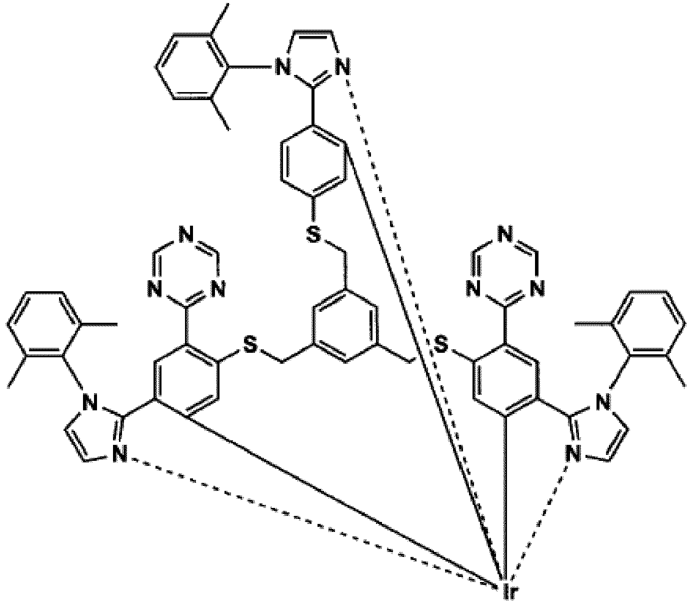
Compound Example 13 (not according to the invention) 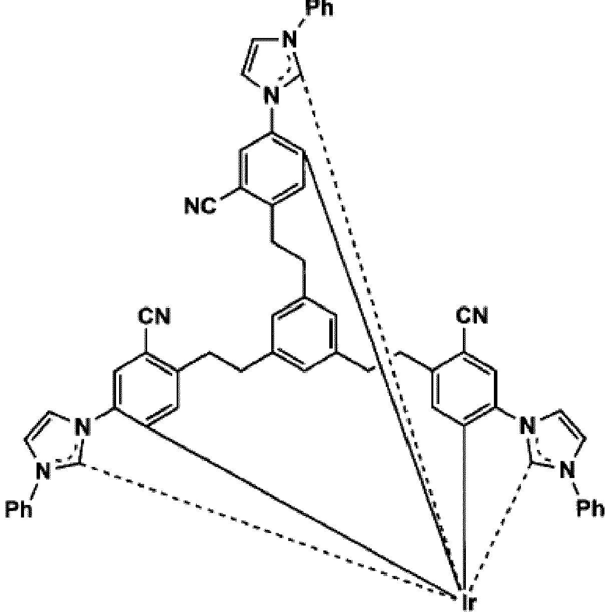
Compound Example 14 (not according to the invention) 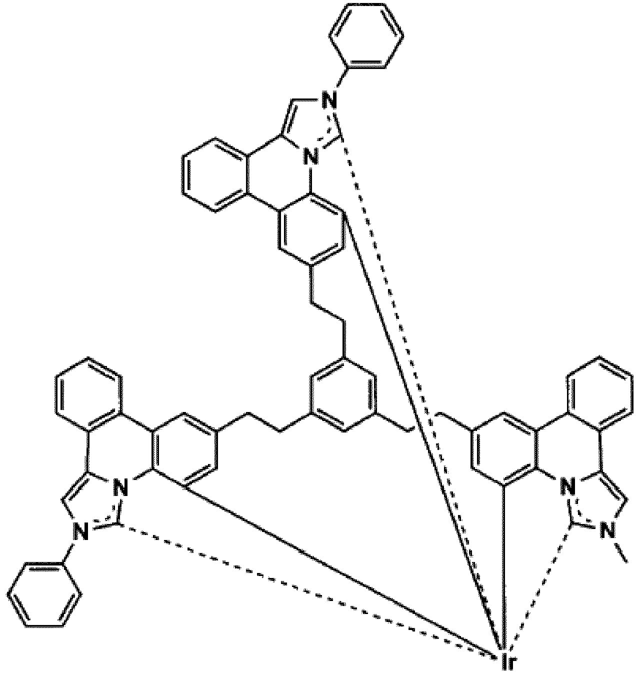
Compound Example 15 (not according to the invention) 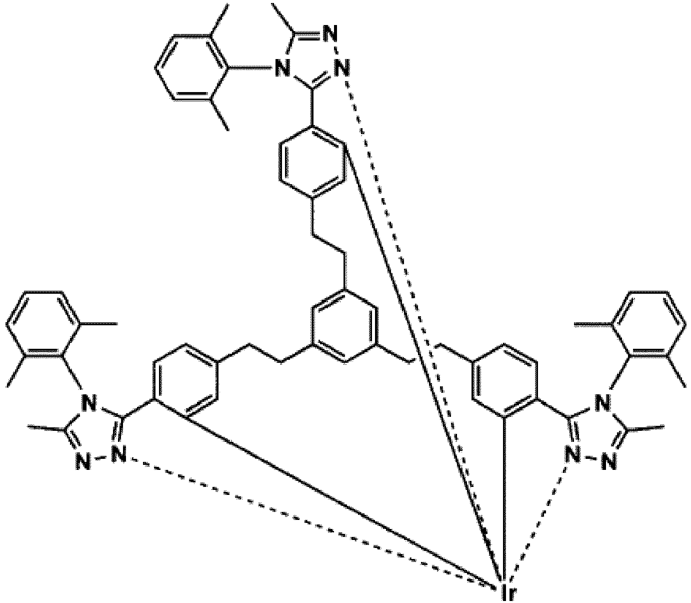
Compound Example 16 (not according to the invention) 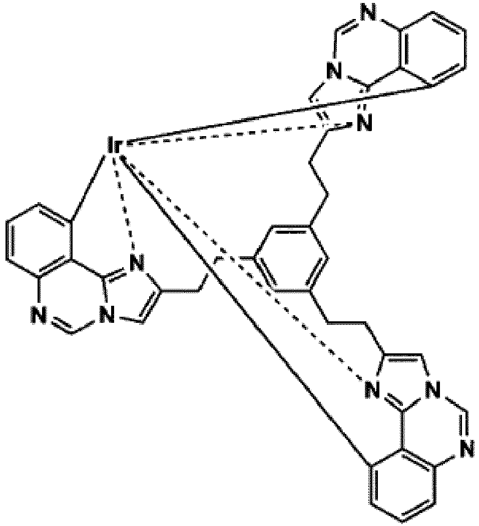
Compound Example 17 (not according to the invention) 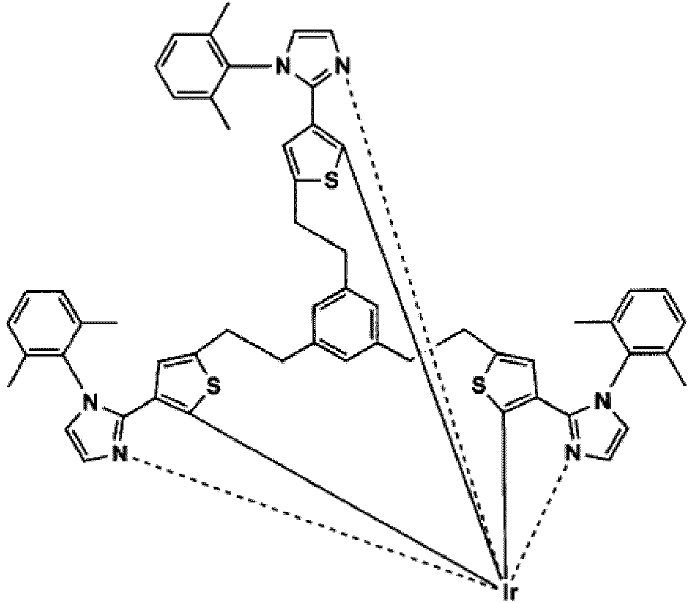
Compound Example 18 (not according to the invention) 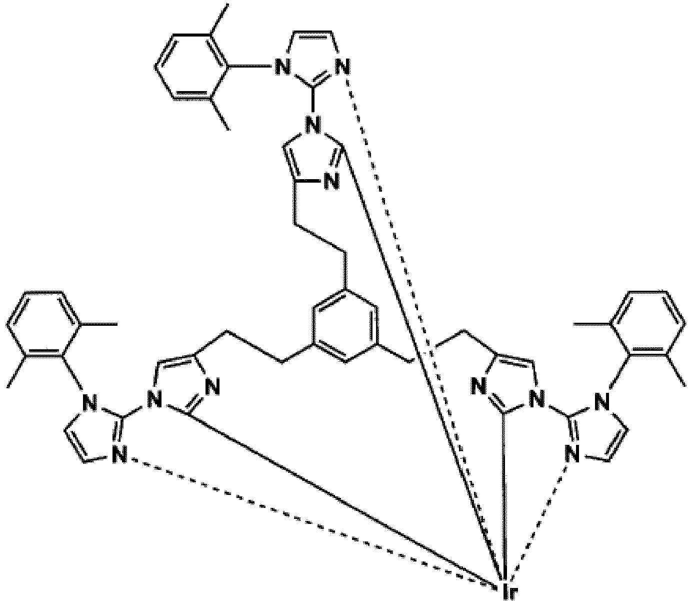
Compound Example 19 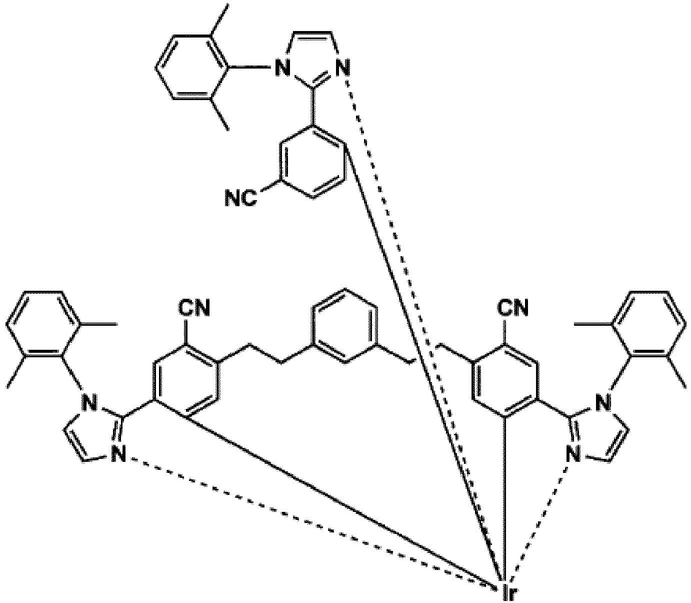
Compound Example 20 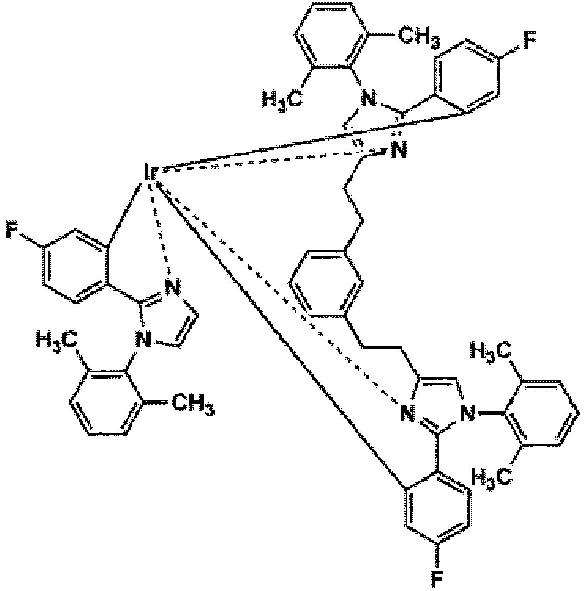
Compound Example 21 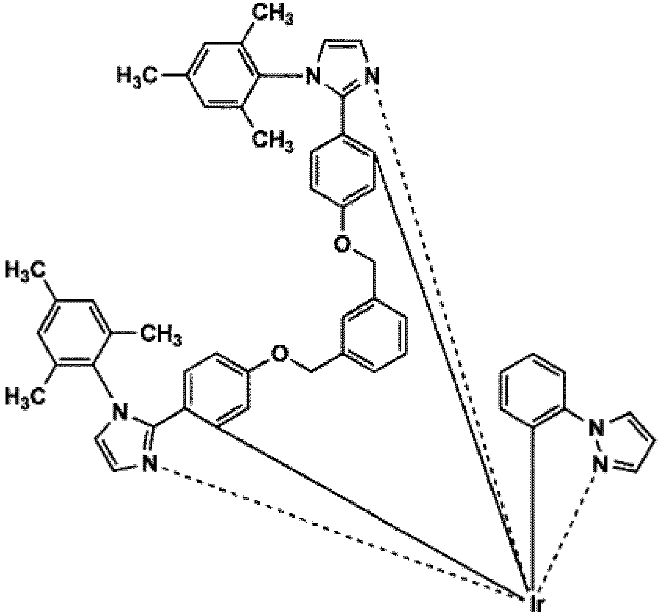
Compound Example 22 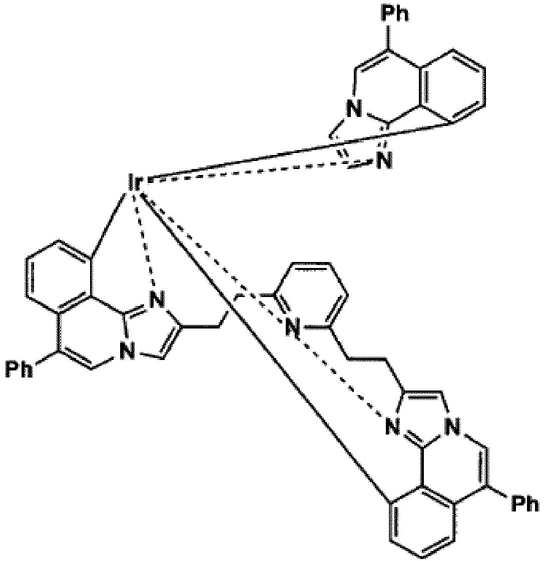
Compound Example 23 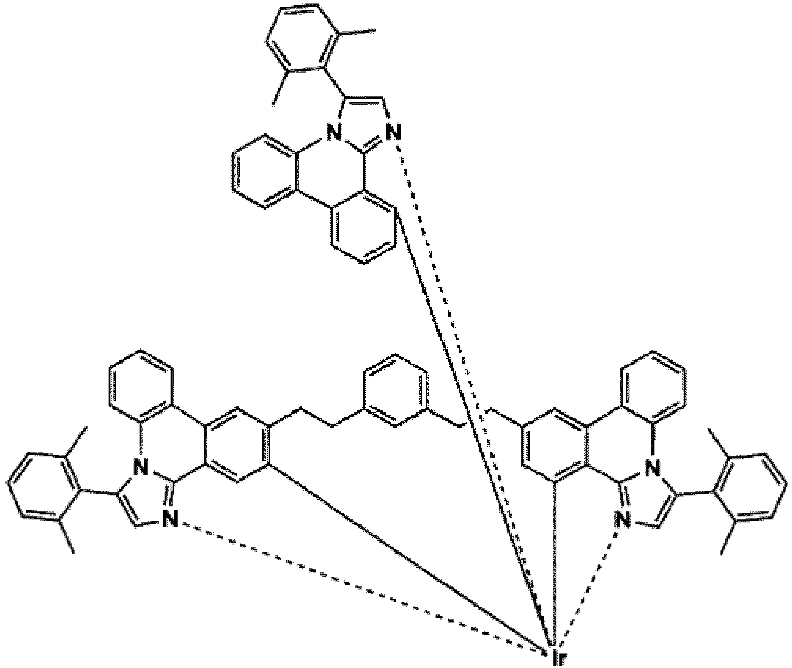
Compound Example 24 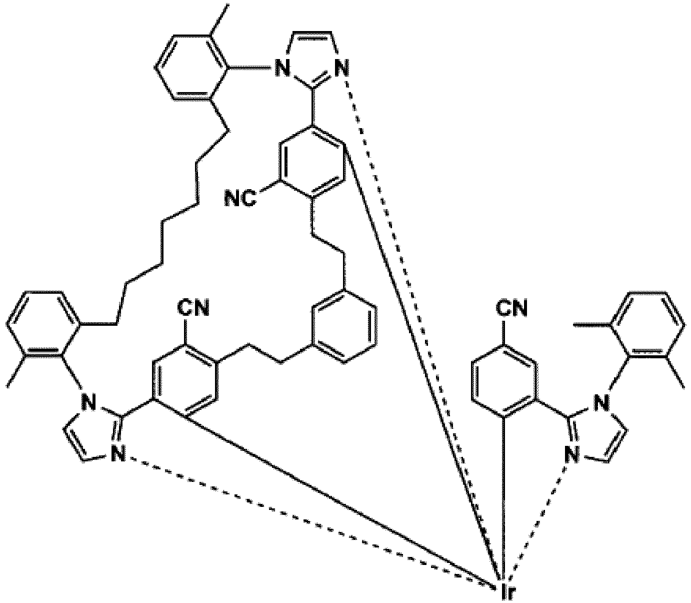
Compound Example 25 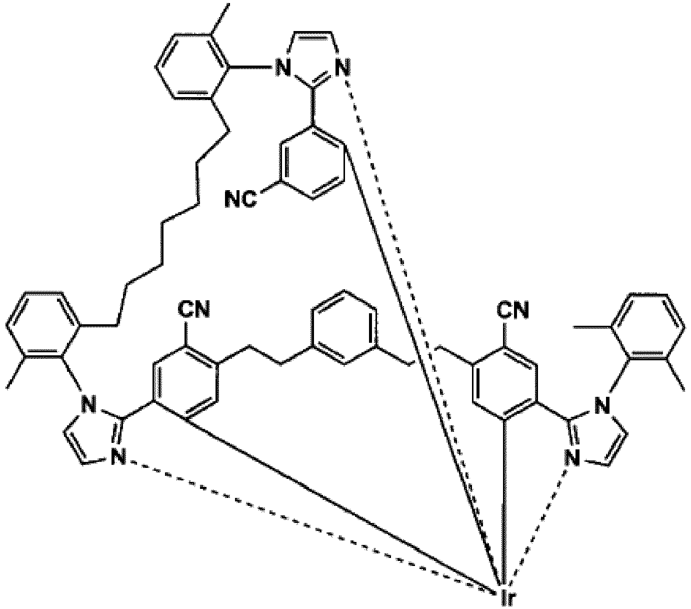
Compound Example 26 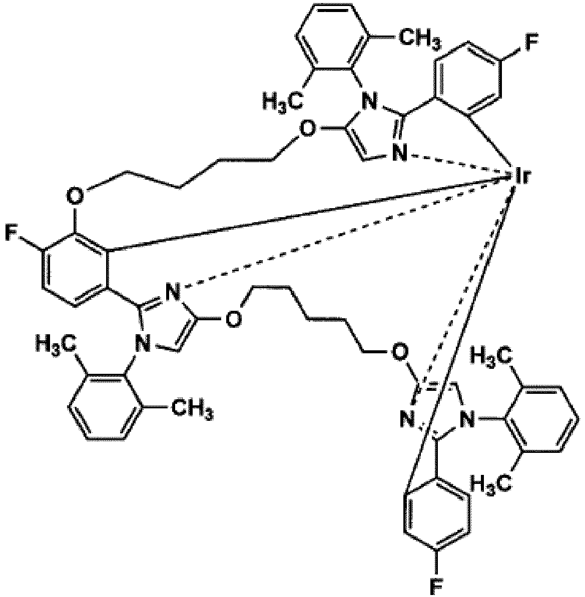
Compound Example 27 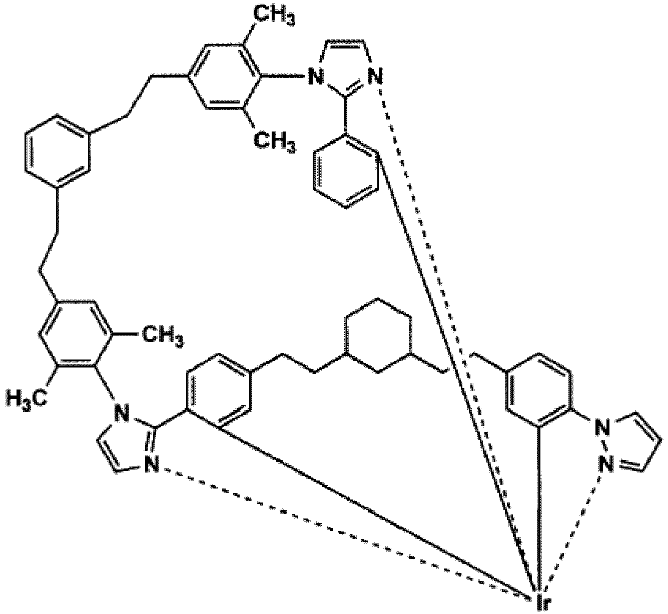
Compound Example 28 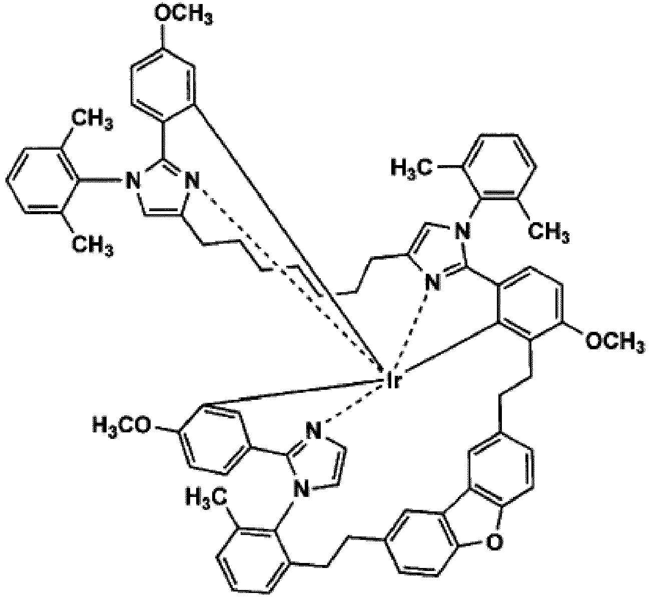
Compound Example 29 (not according to the invention) 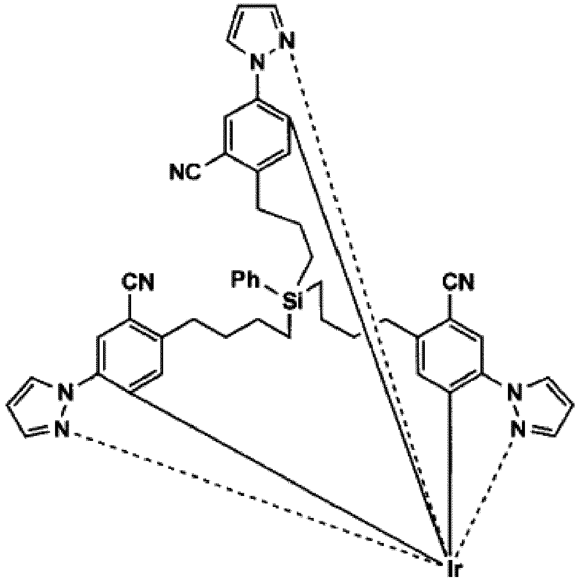
Compound Example 30 (not according to the invention) 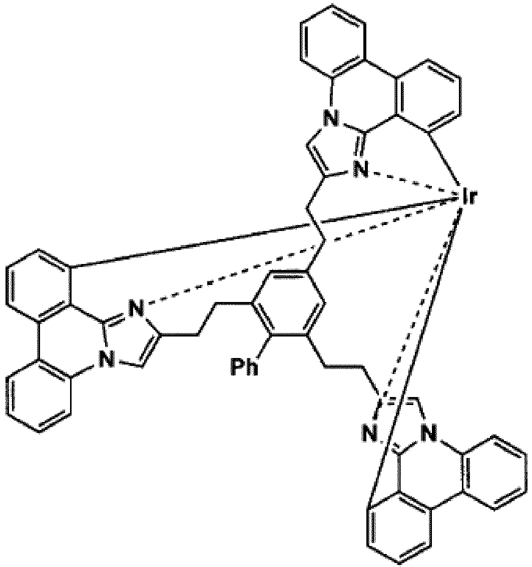
Compound Example 31 (not according to the invention) 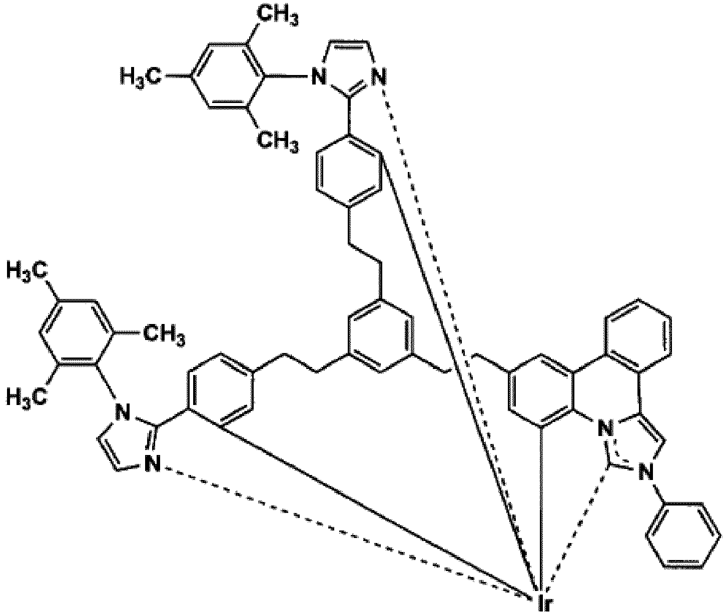
Compound Example 32 (not according to the invention) 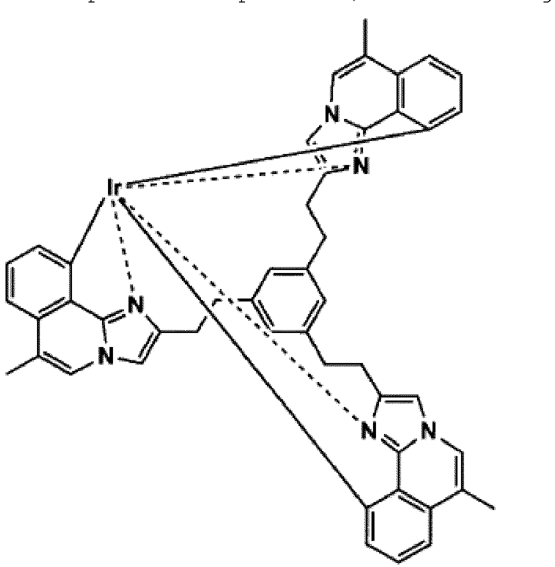
Compound Example 33 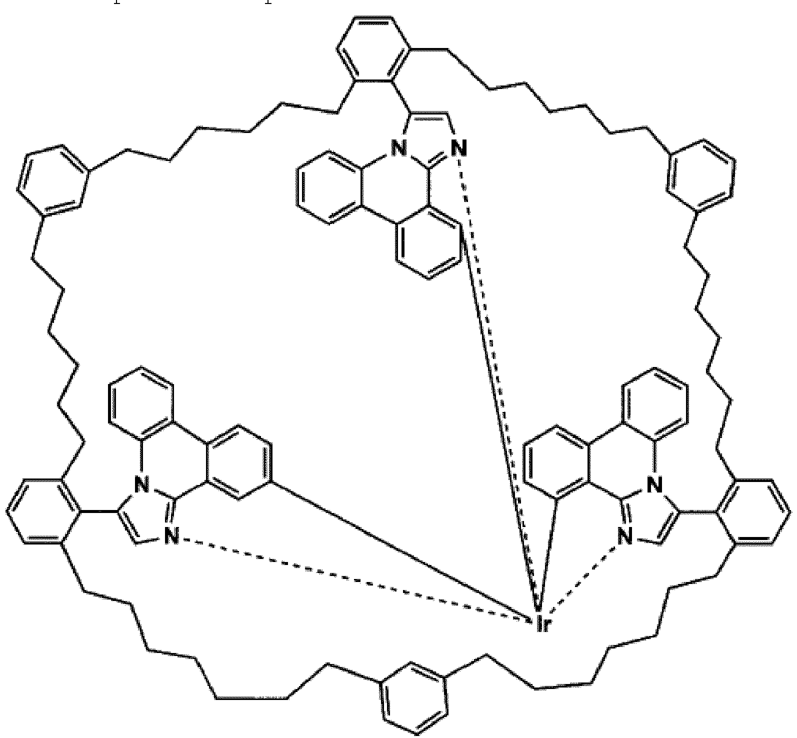
Compound Example 34 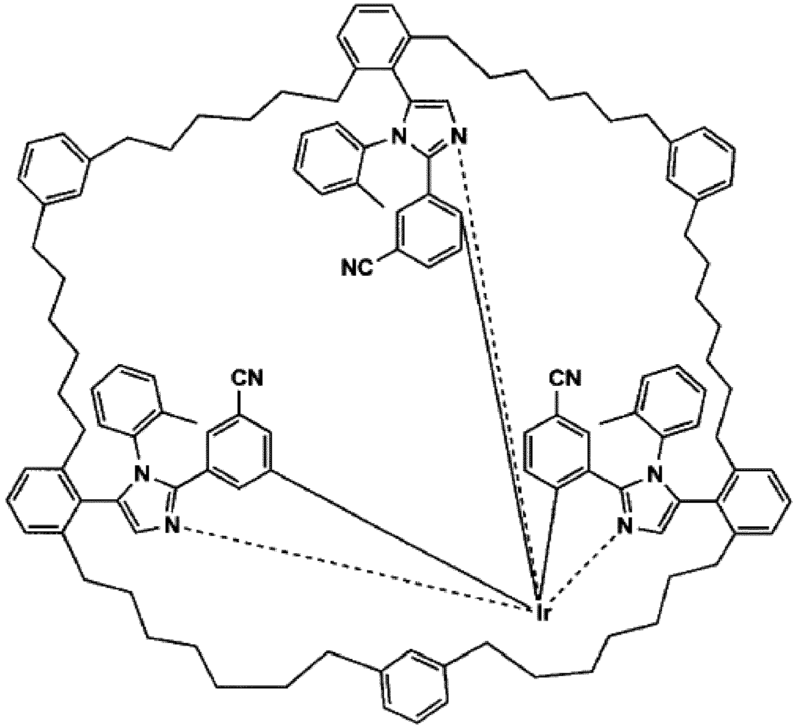
Compound Example 35 (not according to the invention) 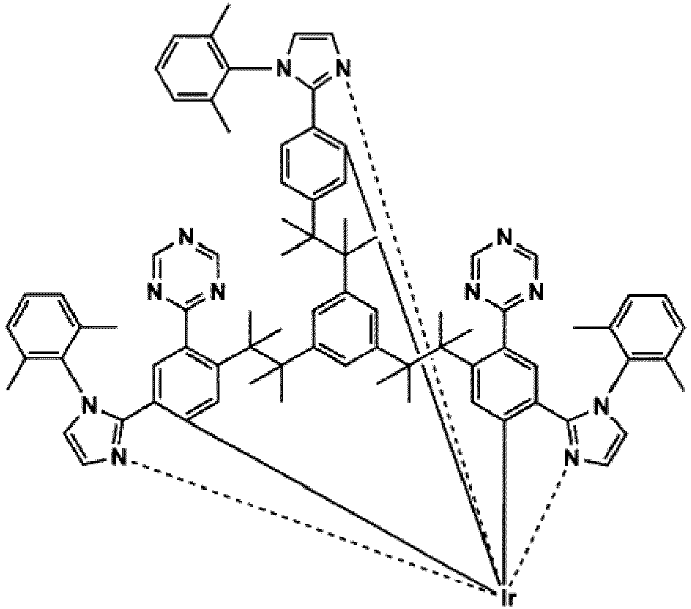
Compound Example 36 (not according to the invention) 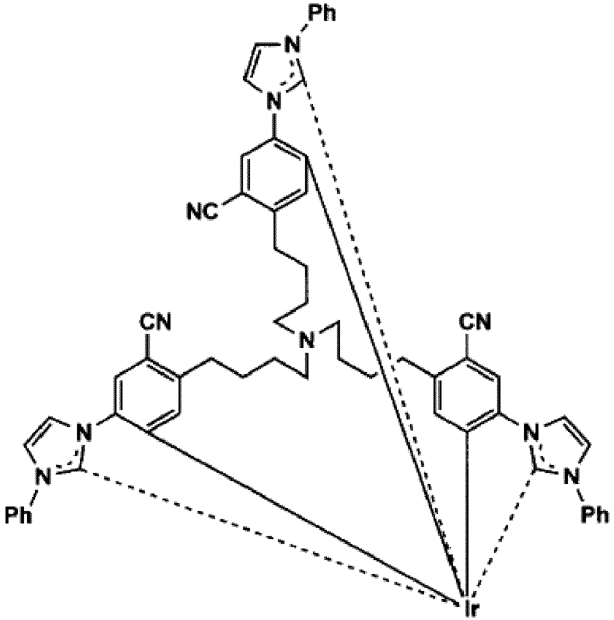
Compound Example 37 (not according to the invention) 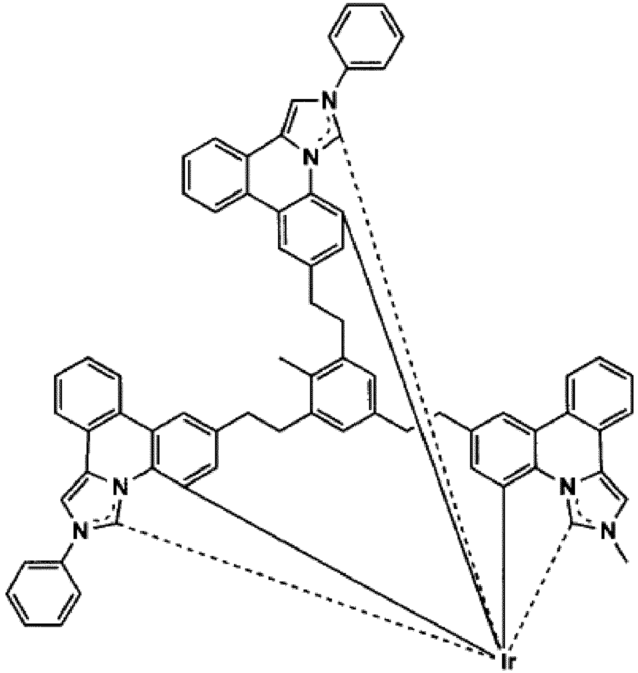
Compound Example 38 (not according to the invention) 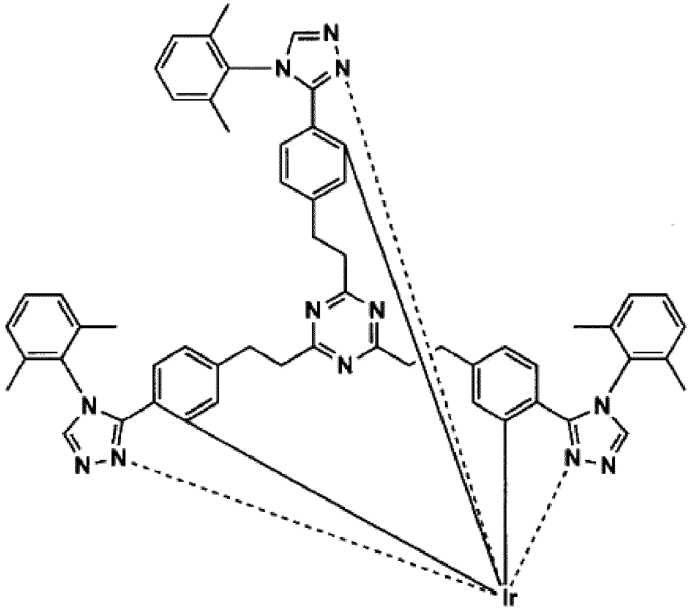
Compound Example 39 (not according to the invention) 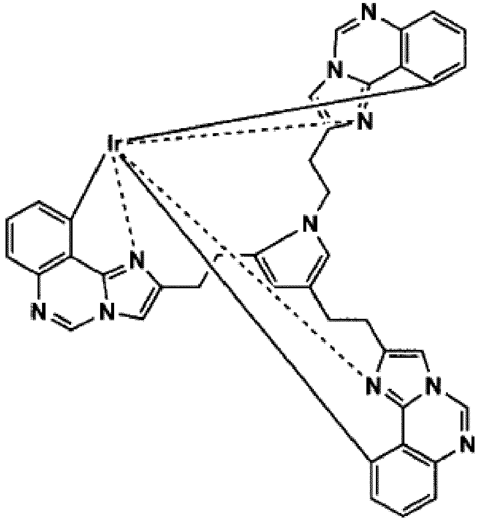
Compound Example 40 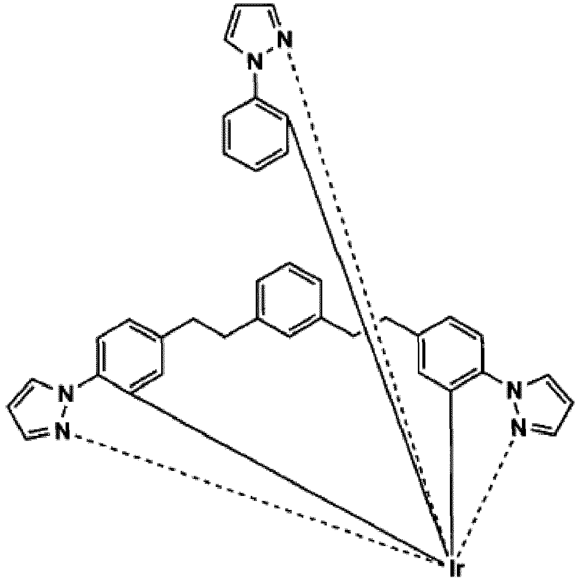
Compound Example 41 (not according to the invention)

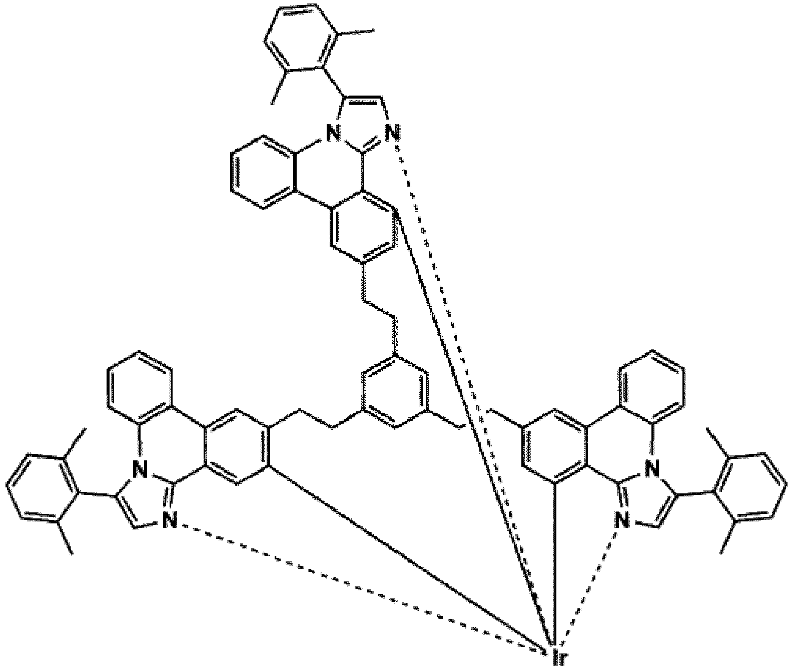

### (1.1.3) Synthesis Example

A Synthesis Example of the iridium complex compound represented by any one of formulas (2) to (4) is described below, but the present invention is not intended to be limited to this. The synthesis method for Compound Example 1 among the specific examples described above is described below as an example.

Compound Example 1 can be synthesized according to the following scheme.

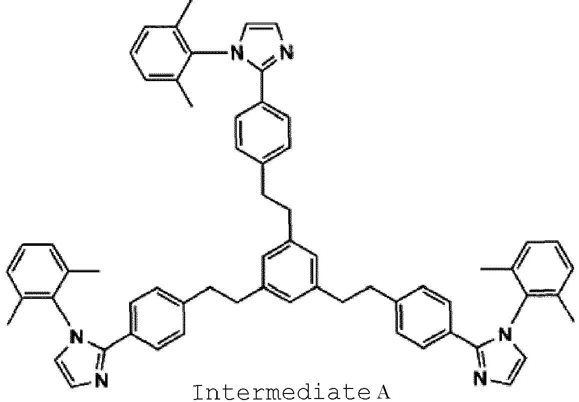

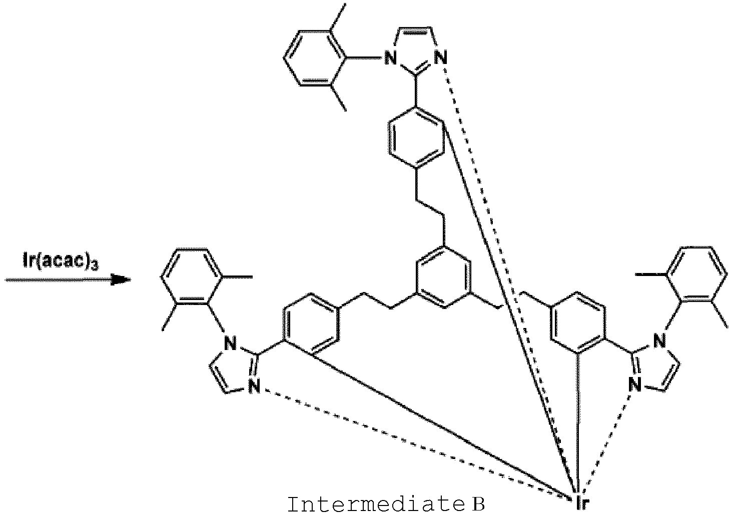

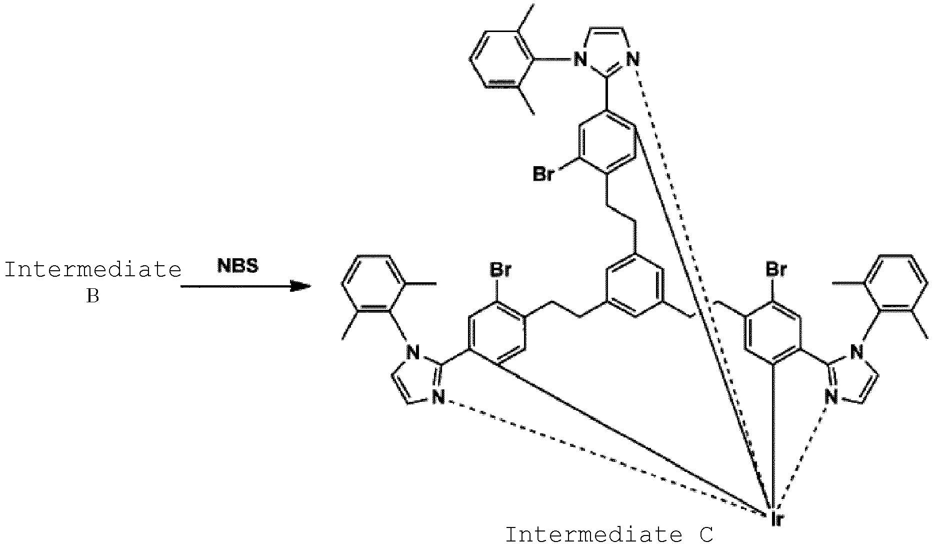

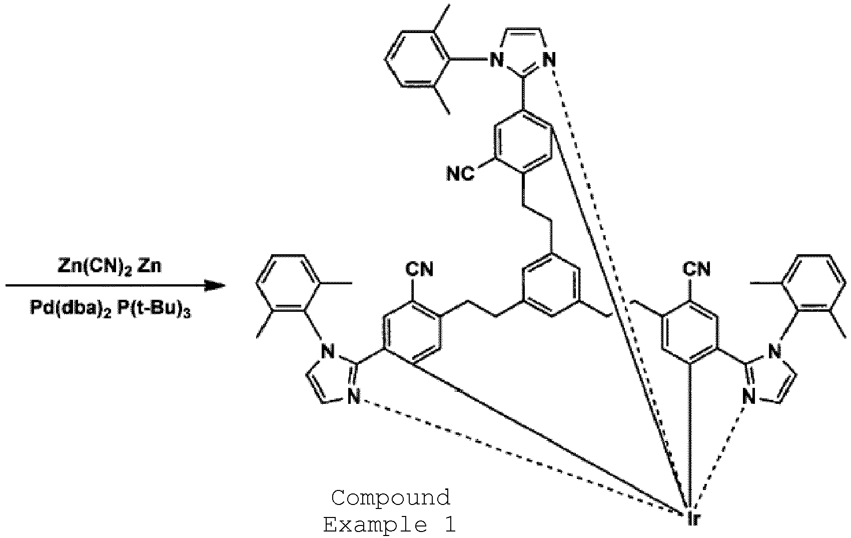

### (Step 1)

5 g of intermediate A, 2.6 g of Ir(acac)₃, and 50 ml of ethylene glycol were introduced into a three-necked flask, and the mixture was heated and stirred at 200°C for 24 hours in a nitrogen atmosphere.

Crystals thus precipitated were collected by filtration, and the filtered crystals were washed with methanol. Thus, 1.1 g of intermediate B was obtained.

### (Step 2)

1.1 g of the intermediate B obtained in step 1 and 30 ml of dimethylformamide were introduced into a three-necked flask, and 0.52 g of N-bromosuccinimide was added thereto in a nitrogen atmosphere.

Crystals thus precipitated were collected by filtration, and the filtered crystals were washed with methanol and then washed with water. Thus, 1.0 g of intermediate C was obtained.

### (Step 3)

1.0 g of the intermediate C obtained in step 2, 0.53 g of Zn(CN)₂, 0.05 g of Pd(dba)₂, 0.03 g of Zn, and 50 ml of dimethylformamide were introduced into a three-necked flask, and the mixture was heated and stirred at 100°C for 7 hours in a nitrogen atmosphere.

Ethyl acetate and water were added thereto, subsequently the mixture was transferred to a separatory funnel, and an organic layer was separated out. Magnesium sulfate as a dehydrating agent was added to this organic layer, subsequently magnesium sulfate was removed using a filter paper, subsequently the filtrate was transferred to an eggplant-shaped flask, and ethyl acetate was concentrated. The residue was purified by silica gel chromatography (developing solvent: hexane: toluene), and thus 0.3 g of Compound Example 1 was obtained.

### (1.2) Fluorescent dopant (also called fluorescent compound)

Examples of a fluorescent dopant include coumarin-based dyes, pyran-based dyes, cyanine-based dyes, croconium-based dyes, squalium-based dyes, oxobenzanthracene-based dye, fluorescein-based dyes, rhodamine-based dyes, pyrylium-based dyes, perylene-based dyes, stilbene-based dyes, polythiophene-based dyes, rare earth metal complex-based fluorescent compounds, and compounds having high fluorescence quantum yield represented by laser dyes.

### (1.3) Combined use with conventionally known dopants

The luminescent dopant related to the present invention may also be used in combination with plural kinds of compounds, and combinations of the same kinds of phosphorescent dopants having different structures, or combinations of phosphorescent dopants and fluorescent dopants may also be used.

Here, as the luminescent dopant, specific examples of conventionally known luminescent dopants that may be used in combination with the iridium complex compound represented by any one of formulas (2) to (4) related to the present invention are given below, but the present invention is not intended to be limited to these.

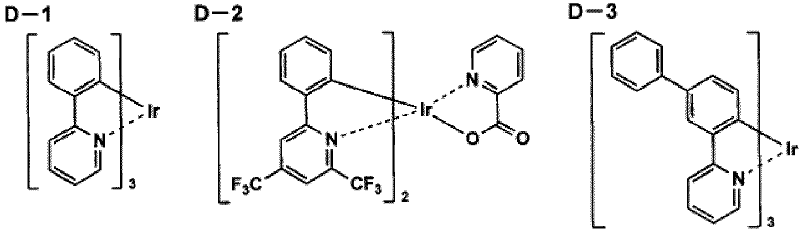

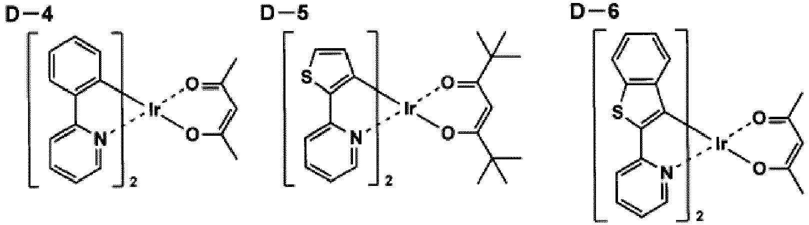

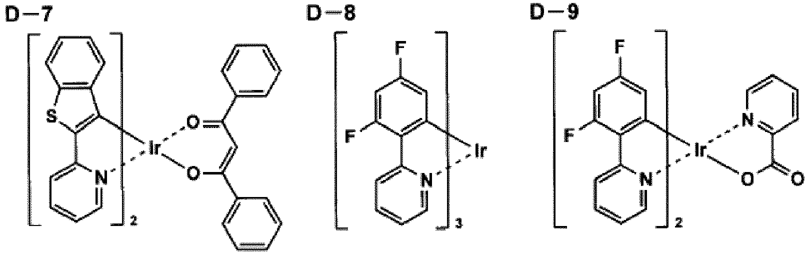

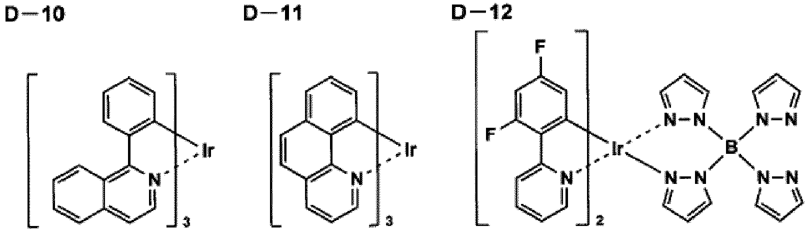

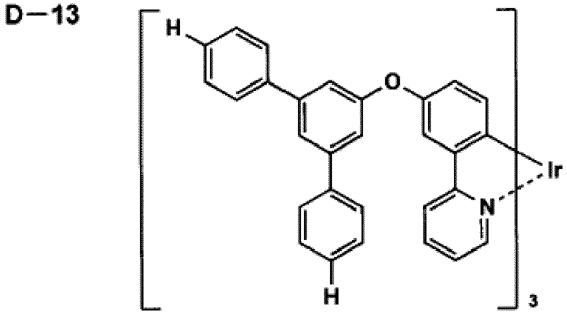

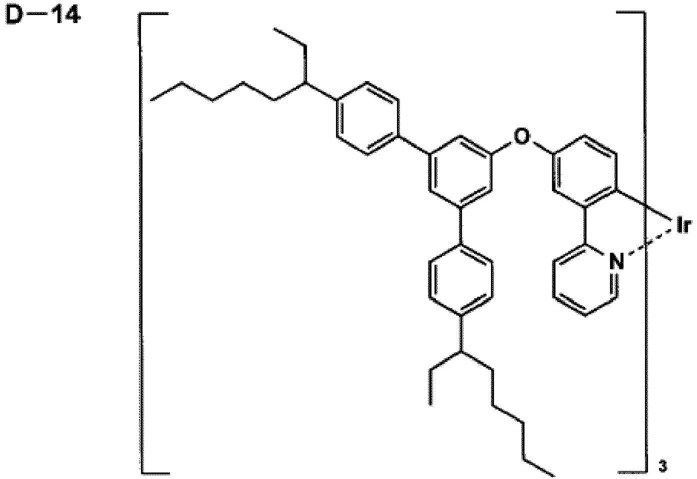

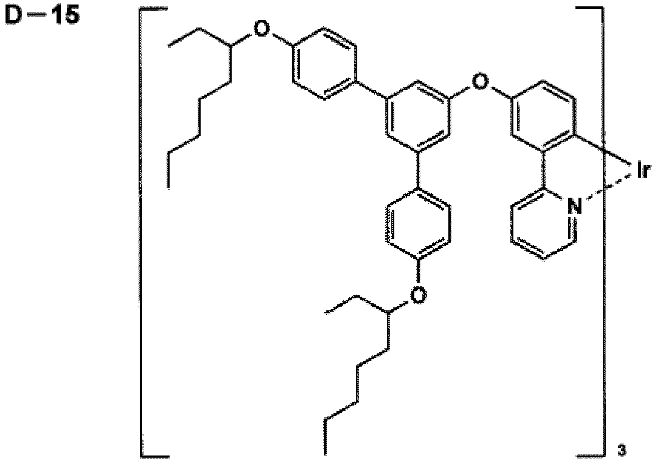

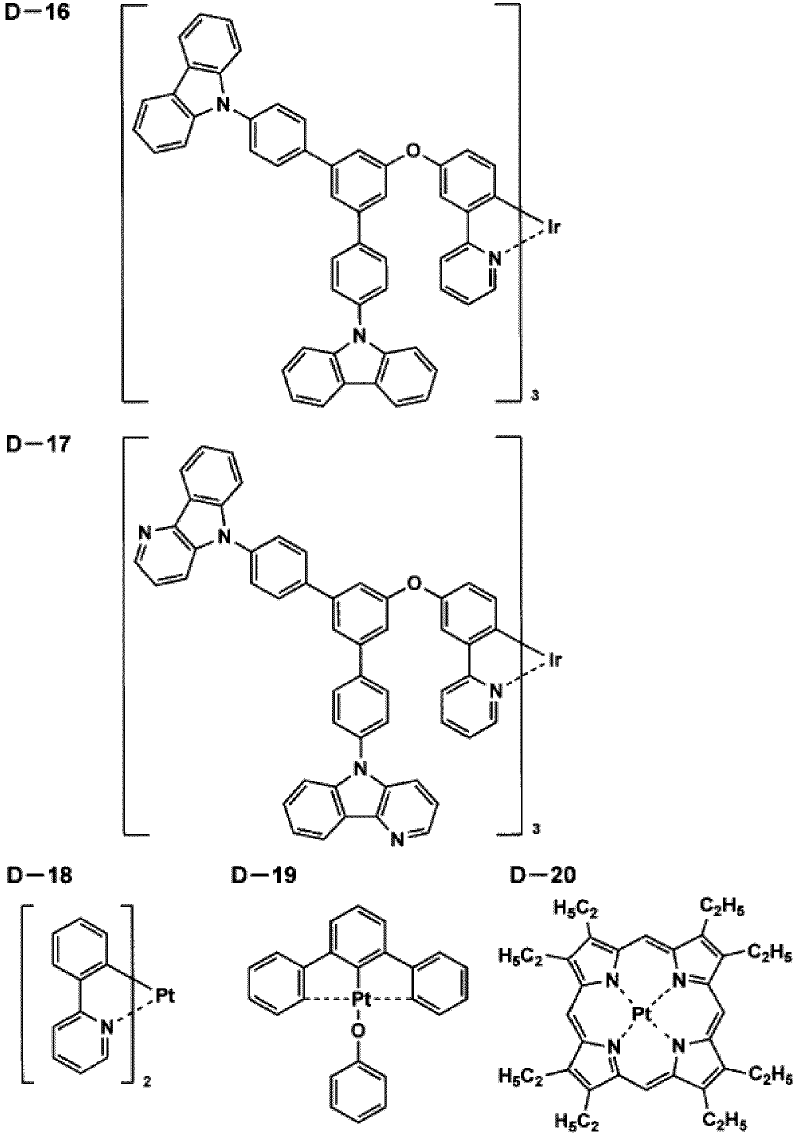

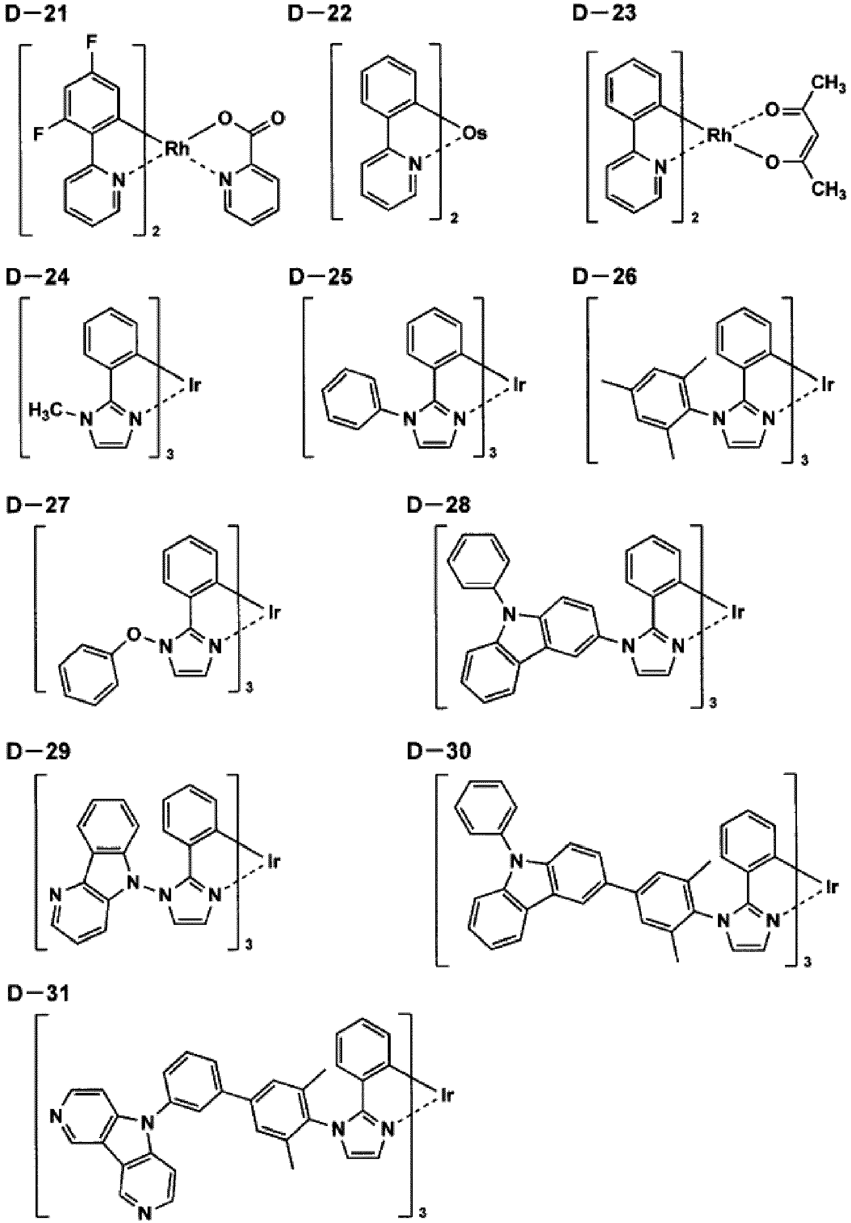

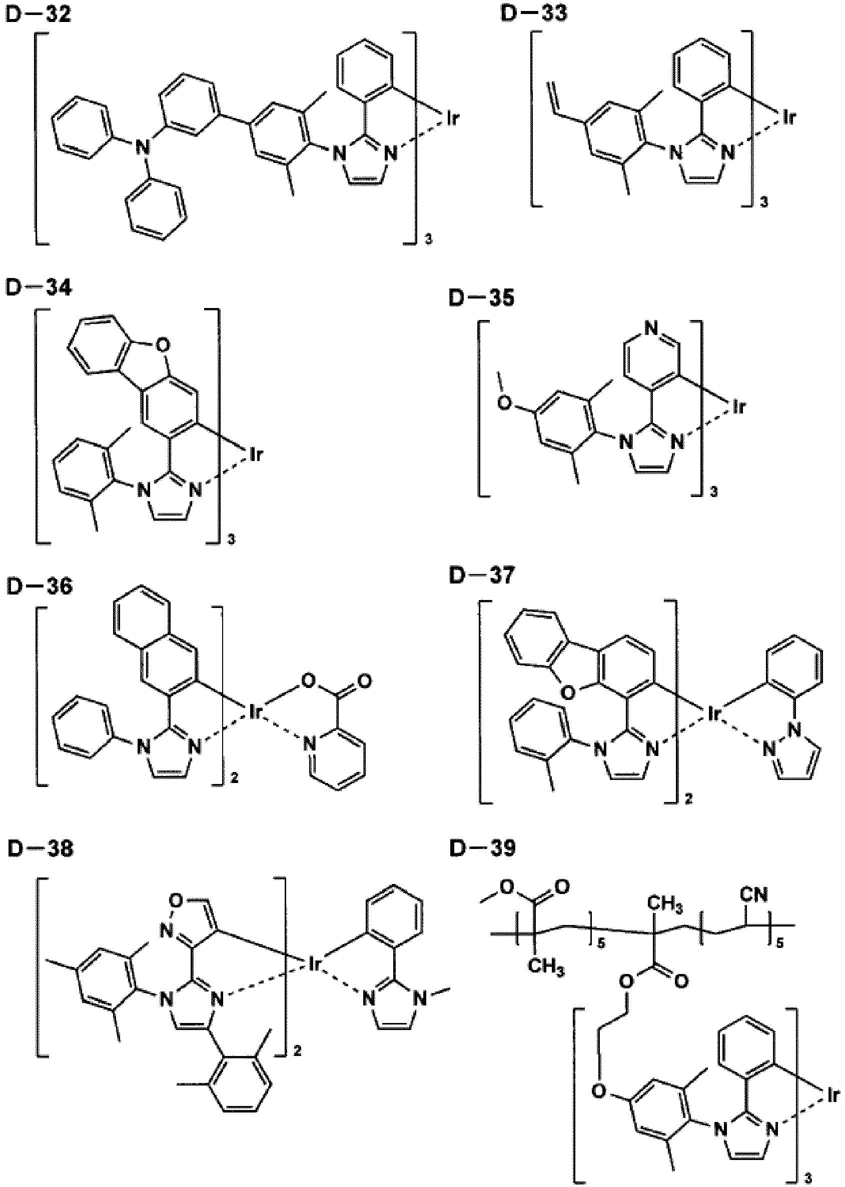

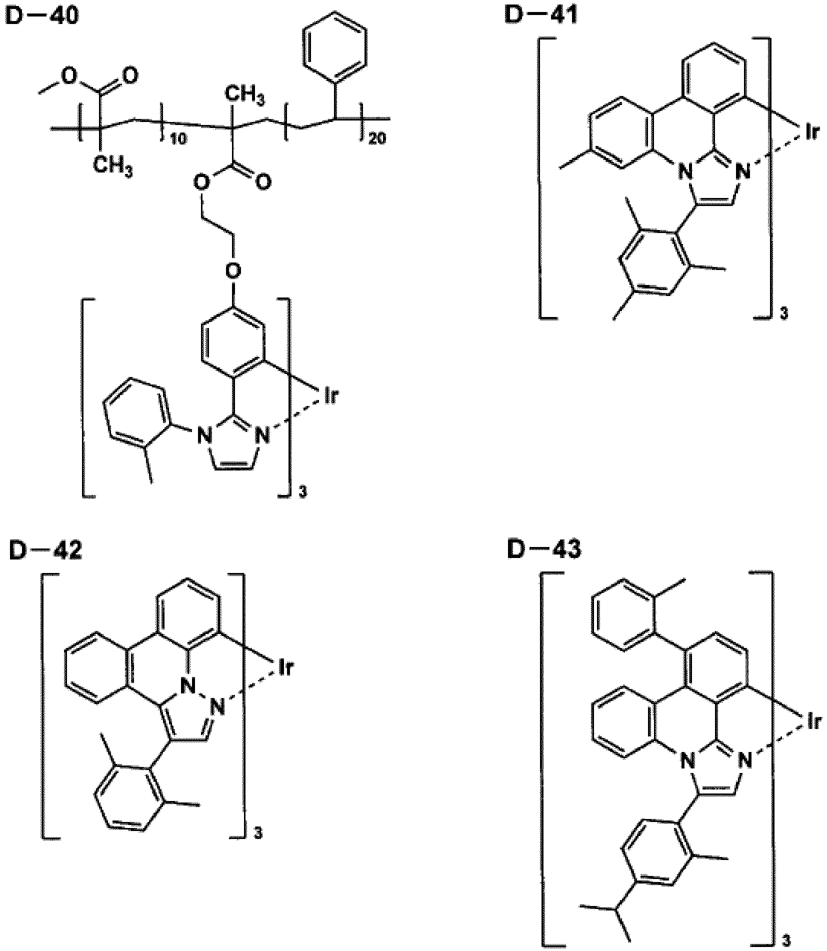

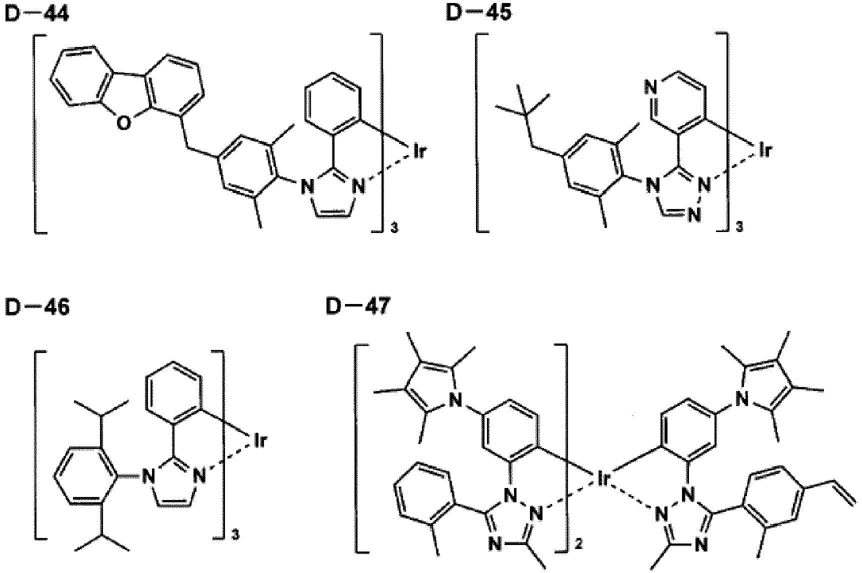

### (2) Luminescent host compound (also called luminescent host or host compound)

The host compound to be used in the present invention is defined as a compound whose mass ratio in the light emitting layer among the compounds contained in the layer is 20% or more, and whose phosphorescence quantum yield of phosphorescent luminescence at room temperature (25°C) is less than 0.1. Preferably, the phosphorescence quantum yield is less than 0.01. Furthermore, it is preferable that among the compounds contained in the light emitting layer, the mass ratio of the host compound in the layer is 20% or more.

There are no particular limitations on the luminescent host that can be used in the present invention, and compounds that are conventionally used in organic EL elements can be used. Representative examples thereof include carbazole derivatives, triarylamine derivatives, aromatic derivatives, nitrogen-containing heterocyclic compounds, thiophene derivatives, furan derivatives, compounds having a basic skeleton of oligoarylene compounds or the like, and carboline derivatives, and diazacarbazole derivatives (here, a diazacarbazole derivative means a compound in which at least one carbon atom of the hydrocarbon ring that constitutes the carboline ring of a carboline derivative has been substituted by a nitrogen atom).

Preferred as a known luminescent host that can be used in the present invention is a compound which has hole transport capacity and electron transport capacity, prevents a shift to longer wavelength of the emitted light, and has a high Tg (glass transition temperature).

Furthermore, according to the present invention, conventionally known luminescent hosts may be used singly, or plural kinds of luminescent hosts may be used in combination. When plural kinds of luminescent hosts are used together, migration of charges can be regulated, and high efficiency of the organic EL element can be obtained. Furthermore, when plural kinds of the metal complex that are used as the phosphorescent dopants and/or plural kinds of conventionally known compounds are used together, it is made possible to mix different light emissions, and thereby arbitrary emitted light colors can be obtained.

Furthermore, the luminescent host that is used in the present invention may be a low molecular weight compound, may be a polymeric compound having repeating units, or may be a low molecular weight compound having a polymerizable group such as a vinyl group or an epoxy group (polymerizable luminescent host). Also, one kind or plural kinds of these compounds may be used.

Specific examples of known luminescent hosts include the compounds described in the following literatures:
JP 2001-257076 A, JP 2002-308855 A, JP 2001-313179 A, JP 2002-319491 A, JP 2001-357977 A, JP 2002-334786 A, JP 2002-008860 A, JP 2002-334787 A, JP 2002-015871 A, JP 2002-334788 A, JP 2002-043056 A, JP 2002-334789 A, JP 2002-075645 A, JP 2002-338579 A, JP 2002-105445 A, JP 2002-343568 A, JP 2002-141173 A, JP 2002-352957 A, JP 2002-203683 A, JP 2002-363227 A, JP 2002-231453 A, JP 2003-003165 A, JP 2002-234888 A, JP 2003-027048 A, JP 2002-255934 A, JP 2002-260861 A, JP 2002-280183 A, JP 2002-299060 A, JP 2002-302516 A, JP 2002-305083 A, JP 2002-305084 A, and JP 2002-308837 A.

Specific examples of a compound that is used as a luminescent host in the light emitting layer of the organic EL element of the present invention are described below, but the present invention is not intended to be limited to these.

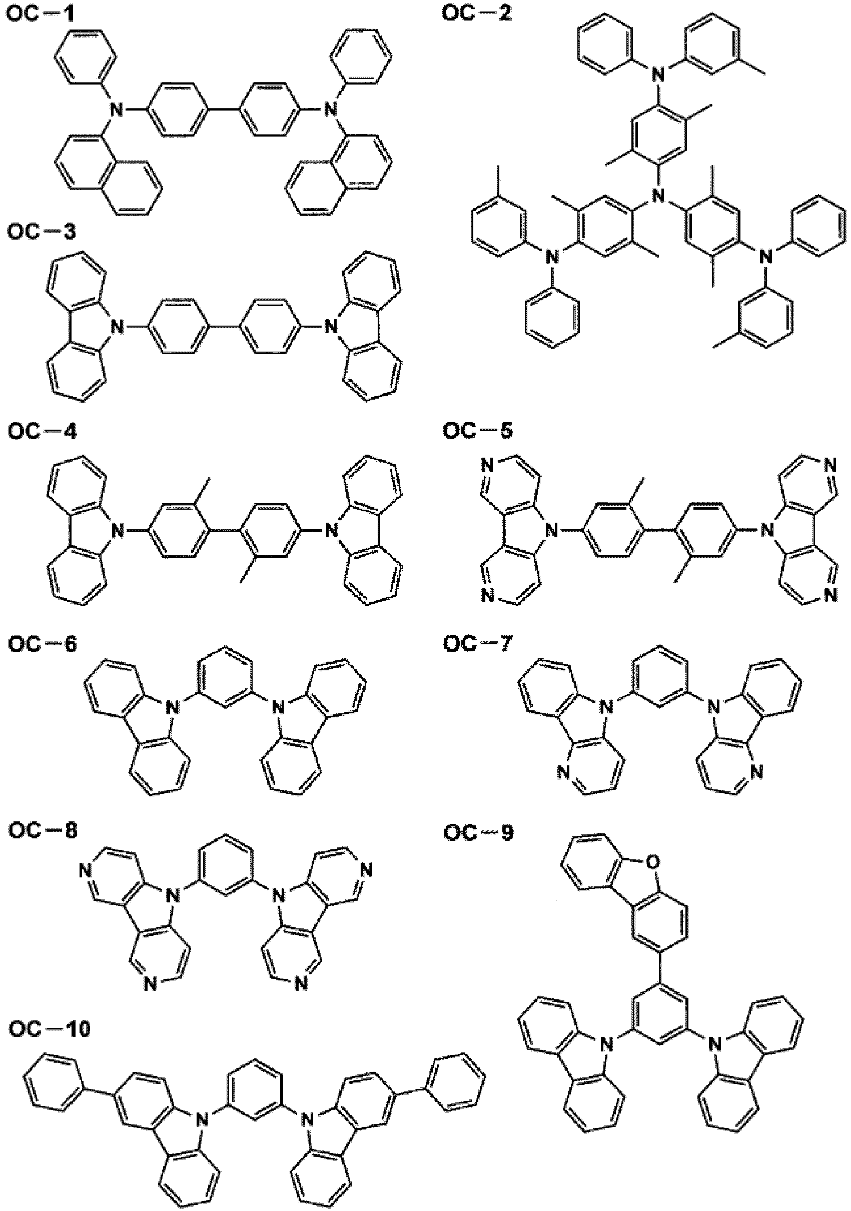

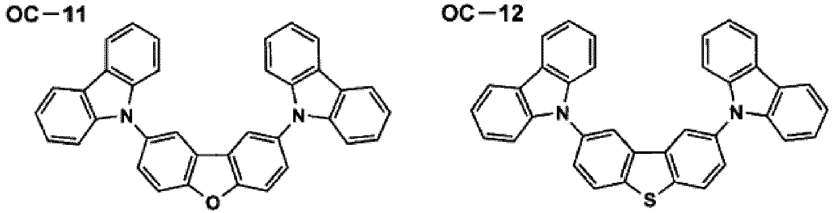

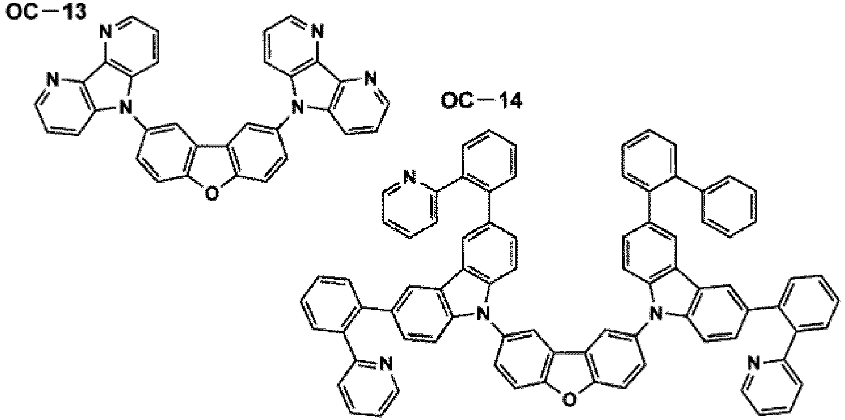

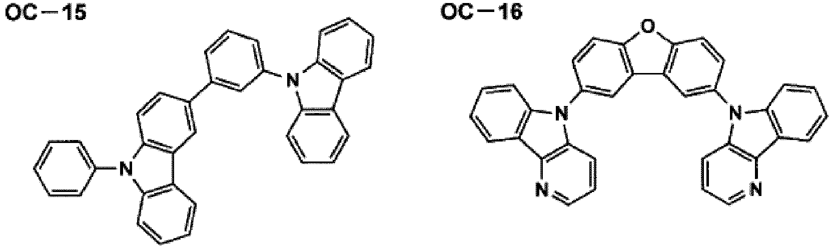

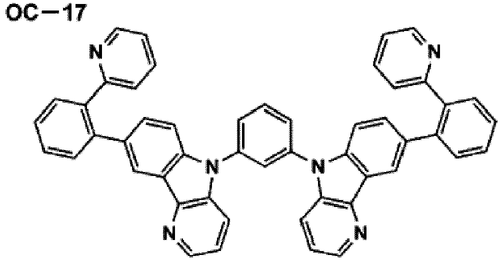

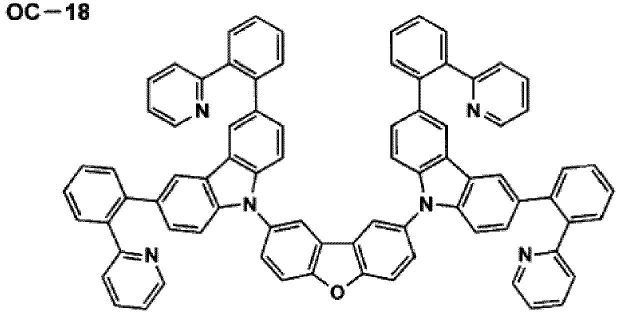

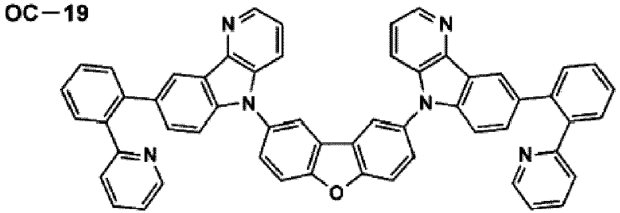

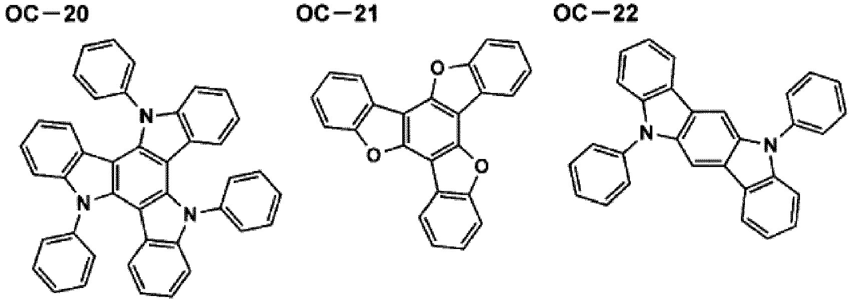

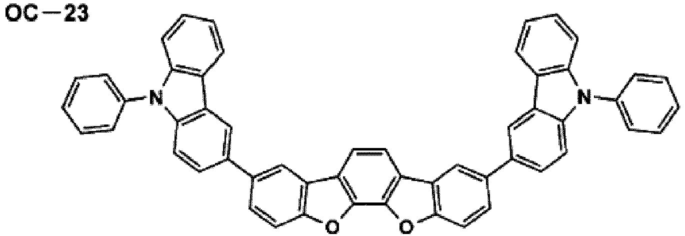

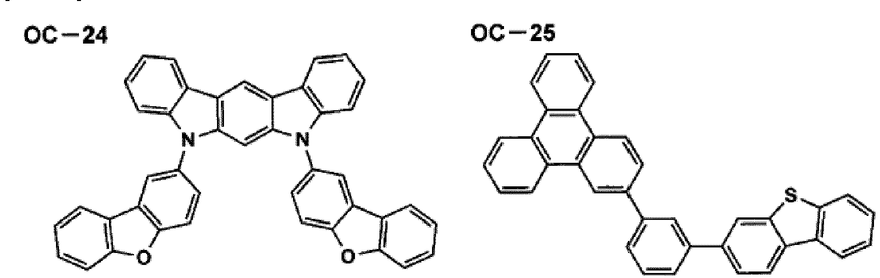

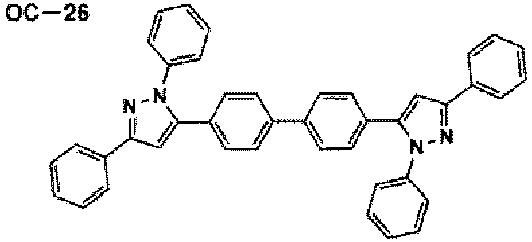

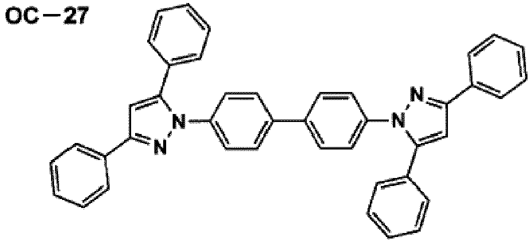

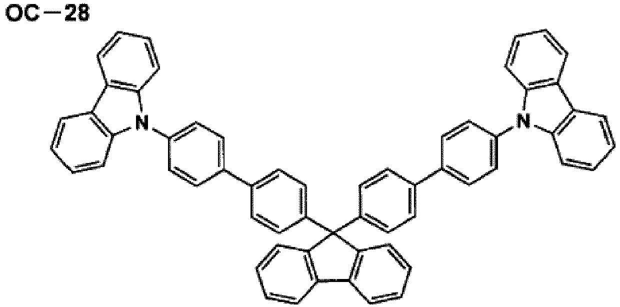

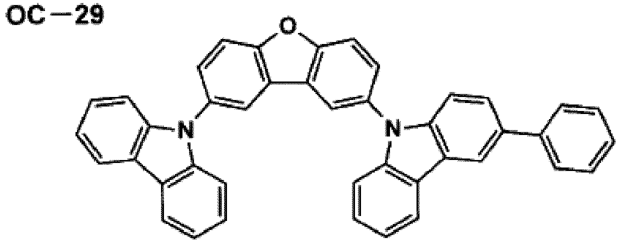

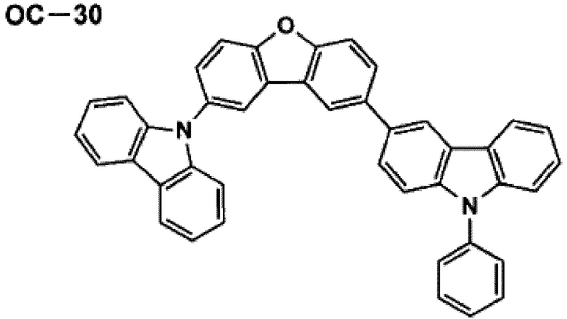

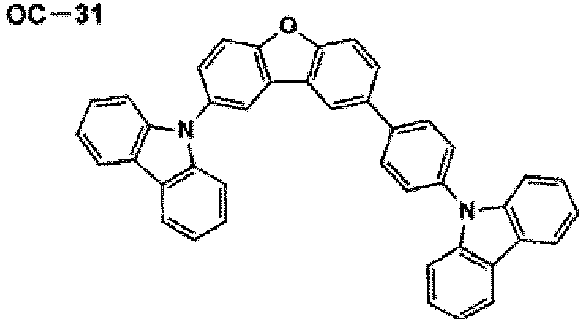

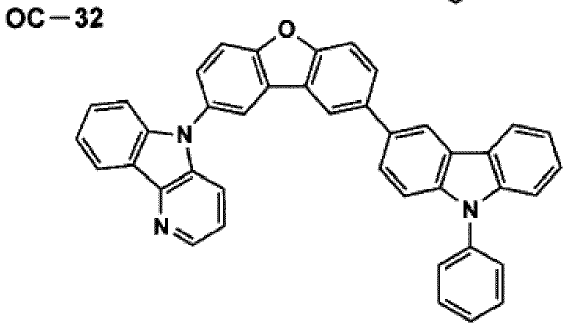

Furthermore, particularly preferred examples of the luminescent host for the light emitting layer of the organic EL element of the present invention include compounds represented by the following formula (B) and formula (E):

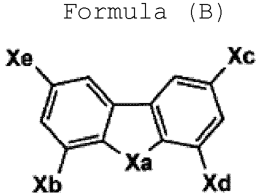

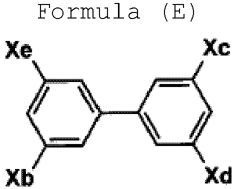

In formulas (B) and (E), Xa represents O or S Xb, Xc, Xd and Xe each represent a hydrogen atom, a substituent, or a group represented by the following formula (C) ; at least one of Xb, Xc, Xd and Xe represents a group represented by the following formula (C) ; and Ar in at least one among the groups represented by the following formula (C) represents a carbazolyl group:

Formula (C) Ar-(L₄)ₙ-*

In formula (C), L₄ represents a divalent linking group derived from an aromatic hydrocarbon ring or an aromatic heterocyclic ring; n represents an integer from 0 to 3; when n is 2 or larger, plural L₄'s may be identical or different; * represents a linking site to formula (B) or (E); and Ar represents a group represented by the following formula (D):

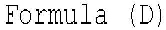

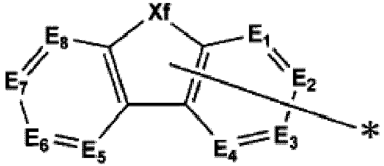

In formula (D), Xf represents N(R"), O or S; E₁ to E₈ each represent C (R"₁) or N; R" and R"₁ each represent a hydrogen atom, a substituent, or a linking site to L₄ in formula (C); and * represents a linking site to L₄ in formula (C).

In regard to the compound represented by the above formula (B), preferably, at least two among Xb, Xc, Xd and Xe are represented by formula (C), and more preferably, Xc is represented by formula (C), while Ar in formula (C) represents a carbazolyl group which may be substituted.

Specific examples of the compound represented by formula (B) that are preferably used as the host compound (also called luminescent host) for the light emitting layer of the organic EL element of the present invention are listed below, but the present invention is not intended to be limited to these.

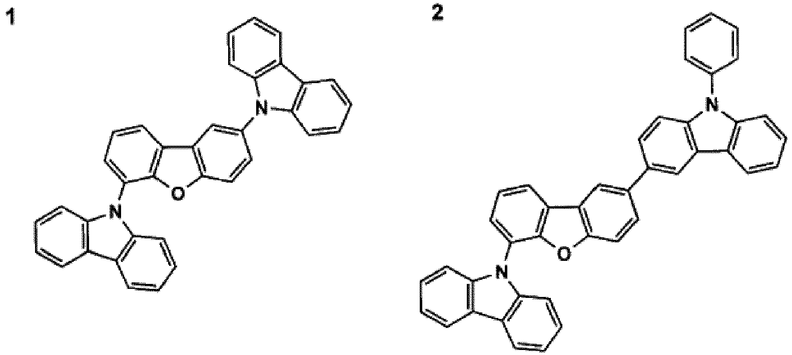

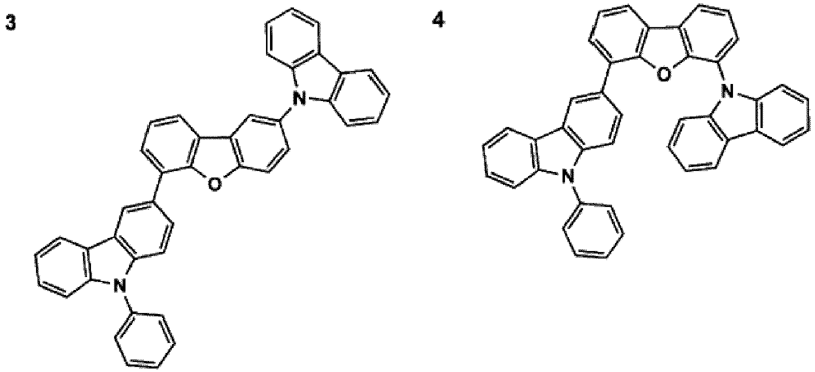

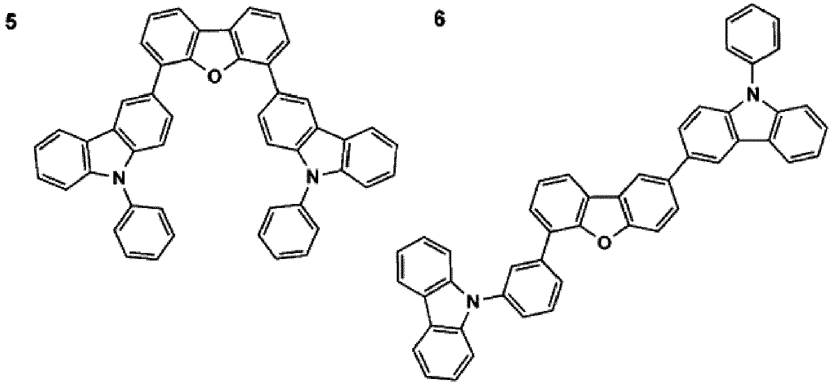

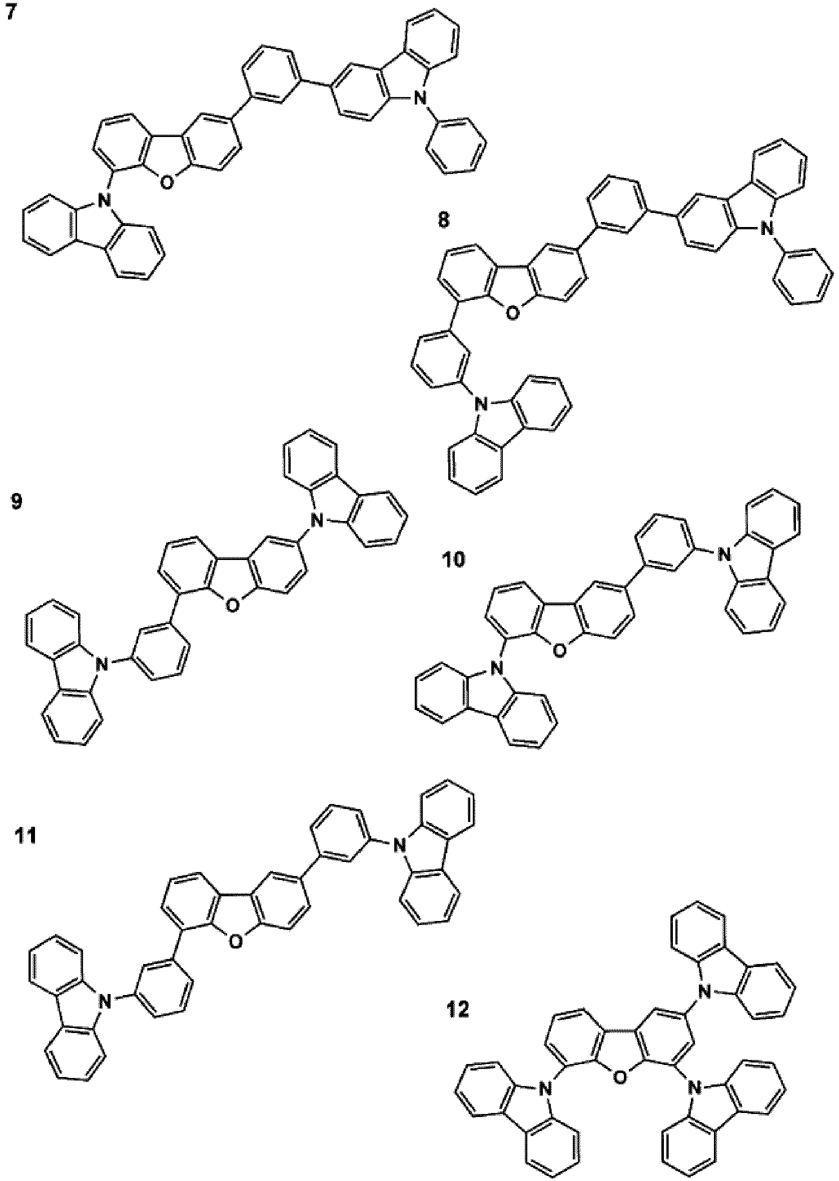

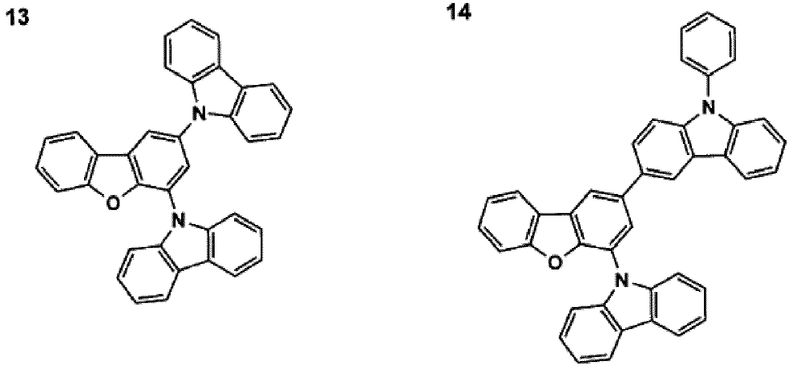

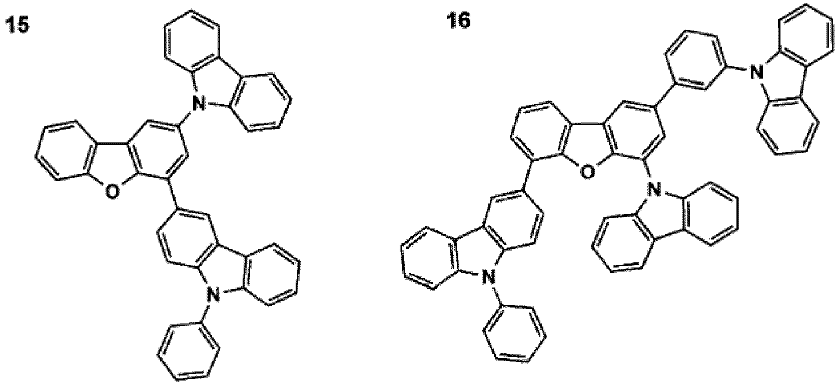

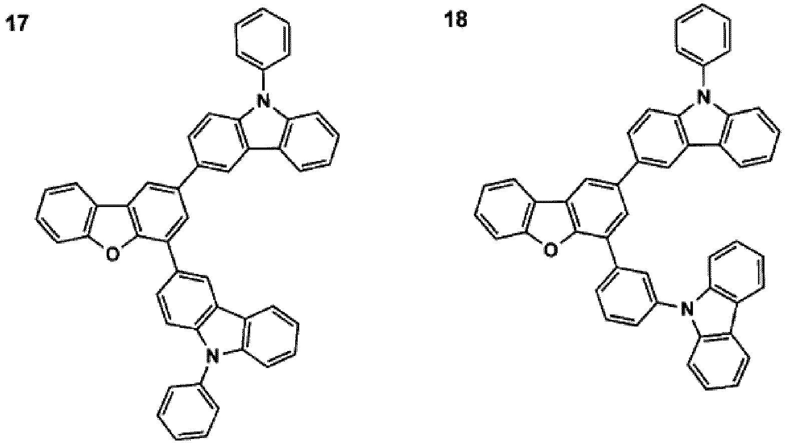

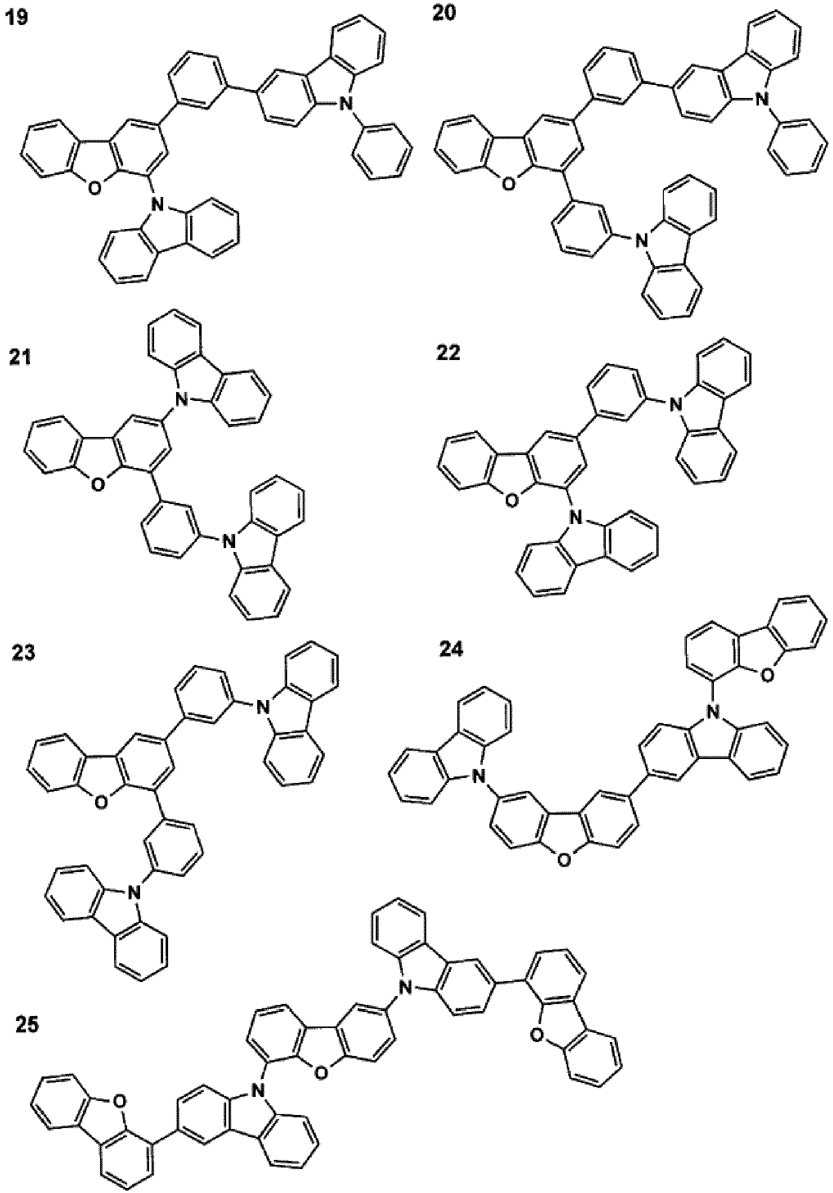

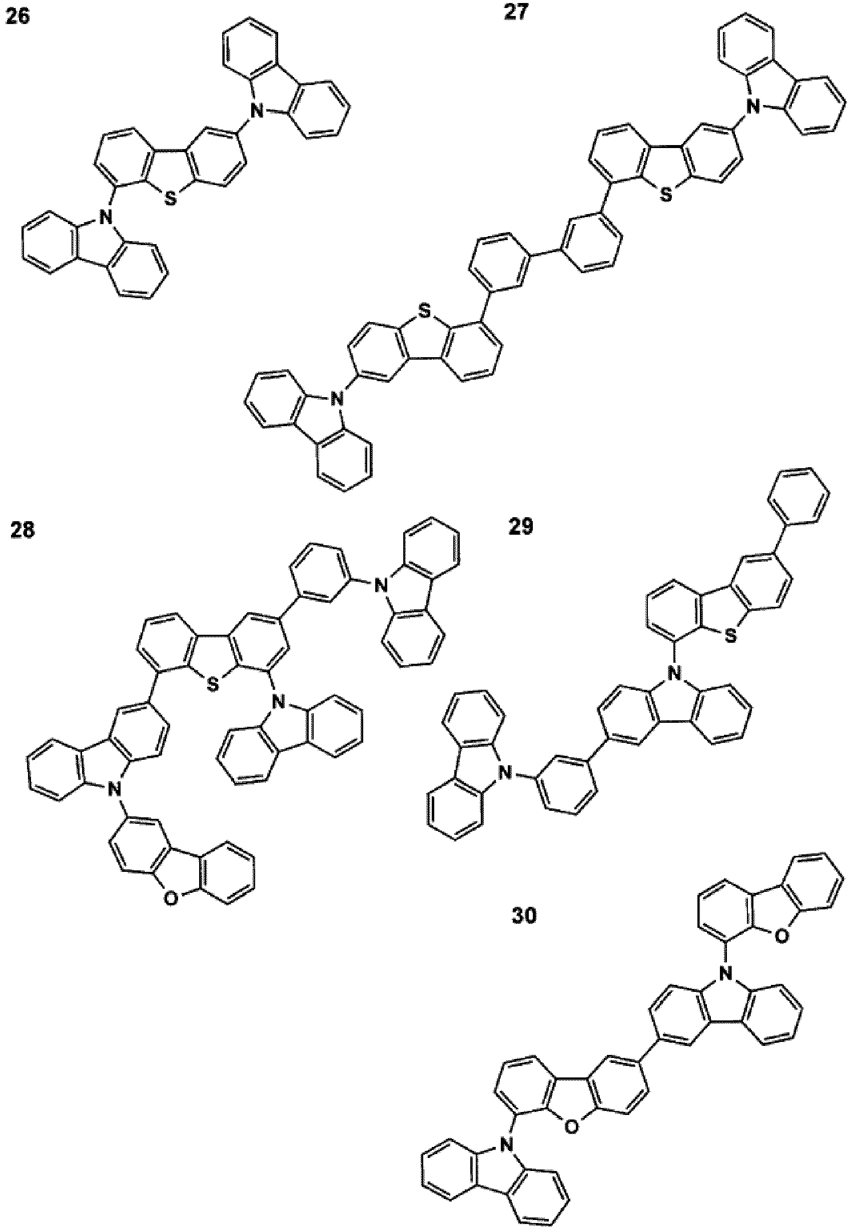

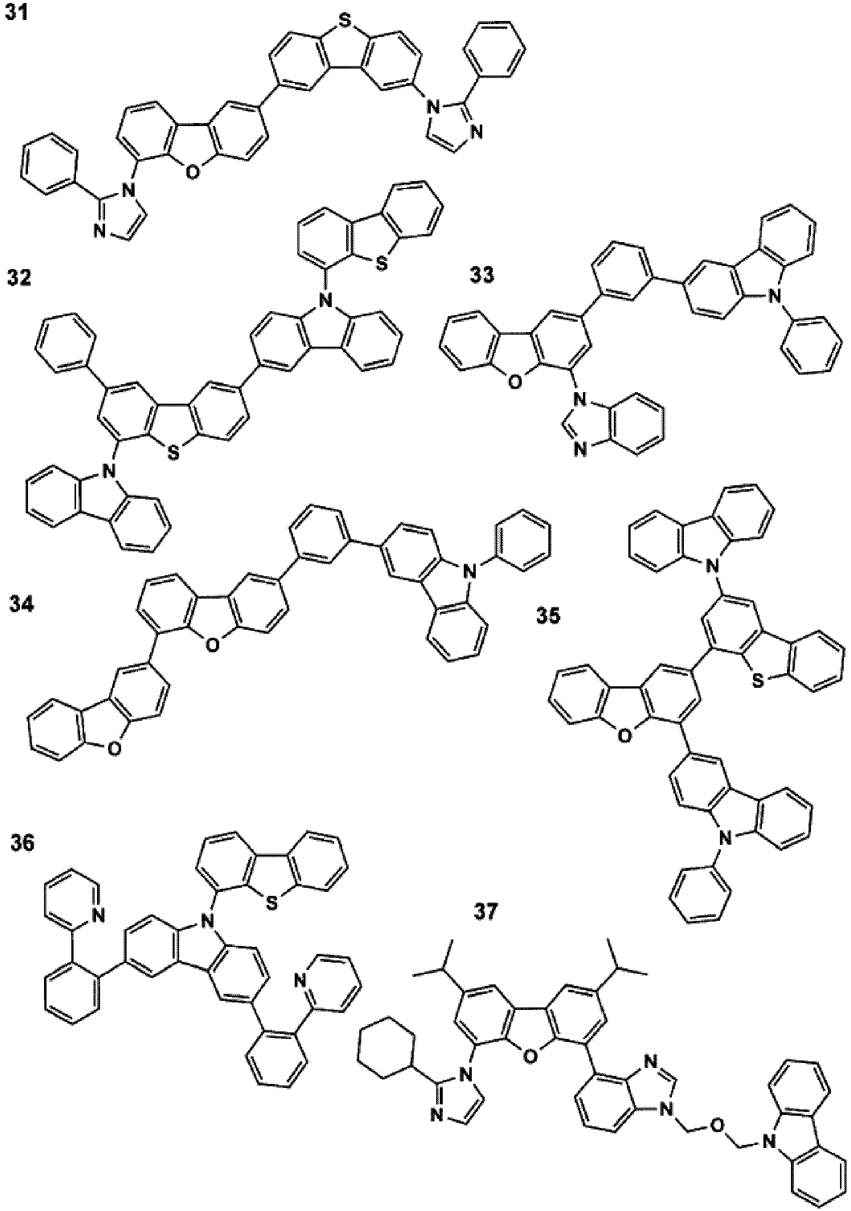

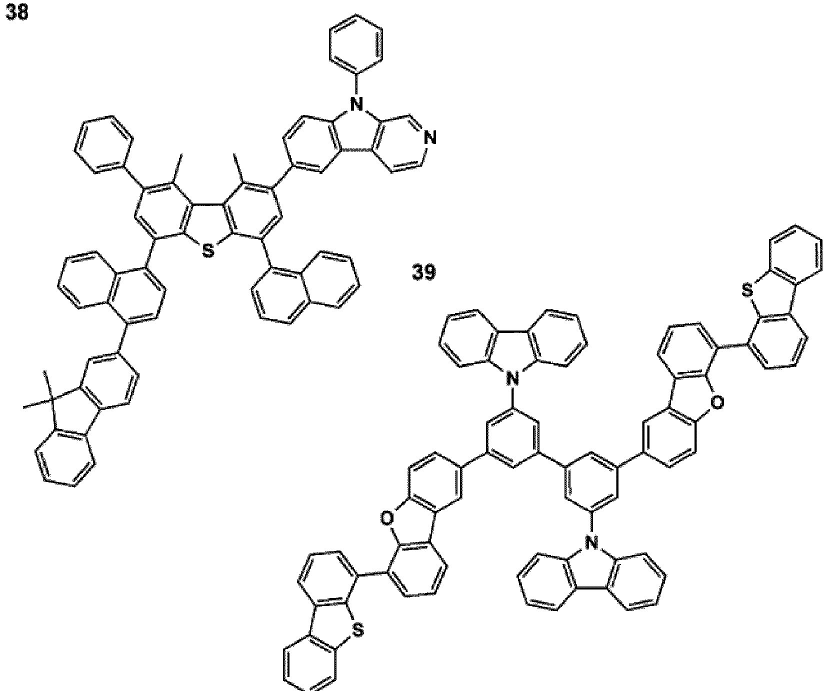

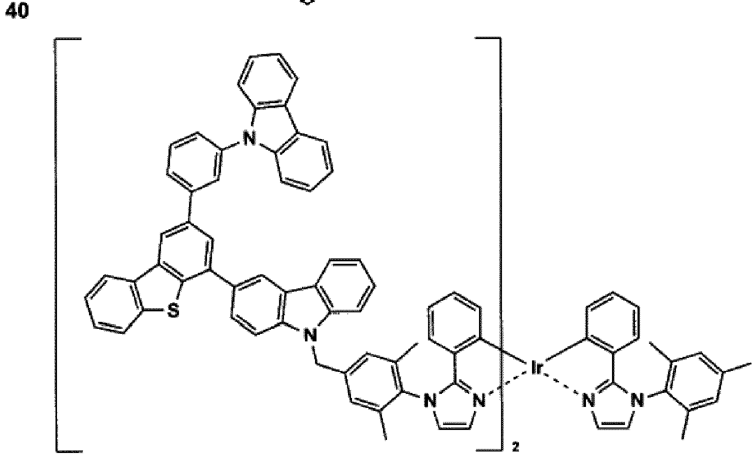

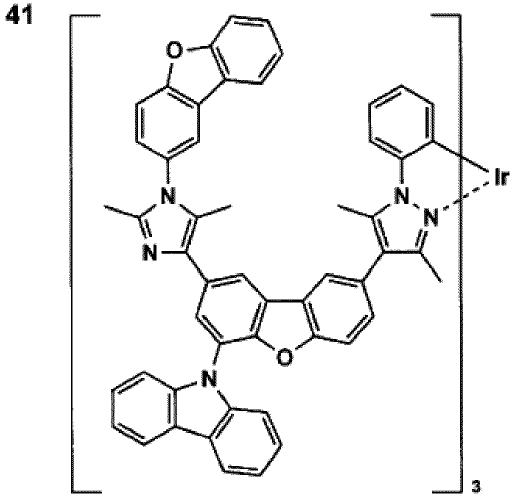

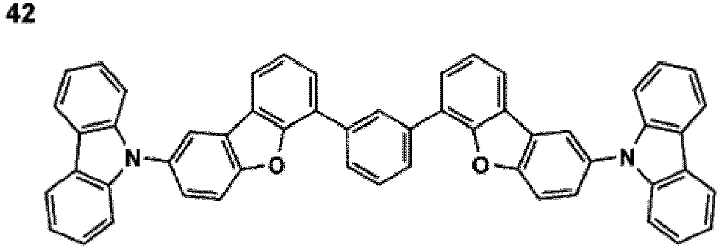

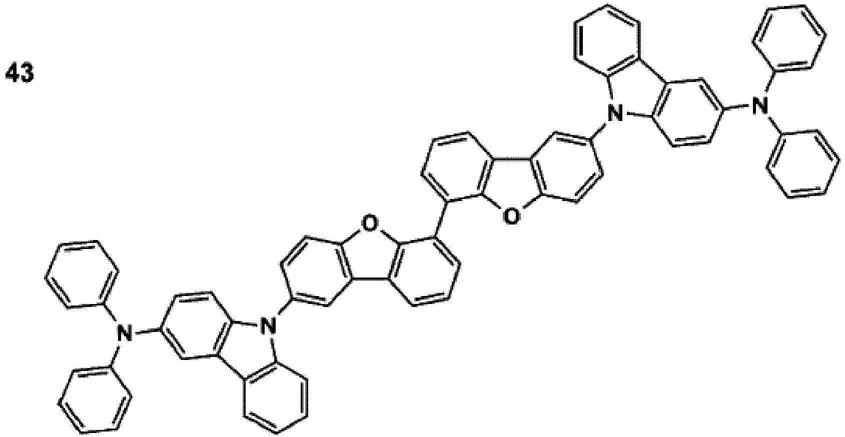

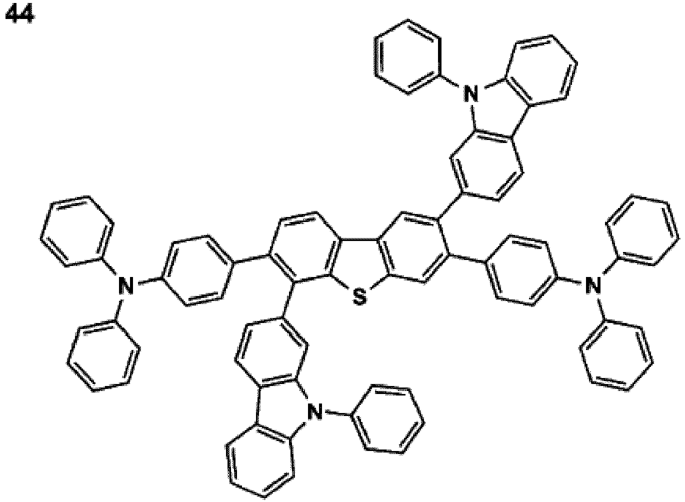

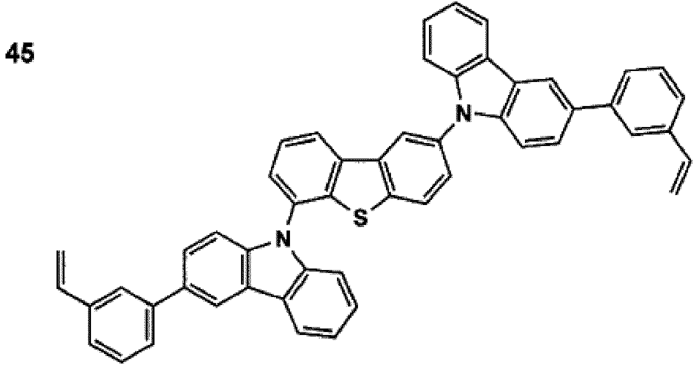

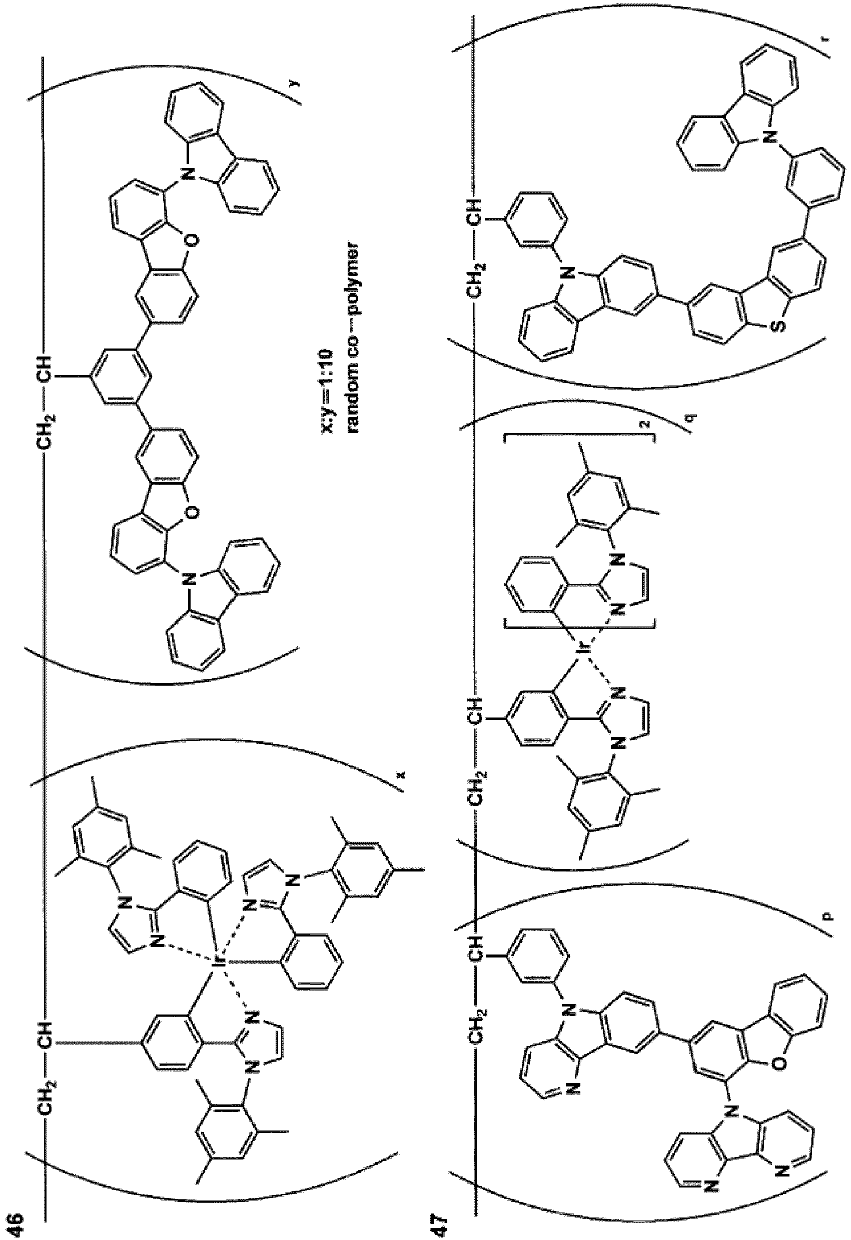

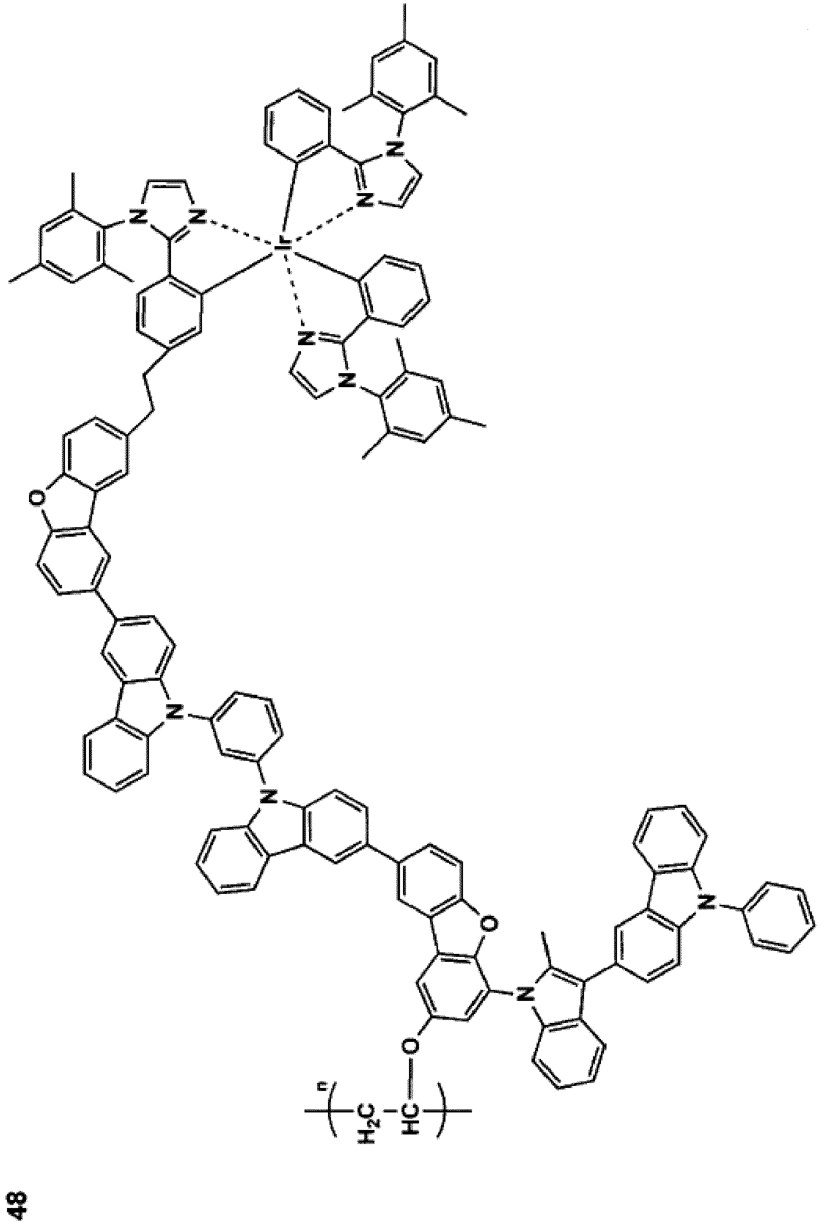

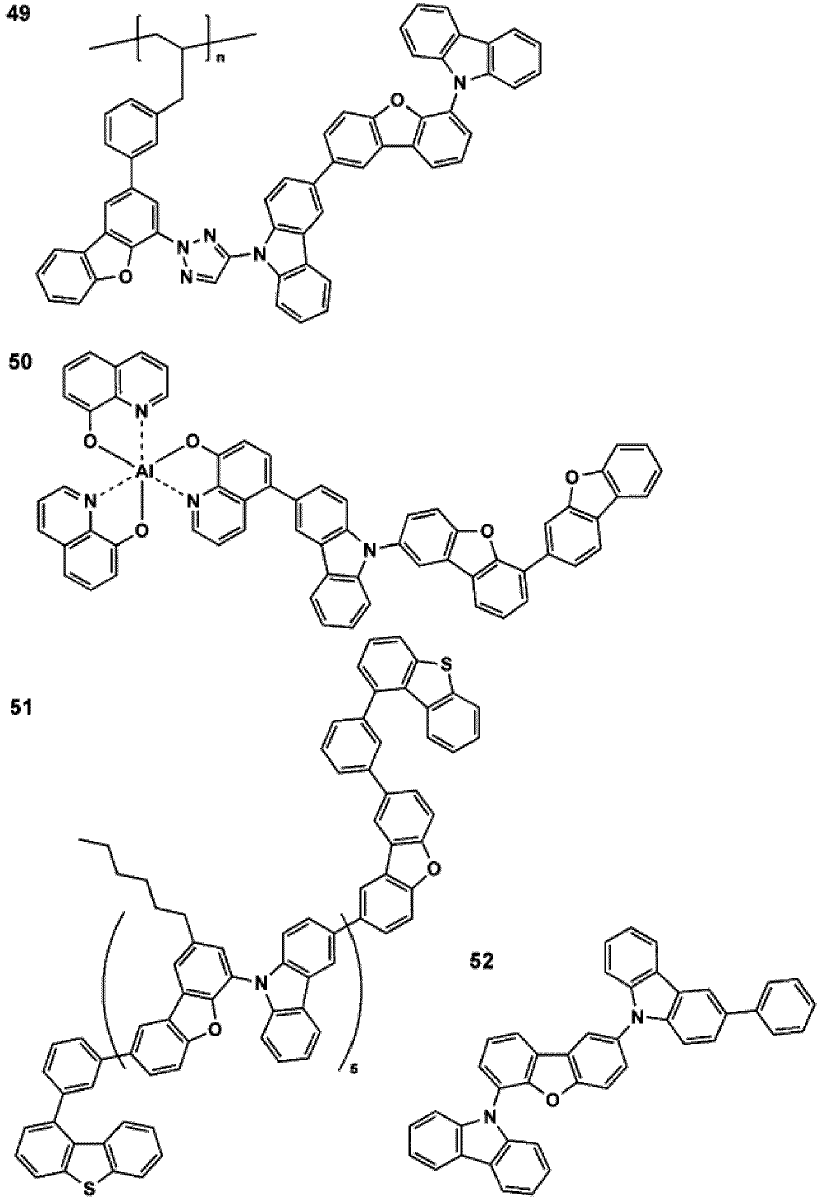

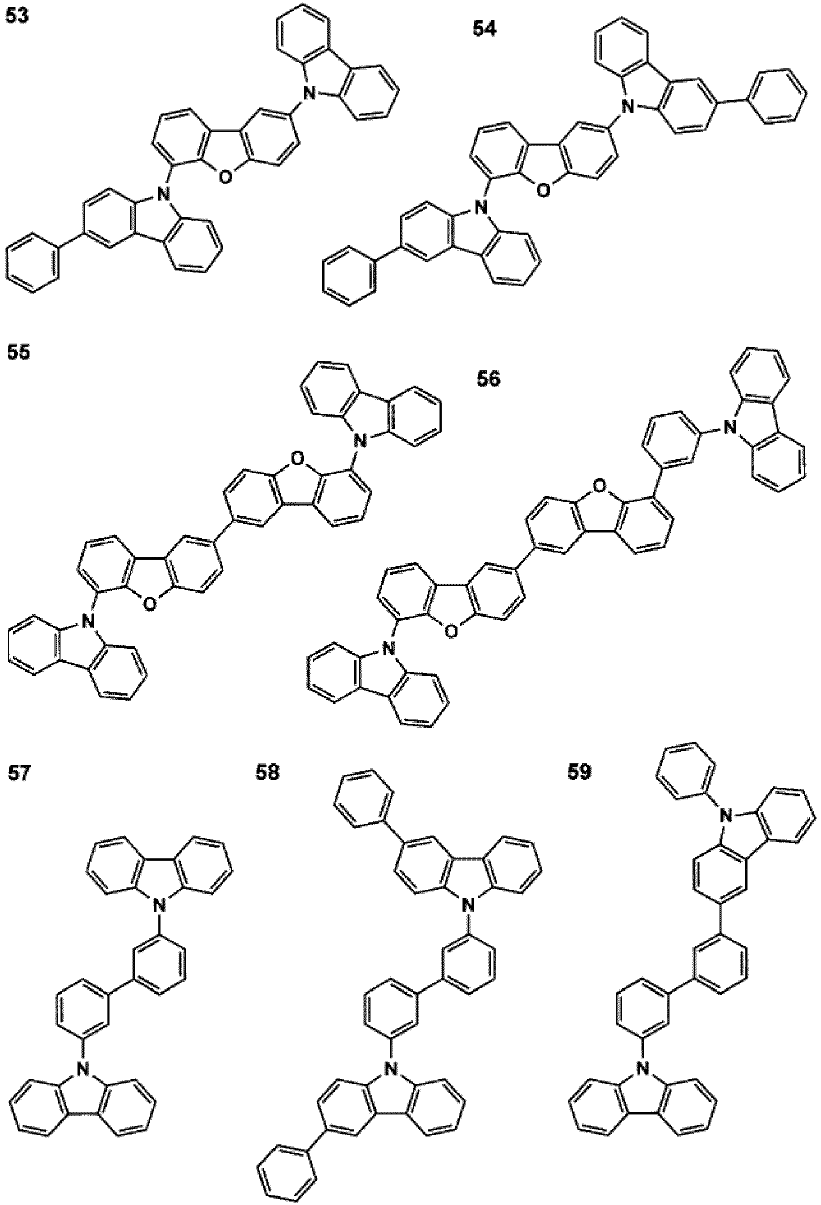

Furthermore, a compound represented by the following formula (B') is also particularly preferably used as the luminescent host for the light emitting layer of the organic EL element of the present invention.

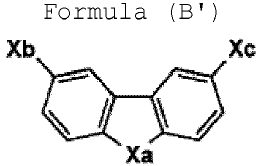

In formula (B'), Xa represents O or S; Xb and Xc each represent a substituent or a group represented by the above formula (C).

At least one of Xb and Xc represents a group represented by the above formula (C), and Ar of at least one of the groups represented by the formula (C) represents a carbazolyl group.

In regard to the compound represented by the above formula (B'), preferably, Ar of formula (C) represents a carbazolyl group which may be substituted, and more preferably, Ar of formula (C) represents a carbazolyl group which may be substituted and is linked to L₄ in the formula (C) at the N-position.

Specific examples of the compound represented by formula (B') that is preferably used as the host compound (also called luminescent host) for the light emitting layer of the organic EL element of the present invention include OC-9, OC-11, OC-12, OC-14, OC-18, OC-29, OC-30, OC-31, and OC-32, which have been previously listed as specific examples that are used as the luminescent host; however, the present invention is not intended to be limited to these.

### <<Electron transport layer>>

The electron transport layer is formed from a material having a function of transporting electrons, and in a wide sense, an electron injection layer and a hole blocking layer are also included in the electron transport layer. The electron transport layer may be provided as a single layer or as plural layers.

It is desirable if the electron transport layer has a function of transferring the electrons injected from the negative electrode to the light emitting layer, and regarding the constituent material for the electron transport layer, any arbitrary materials can be selected from conventionally known compounds and used in combination.

Examples of the conventionally known material that is used in the electron transport layer (hereinafter, referred to as electron transporting material) include nitro-substituted fluorene derivatives, diphenylquinone derivatives, thiopyran dioxide derivatives, polycyclic aromatic hydrocarbons such as naphthalene-perylene, heterocyclic tetracarboxylic acid anhydrides, carbodiimide, fluorenylidenemethane derivatives, anthrquinodimethane and anthrone derivatives, oxadiazole derivatives, carboline derivatives, derivatives having a ring structure in which at least one of the carbon atoms of a hydrocarbon ring that constitutes the carboline ring of the carboline derivatives has been substituted by a nitrogen atom, and hexaazatriphenylene derivatives.

Furthermore, thiadiazole derivatives in which an oxygen atom of the oxadiazole ring in the oxadiazole derivative has been substituted by a sulfur atom; and quinoxaline derivatives having a quinoxaline ring, which is known as an electron-withdrawing group, can also be used as the electron transporting materials.

Polymeric materials having these materials introduced into the polymer chain, or polymeric materials employing these materials as the main chain of the polymer, can also be used.

Furthermore, metal complexes of 8-quinolinol derivatives such as, for example, tris(8-quinolinol)aluminum (Alq), tris(5,7-dichloro-8-quinolinol)aluminum, tris(5,7-dibromo-8-quinolinol)aluminum, tris(2-methyl-8-quinolinol)aluminum, tris(5-methyl-8-quinolinol)aluminum, and bis(8-quinolinol)zinc (Znq); and metal complexes in which the center metal of these metal complexes has been replaced with In, Mg, Cu, Ca, Sn, Ga or Pb, can also be used as the electron transporting materials.

In addition to them, metal-free or metal phthalocyanines, or those phthalocyanines in which terminals thereof have been substituted with alkyl groups, sulfonic acid groups or the like, can also be used as the electron transporting materials.

Furthermore, inorganic semiconductors such as n-type Si and n-type SiC can also be used as the electron transporting materials.

The electron transport layer is preferably formed by forming a thin film of an electron transporting material by, for example, a vacuum deposition method, or a wet method (also called a wet process, and examples thereof include a spin coating method, a casting method, a die coating method, a blade coating method, a roll coating method, an inkjet method, a printing method, a spray coating method, a curtain coating method, or an LB method (Langmuir-Blodgett method)).

There are no particular limitations on the film thickness of the electron transport layer, but the film thickness is usually about 5 nm to 5000 nm, and preferably 5 nm to 200 nm. This electron transport layer may have a single-layer structure formed from one kind or two or more kids of the materials described above.

Furthermore, materials doped with n-type dopants such as metal complexes or metal compounds such as metal halides may also be used.

Specific examples of conventionally known compounds (electron transporting material) that are preferably used in the formation of the electron transport layer of the white organic EL element of the present invention are listed below, but the present invention is not intended to be limited to these.

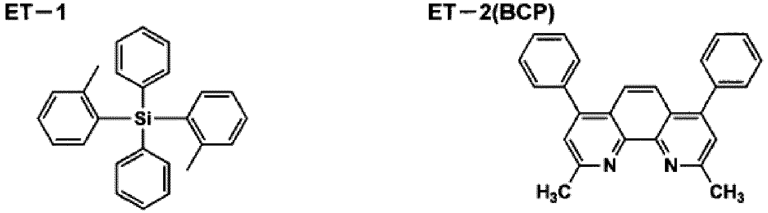

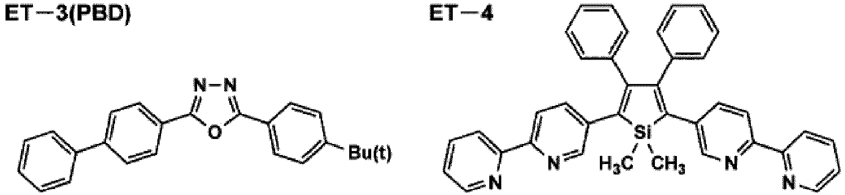

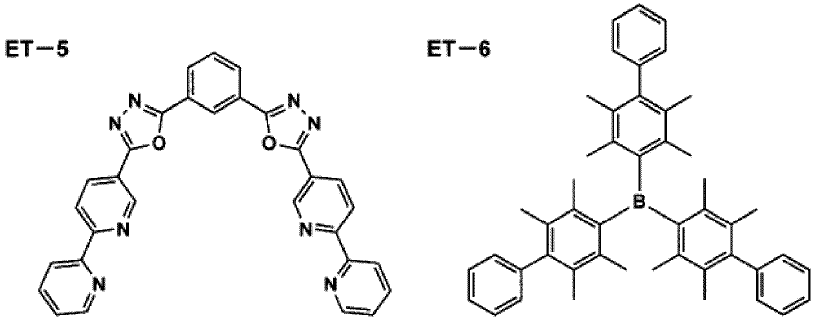

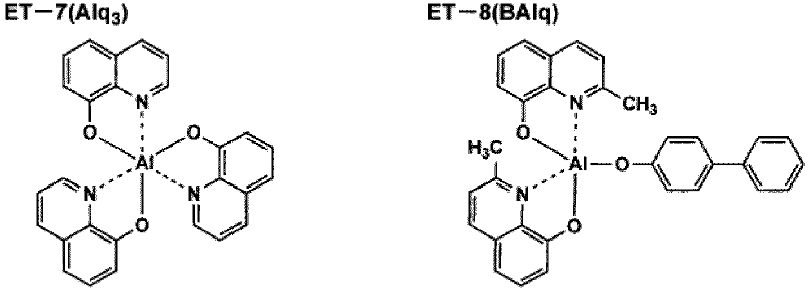

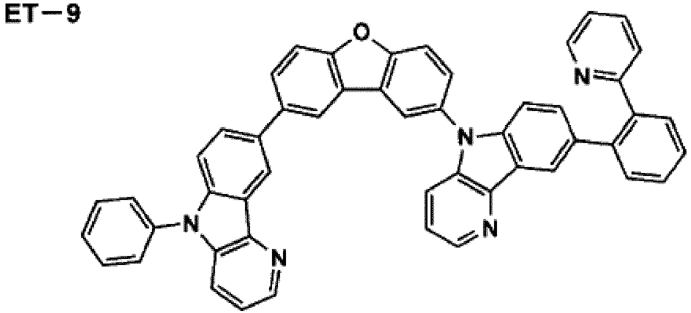

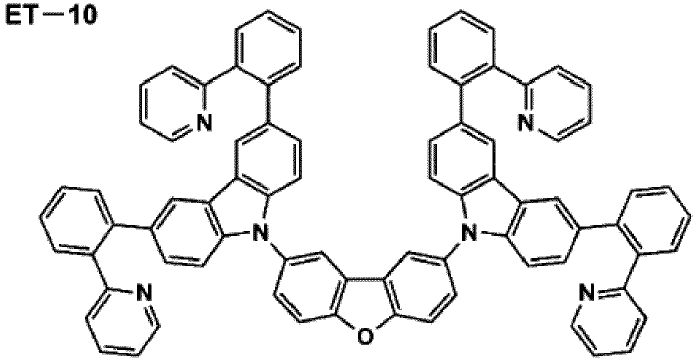

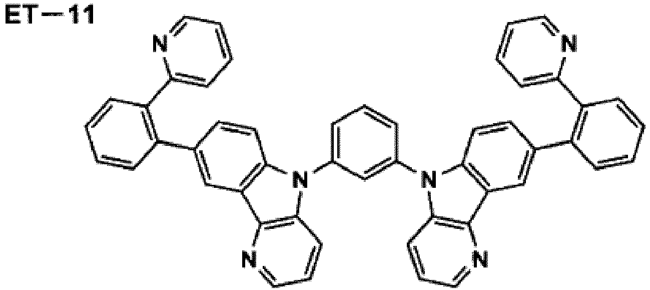

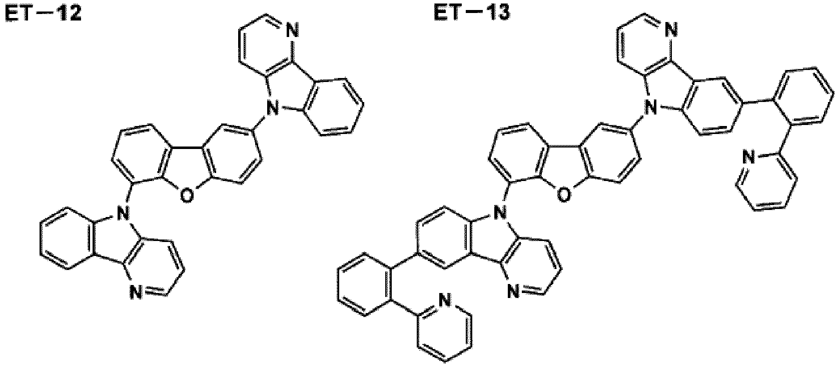

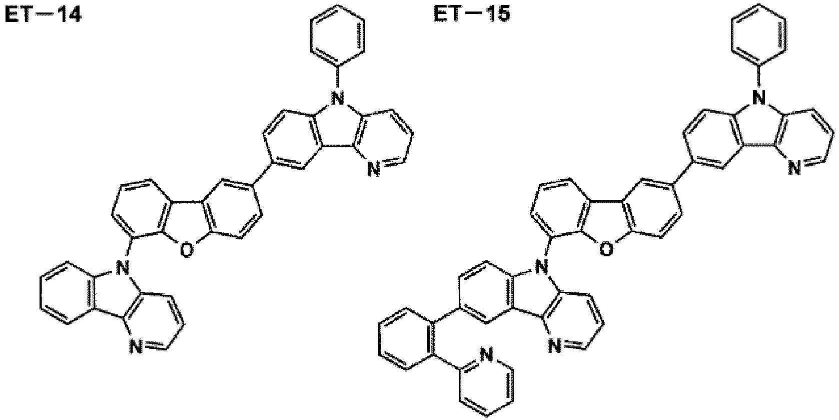

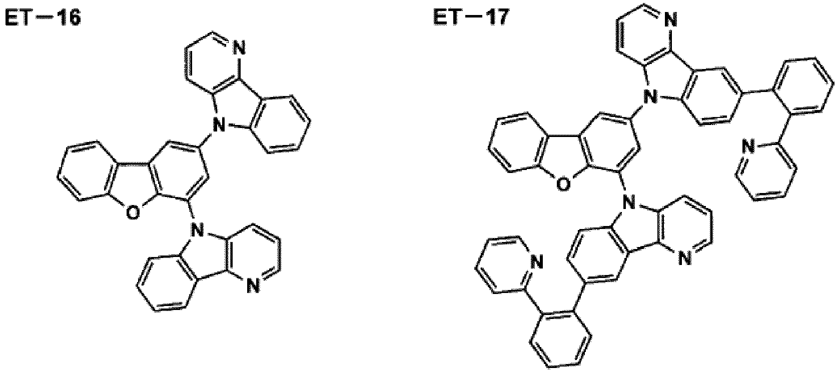

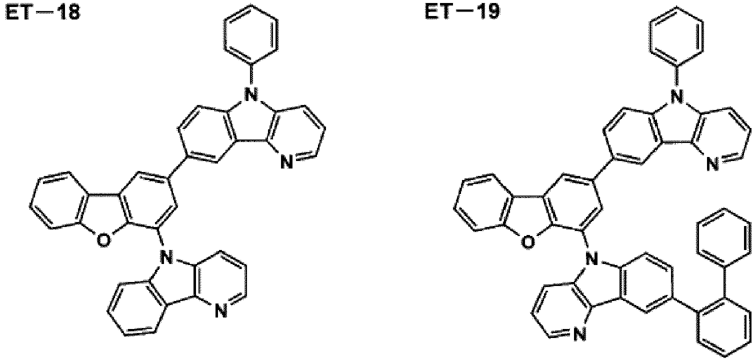

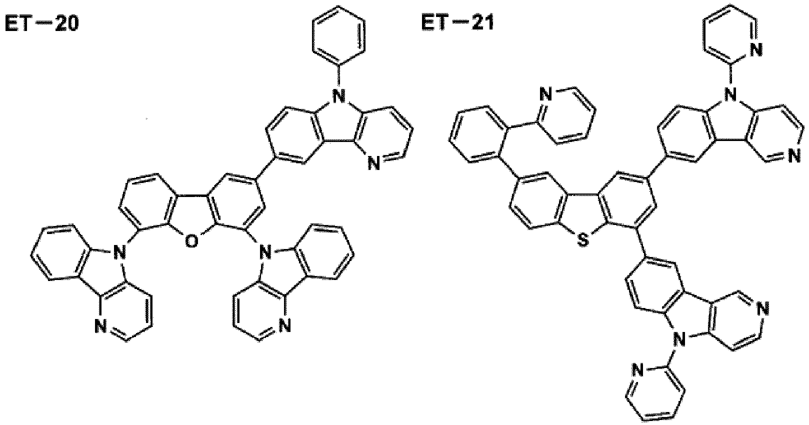

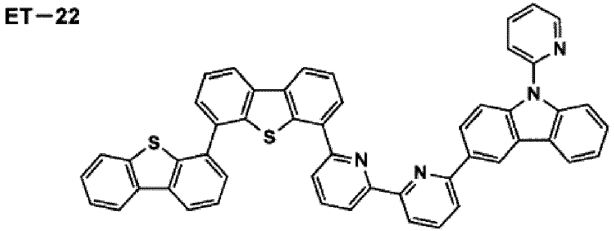

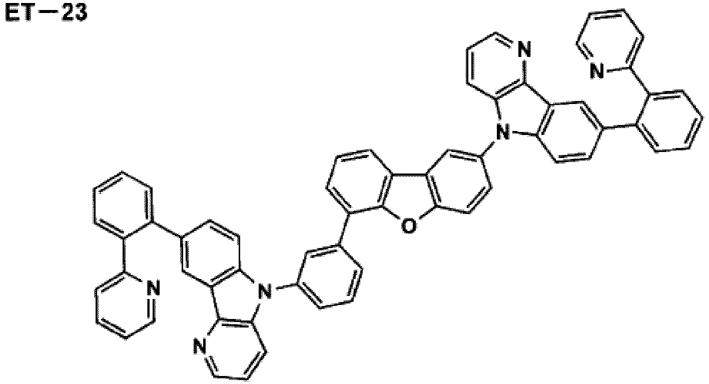

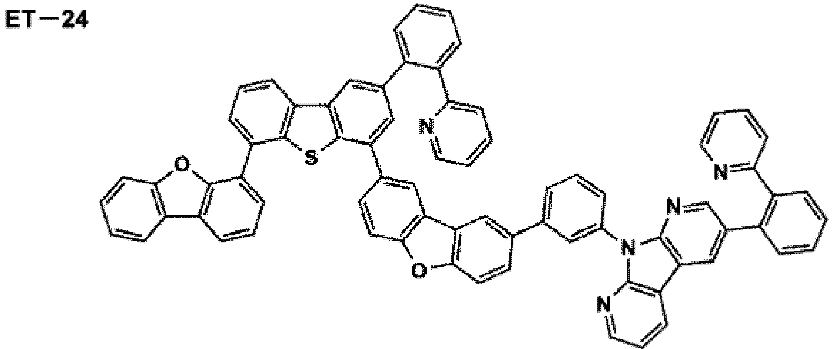

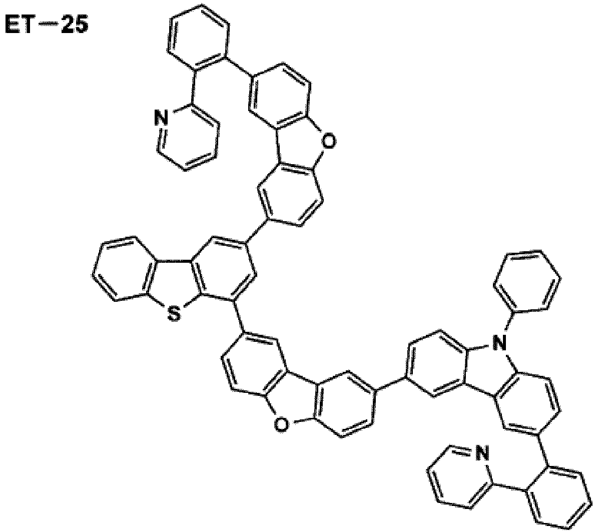

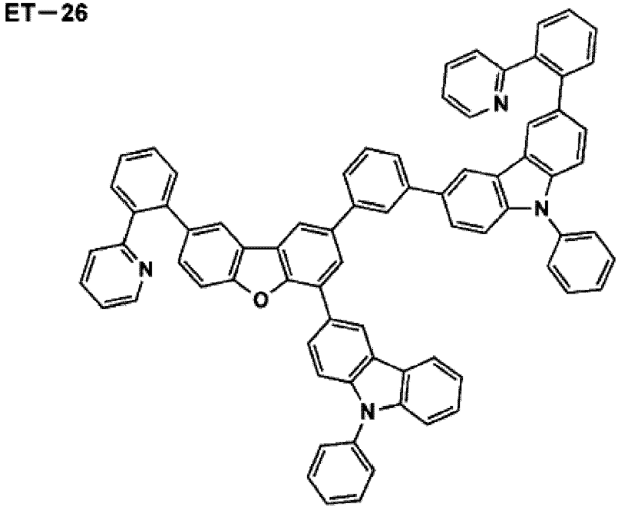

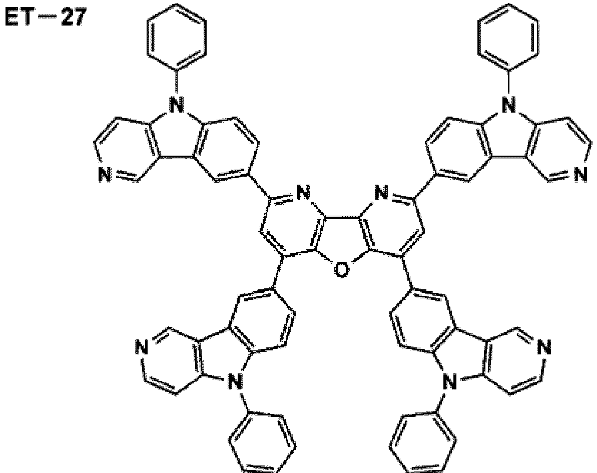

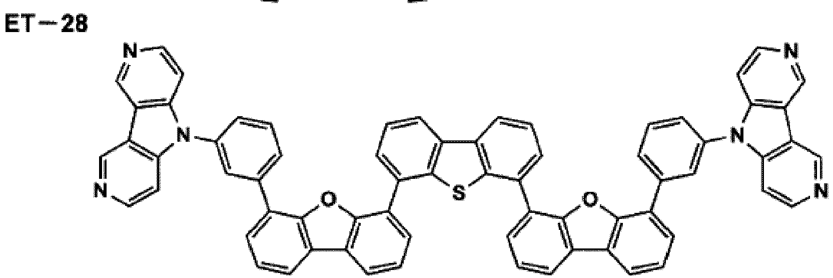

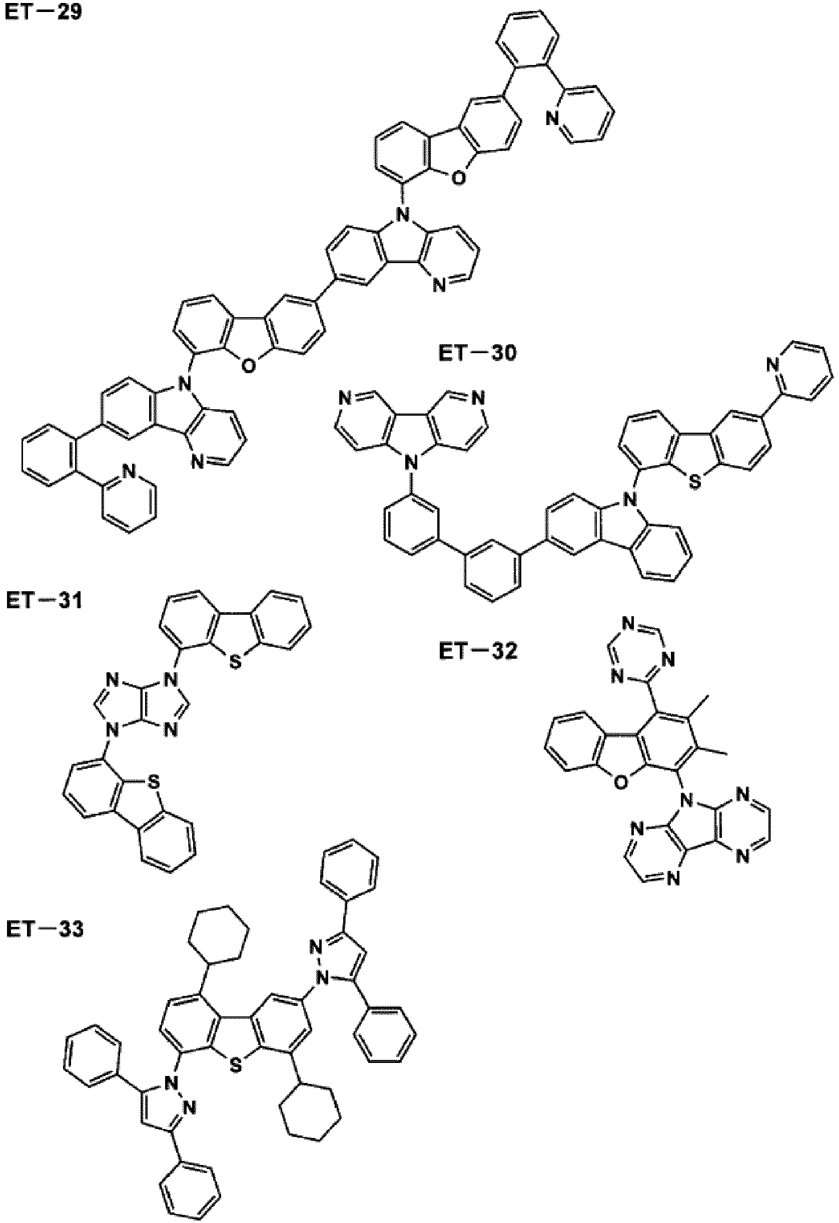

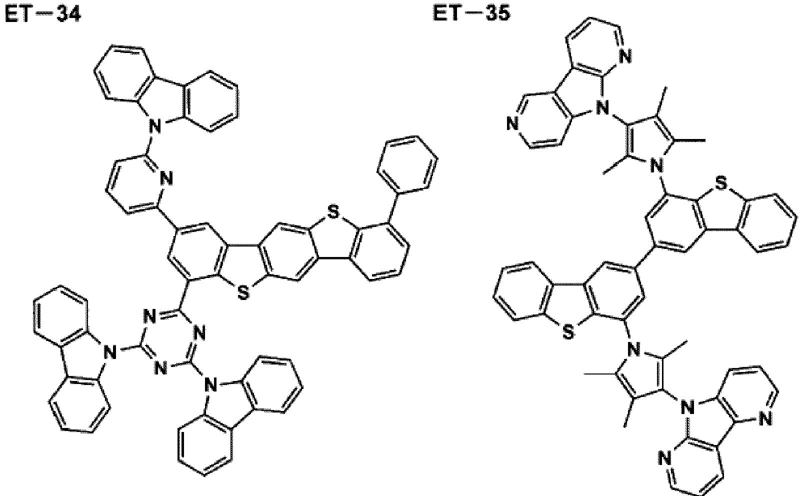

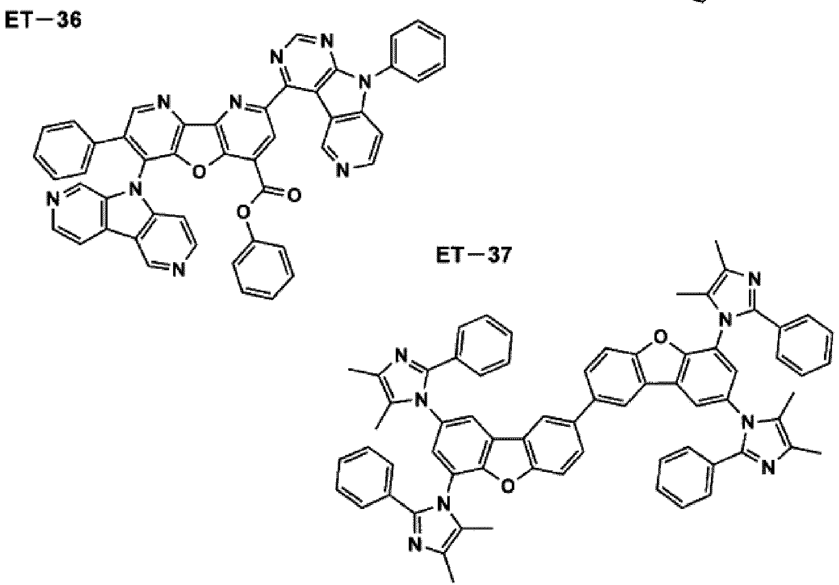

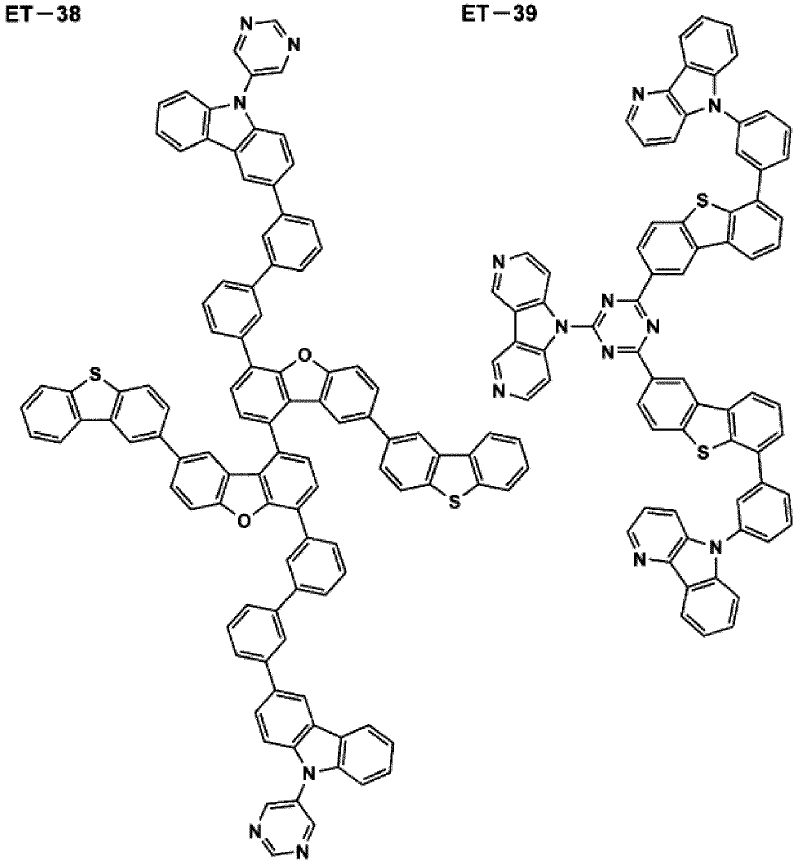

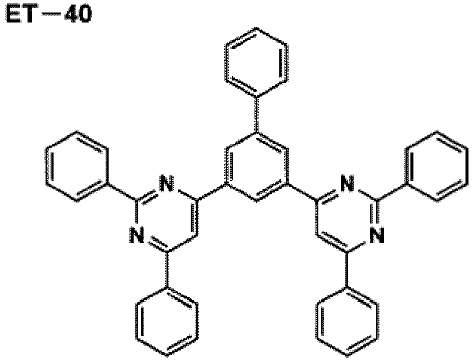

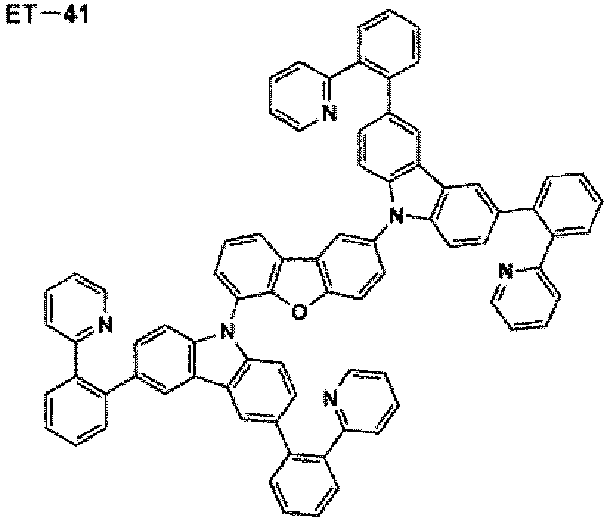

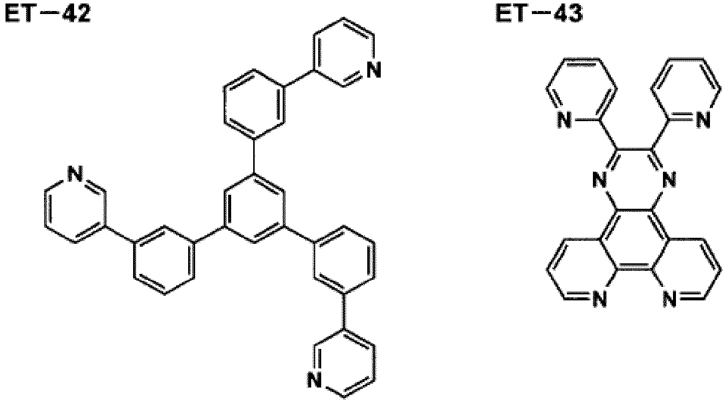

### <<Negative electrode>>

On the other hand, regarding the negative electrode, an electrode formed from a metal having a small work function (4 eV or less) (referred to as an electron injecting metal), an alloy, an electrically conductive compound, or a mixture thereof as the electrode material is used. Specific examples of such an electrode material include sodium, a sodium-potassium alloy, magnesium, lithium, a magnesium/copper mixture, a magnesium/silver mixture, a magnesium/aluminum mixture, a magnesium/indium mixture, an aluminum/aluminum oxide (Al₂O₃) mixture, indium, a lithium/aluminum mixture, and rare earth metals. Among these, from the viewpoint of electron injectability and durability against oxidation or the like, mixtures of an electron injecting metal and a second metal which is a stable metal having a larger value of the work function than the electron injecting metal, for example, a magnesium/silver mixture, a magnesium/aluminum mixture, a magnesium/indium mixture, an aluminum/aluminum oxide (Al₂O₃) mixture, a lithium/aluminum mixture, and aluminum, are suitable.

The negative electrode can be produced by forming a thin film of such an electrode material by a method such as vapor deposition or sputtering. Furthermore, the sheet resistance as the negative electrode is preferably several hundred Ω/□ or less, and the film thickness is usually selected in the range of 10 nm to 5 µm, and preferably 50 nm to 200 nm.

Meanwhile, in order to transmit the emitted light, when any one of the positive electrode or the negative electrode of the organic EL element is transparent or semi-transparent, the emission luminance is increased, which is suitable.

Furthermore, a transparent or semi-transparent negative electrode can be produced by producing the aforementioned metal into a negative electrode having a film thickness of 1 nm to 20 nm, and then producing thereon an electroconductive transparent material mentioned in the explanation on the positive electrode as described below. When this is applied, an element having light transmission properties on both the positive electrode and the negative electrode can be produced.

### <<Injection layer: electron injection layer (negative electrode buffer layer) and hole injection layer>>

The injection layer is provided as necessary, and there are available an electron injection layer and a hole injection layer . The injection layer may be provided between the positive electrode and the light emitting layer or the hole transport layer, and between the negative electrode and the light emitting layer or the electron transport layer as described above.

An injection layer is a layer provided between an electrode and an organic layer for the purpose of decreasing the driving voltage or enhancing the emission luminance, and the details thereof are described in "Organic EL Elements and Frontiers of Industrialization Thereof (published on November 30, 1998 by NTS, Inc.)", Vol. 2, Chapter 2, "Electrode Materials" (pp. 123-166). There are available a hole injection layer (positive electrode buffer layer) and an electron injection layer (negative electrode buffer layer).

Regarding the positive electrode buffer layer (hole injection layer), the details are described in JP H09-045479 A, JP H09-260062 A, JP H08-288069 A and the like, and specific examples thereof include a phthalocyanine buffer layer represented by copper phthalocyanine; a hexaazatriphenylene derivative buffer layer described in JP 2003-519432 A, JP 2006-135145 A and the like; an oxide buffer layer represented by vanadium oxide; an amorphous carbon buffer layer; a polymer buffer layer using an electroconductive polymer such as polyaniline (emeraldine) or polythiophene; and an ortho-metalated complex layer represented by a tris(2-phenylpyridine)iridium complex or the like.

Regarding the negative buffer layer (electron injection layer), the details are described in JP H06-325871 A, JP H09-017574 A, JP H10-074586 A, and the like, and specific examples thereof include a metal buffer layer represented by strontium, aluminum or the like; an alkali metal compound buffer layer represented by lithium fluoride or potassium fluoride; an alkaline earth metal compound buffer layer represented by magnesium fluoride or cesium fluoride; and an oxide buffer layer represented by aluminum oxide. The buffer layer (injection layer) is desirably a very thin film, and although the film thickness may vary depending on the material, the film thickness is preferably in the range of 0.1 nm to 5 µm.

### <<Blocking layer: hole blocking layer and electron blocking layer>>

The blocking layer is a layer provided as necessary in addition to the basic constituent layers of the organic compound thin films as described above. For example, there are available the hole blocking layers described in JP H11-204258 A, JP H11-204359 A, and "Organic EL Elements and Frontiers of Industrialization Thereof (published on November 30, 1998 by NTS, Inc.)", p. 237.

The hole blocking layer has the function of the electron transport layer in a wide sense, and is formed from a hole blocking material which has markedly low ability to transport holes while having a function of transporting electrons. Thus, the probability of recombination of electrons and holes can be increased by blocking holes while transporting electrons.

Also, if necessary, the configuration of the electron transport layer described above can be used as the hole blocking layer related to the present invention.

The hole blocking layer of the organic EL element of the present invention is preferably provided adjacently to the light emitting layer.

It is preferable that the hole blocking layer contains a carbazole derivative, a carboline derivative, or a diazacarbazole derivative (here, the diazacarbazole derivative means a compound in which any one of the carbon atoms that constitute a carboline ring has been substituted by a nitrogen atom), which are described above as host compounds.

Furthermore, according to the present invention, in a case in which an organic EL element has plural light emitting layers having different emitted light colors, it is preferable that the light emitting layer having the shortest maximum emission wavelength is closest to the positive electrode among all the light emitting layers. However, in this case, it is preferable to additionally provide a hole blocking layer between the shortest wavelength layer and the light emitting layer that is second closest to the positive layer next to the shortest wavelength layer. Furthermore, it is preferable that 50% by mass or more of the compounds contained in the hole blocking layer that is provided in that position has an ionization potential larger by 0.3 eV or more relative to the host compound of the shortest wavelength light emitting layer.

The ionization potential is defined as the energy required for releasing electrons in the HOMO (highest occupied molecular orbital) level to the vacuum level, and can be determined by, for example, methods described below.
(1) The ionization potential can be determined as a value (value calculated in terms of unit eV) calculated by performing structural optimization using Gaussian98 (Gaussian98, Revision A.11.4, M.J. Frisch, et al., Gaussian, Inc., Pittsburgh PA, 2002) which is a software for calculating molecular orbitals manufactured by GAUSSIAN (US) and using B3LYP/6-31G* as the keyword. This calculated value is effective because there is a high correlation between the calculated values determined by this technique and the experimental values.
(2) The ionization potential can also be determined by a method of directly measuring the value by a photoelectron spectrometric method. For example, a method otherwise known as ultraviolet electron spectrometry can be suitably used by using a low energy electron spectrometric apparatus "Model AC-1" manufactured by Riken Keiki Co., Ltd.

On the other hand, the electron blocking layer has the function of hole transport layer in a wide sense, and is formed from a material which has markedly low ability to transport electrons while having a function of transporting holes. Thus, the probability of recombination of electrons and holes can be increased by blocking electros while transporting holes.

Furthermore, if necessary, the configuration of the hole transport layer that will be described below can be used as an electron blocking layer. The film thickness of the hole blocking layer and the electron transport layer related to the present invention is preferably 3 nm to 100 nm, and more preferably 5 nm to 30 nm.

### <<Hole transport layer>>

The hole transport layer is formed from a hole transporting material having a function of transporting holes, and in a wide sense, a hole injection layer and an electron blocking layer are also included in the hole transport layer. The hole transport layer can be provided as a single layer or as plural layers.

The hole transporting material is a material having any of the properties of injecting or transporting of holes or electron barrier properties, and may be any one of an organic material or an inorganic material. Examples thereof include triazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, oxazole derivatives, styrylanthracene derivatives, fluorenone derivatives, hydrazone derivatives, stilbene derivatives, silazane derivatives, aniline-based copolymers, and electroconductive high molecular weight oligomers, particularly thiophene oligomers.

Furthermore, the azatriphenylene derivatives described in JP 2003-519432 A, JP 2006-135145 A and the like can also be used as hole transporting materials as such.

Regarding the hole transporting material, the materials described above can be used, but it is preferable to use a porphyrin compound, an aromatic tertiary amine compound, and a styrylamine compound, particularly an aromatic tertiary amine compound.

Representative examples of the aromatic tertiary amine compound and the styrylamine compound include N,N,N',N'-tetraphenyl-4,4'-diaminophenyl; N,N'-diphenyl-N,N'-bis(3-methylpheny)-[1,1'-biphenyl]-4,4'-diamine (TPD); 2,2-bis(4-di-p-tolylaminophenyl)propane; 1,1-bis(4-di-p-tolylaminophenyl)cyclohexane; N,N,N',N'-tetra-p-tolyl-4,4'-diaminobiphenyl; 1,1-bis(4-di-p-tolylaminophenyl)-4-phenylcyclohexane; bis(4-dimethylamino-2-methylphenyl)phenylmethane; bis(4-di-p-tolylaminophenyl)phenylmethane; N,N'-diphenyl-N,N'-di(4-methoxyphenyl)-4,4'-diaminobiphenyl ; N,N,N',N'-tetraphenyl-4,4'-diaminodiphenyl ether; 4,4'-bis(diphenylamino)quadriphenyl; N,N,N-tri(p-tolyl)amine; 4-(di-p-tolylamino)-4'-[4-(di-p-tolylamino)styryl]stilbene; 4-N,N'-diphenylamino-(2-diphenylvinyl)benzene; 3-methoxy-4'-N,N-diphenylaminostilbene; and N-phenylcarbazole. Further examples include compounds having two fused aromatic rings in the molecule as described in US 5,061,569 A, for example, 4,4'-bis[N-(1-naphthyl)-N-phenylamino]biphenyl (NPD); and 4,4',4"-tris[N-(3-methylphenyl)-N-phenylamino]triphenylamin e (MTDATA) in which three triphenylamine units are linked in a starburst form, as described in JP H04-308688 A.

Furthermore, polymeric materials having these materials introduced into the polymer chain, or polymeric materials containing these materials in the main chain of the polymer can also be used.

Furthermore, inorganic compounds such as p-type Si and p-type SiC can also be used as the hole injecting material and the hole transporting material.

Furthermore, the so-called p-type hole transporting material described in JP H11-251067 A and literature published by J. Huang et al. (Applied Physics Letters, 80 (2002), p. 139) can also be used. In the present invention, it is preferable to use these materials since luminescent elements having higher efficiency may be obtained.

The hole transport layer can be formed by forming a thin film of the hole transporting material described above by a known method such as, for example, a vacuum deposition method, a spin coating method, a casting method, a printing method including an inkjet method, or an LB method.

There are no particular limitations on the film thickness of the hole transport layer, but the film thickness is usually about 5 nm to 5 µm, and preferably 5 nm to 200 nm. This hole transport layer may have a single-layer structure formed from one kind or two or more kids of the materials described above.

Furthermore, a hole transport layer doped with impurities and having high p-type properties can also be used. Examples thereof include the hole transport layers described in JP H04-297076 A, JP 2000-196140 A, JP 2001-102175 A and the like, and J. Appl. Phys., 95, 5773 (2004).

According to the present invention, it is preferable to use such a hole transport layer having high p-type properties, because a lower power-consuming element can be produced.

### <<Positive electrode>>

Regarding the positive electrode in an organic EL element, a positive electrode employing a metal having a high work function (4 eV or more), an alloy, an electrically conductive compound, or a mixture thereof as the electrode material is preferably used. Specific examples of such an electrode material include metals such as Au; and electroconductive transparent materials such as CuI, indium tin oxide (ITO), SnO₂, and ZnO.

Furthermore, a material which can be used to produce an amorphous transparent conductive film, such as IDIXO (In₂O₃-ZnO), may also be used. For the positive electrode, a thin film of such an electrode material may be formed by a technique such as vapor deposition or sputtering, and a pattern having a desired shape may be formed a photolithographic method. Alternatively, in a case in which pattern accuracy is not much necessary (about 100 µm or more), a pattern may be formed by interposing a mask having a desired shape at the time of vapor deposition or sputtering of the electrode material.

Alternatively, in the case of using a coatable material such as an organic electroconductive compound, a wet film forming method such as a printing system or a coating system can also be used. When emitted light is extracted from this positive electrode, it is desirable to adjust the transmittance to be higher than 10%, and the sheet resistance of the positive electrode is preferably several hundred Ω/□ or less. Furthermore, the film thickness may vary depending on the material, but the film thickness is usually selected in the range of 10 nm to 1000 nm, and preferably 10 nm to 200 nm.

### <<Supporting substrate>>

Regarding the supporting substrate (hereinafter, also called a base, a substrate, a base material, a support or the like) that can be used in the organic EL element of the present invention, there are no particular limitations on the kind of glass, plastics and the like, and the supporting substrate may be transparent or may be opaque. In the case of extracting light through the supporting substrate side, it is preferable that the supporting substrate is transparent. Examples of a transparent supporting substrate that is preferably used include glass, quartz, and a transparent resin film. A particularly preferred supporting substrate is a resin film capable of imparting flexibility to the organic EL element.

Examples of the resin film include films of polyesters such as polyethylene terephthalate (PET) and polyethylene naphthalate (PEN); polypropylene, Cellophane; cellulose esters and derivatives thereof, such as cellulose diacetate, cellulose triacetate, cellulose acetate butyrate, cellulose acetate propionate (CAP), cellulose acetate phthalate (TAC), and cellulose nitrate; polyvinylidene chloride, polyvinyl alcohol, polyethylene vinyl alcohol, syndiotactic polystyrene, polycarbonate, a norbornene resin, polyethylenepentene, polyether ketone, polyimide, polyether sulfone (PES), polyphenylene sulfide, a polysulfone, polyether imide, polyether ketone imide, polyamide, a fluororesin, nylon, polymethyl methacrylate, acrylic or polyallylate; a cycloolefin-based resin such as ARTON (trade name, manufactured by JSR Corp.) or APEL (trade name, manufactured by Mitsui Chemicals, Inc.).

On the surface of the resin film, a coating film of an inorganic material or an organic material, or a hybrid coating film of the two materials may be formed. The coating film is preferably a barrier film having a water vapor permeability (25 ± 0.5°C, relative humidity (90 ± 2)%RH) measured by the method according to JIS K 7129-1992 of 0.01 g/(m²·24 h) or less, and more preferably a high barrier film having an oxygen permeability measured according to JIS K 7126-1987 of 10⁻³ ml/ (m²·24 h·atm) or less, and a water vapor permeability of 10⁻⁵ g/ (m²·24 h) or less.

The material that forms the barrier film may be any material having a function of suppressing the penetration of substances that cause deterioration of the element, such as moisture and oxygen, and for example, silicon oxide, silicon dioxide, and silicon nitride can be used. Furthermore, in order to ameliorate fragility of the film, it is more preferable to provide a laminated structure of these inorganic layers and layers formed from organic materials. There are no particular limitations on the lamination order of the inorganic layers and the organic layers, but it is preferable to alternately laminate the two kinds of layers plural times.

There are no particular limitations on the method of forming a barrier film, and for example, a vacuum deposition method, a sputtering method, a reactive sputtering method, a molecular beam epitaxy method, a cluster ion beam method, an ion plating method, a plasma polymerization method, an atmospheric pressure plasma polymerization method, a plasma CVD method, a laser CVD method, a thermal CVD method, and a coating method can be used. However, it is particularly preferable to follow the atmospheric pressure plasma polymerization method described in JP 2004-068143 A.

Examples of opaque supporting substrate include metal plates of aluminum, stainless steel and the like, films or opaque resin substrates, and ceramic substrates.

The external extraction efficiency at room temperature of the light emitted by the organic EL element of the present invention is preferably 1% or higher, and more preferably 5%or higher.

Here, external extraction quantum efficiency (%) = number of quanta emitted to the outside of the organic EL element / number of electrons flowed to the organic EL element × 100

Furthermore, a color improving filter such as a color filter, or the like may be used in combination, or a color conversion filter that changes the color of the light emitted from the organic EL element into multiple colors using a fluorescent body, may also be used in combination. In the case of using a color conversion filter, the λmax of the emitted light of the organic EL element is preferably 480 nm or less.

### <<Method for producing organic EL element>>

As an example of the method for producing an organic EL element, a method for producing an element composed of positive electrode/hole injection layer/hole transport layer/light emitting layer/hole blocking layer/electron transport layer/negative electrode buffer layer (electron injection layer)/negative electrode will be explained.

First, a positive electrode is produced by forming a thin film formed from a desired electrode material, for example, a material for positive electrode, on an appropriate base to obtain a film thickness of 1 µm or less, and preferably 10 nm to 200 nm.

Next, thin films containing organic compounds for a hole injection layer, a hole transport layer, a light emitting layer, a hole blocking layer, an electron transport layer, a negative electrode buffer layer, and the like, which are element materials, are formed on the positive electrode.

Regarding the method for forming thin films, for example, thin films can be formed by forming a film by, for example, a vacuum deposition method or a wet method (also called a wet process).

Examples of the wet method include a spin coating method, a casting method, a die coating method, a blade coating method, a roll coating method, an inkjet method, a printing method, a spray coating method, a curtain coating method, and an LB method. However, from the viewpoint that a precise thin film can be formed, and high productivity is obtained, methods having high suitability to a roll-to-roll system, such as a die coating method, a roll coating method, an inkjet method, and a spray coating method, are preferred. Also, different film forming methods may be applied to different layers.

Regarding the liquid medium that dissolves or disperses the organic EL materials related to the present invention, for example, ketones such as methyl ethyl ketone and cyclohexanone; fatty acid esters such as ethyl acetate; halogenated hydrocarbons such as dichlorobenzene; aromatic hydrocarbons such as toluene, xylene, mesitylene, and cyclohexylbenzene; aliphatic hydrocarbons such as cyclohexane, decalin, and dodecan; and organic solvents such as DMF and DMSO, can be used.

Furthermore, regarding the dispersing method, dispersing can be performed by dispersing methods such as ultrasonic dispersing, high shear dispersing, and medium dispersing.

After the formation of these layers, a negative electrode is provided by forming thereon a thin film formed from a material for negative electrode to have a film thickness of 1 µm or less, and preferably in the range of 50 to 200 nm. Thereby, a desired organic EL element was obtained.

Furthermore, it is also possible to reverse the order and to produce a negative electrode, a negative electrode buffer layer, an electron transport layer, a hole blocking layer, a light emitting layer, a hole transport layer, a hole injection layer, and a positive electrode in this order.

In regard to the production of the organic EL element of the present invention, it is preferable to produce from the hole injection layer to the negative electrode by drawing a vacuum once; however, it is also acceptable to apply other film forming methods by taking out the organic EL element in the middle. At that time, it is preferable to perform the operation in a dry inert gas atmosphere.

### <<Sealing>>

Regarding the means for sealing used in the present invention, for example, a method of adhering a sealing member, electrodes, and a supporting substrate using an adhesive may be used.

It is desirable if the sealing member is disposed so as to cover the display region of the organic EL element, and the sealing member may have a recessed plate or may be a flat plate. Furthermore, transparency and electrical insulating properties do not matter particularly.

Specific examples thereof include a glass plate, a polymer plate film, and a metal plate film. Particularly, examples of the glass plate include soda lime glass, barium-strontium-containing glass, lead glass, aluminosilicate glass, borosilicate glass, barium borosilicate glass, and quartz.

Furthermore, examples of the polymer plate include plates formed from polycarbonate, acrylic, polyethylene terephthalate, polyether sulfide, and polysulfone.

Examples of the metal plate include plates formed from one or more kinds of metals or alloys selected from the group consisting of stainless steel, iron, copper, aluminum, magnesium, nickel, zinc, chromium, titanium, molybdenum, silicon, germanium, and tantalum.

According to the present invention, a polymer film or a metal film can be preferably used, since the element can be made to be like a thin film.

Furthermore, the polymer film is preferably a film having an oxygen permeability measured by the method according to JIS K 7126-1987 of 1 × 10⁻³ ml/ (m²·24 h·atm) or less, and a water vapor permeability (25 ± 0.5°C, relative humidity (90 ± 2)%RH) measured by the method according to JIS K 7129-1992 of 1 × 10⁻³ g/ (m²·24 h) or less.

For the processing of the sealing member into a recessed state, sand blast processing, chemical etching processing or the like is used.

Specific examples of the adhesive include photocurable and thermally curable adhesives having reactive vinyl groups of acrylic acid-based oligomers or methacrylic acid-based oligomers; and moisture-curable adhesives such as 2-cyanoacrylic acid esters. Further examples include thermal and chemical-curable (two-liquid mixture) adhesives such as epoxy-based adhesives. Further examples include polyamides, polyesters and polyolefins of hot melt type. Further examples include ultraviolet-curable epoxy resin adhesives of cation-curable type.

Meanwhile, since there are occasions in which the organic EL element may be deteriorated by a heat treatment, an adhesive capable of adhering and curing from room temperature to 80°C. Furthermore, a desiccant may be dispersed in the adhesive. Application of the adhesive to sealing areas may be carried out using a commercially available dispenser, or may be printed as in the case of screen printing.

Furthermore, forming on the outer side of the electrode on the side opposite to the supporting substrate across the organic layers, a layer of an inorganic material or an organic material that covers the electrode and the organic layers in the form of adjoining the supporting substrate, and using this as a sealing membrane, can also be suitably employed. In this case, the material that forms the film may be any material having a function of suppressing the penetration of substances that cause deterioration of the element, such as moisture and oxygen, and for example, silicon oxide, silicon dioxide, and silicon nitride can be used.

Furthermore, in order to ameliorate fragility of the film, it is preferable to apply a laminated structure of these inorganic layers and layers formed from organic materials . There are no particular limitations on the method of forming these films, and for example, a vacuum deposition method, a sputtering method, a reactive sputtering method, a molecular beam epitaxy method, a cluster ion beam method, an ion plating method, a plasma polymerization method, an atmospheric pressure plasma polymerization method, a plasma CVD method, a laser CVD method, a thermal CVD method, and a coating method can be used.

In a gas phase and a liquid phase, it is preferable to inject an inert gas such as nitrogen or argon, or an inert liquid such as a fluorinated hydrocarbon or silicone oil, in to the gap between the sealing member and the display region of the organic EL element. It is also possible to maintain a vacuum therein. Also, a hygroscopic compound may be encapsulated in the interior.

Examples of the hygroscopic compound include metal oxides (for example, sodium oxide, potassium oxide, calcium oxide, barium oxide, magnesium oxide, and aluminum oxide), sulfuric acid salts (for example, sodium sulfate, calcium sulfate, magnesium sulfate, and cobalt sulfate), metal halides (for example, calcium chloride, magnesium chloride, cesium fluoride, tantalum fluoride, cerium bromide, magnesium bromide, barium iodide, and magnesium iodide), and perchloric acids (for example, barium perchlorate and magnesium perchlorate). For sulfuric acid salts, metal halides and perchloric acids, anhydrous salts are suitably used.

### <<Protective film and protective plate>>

On the outer side of the sealing membrane or the film for sealing on the side opposite to the supporting substrate across the organic layers, a protective film or a protective plate may be provided in order to increase the mechanical strength of the element. Particularly, in a case in which sealing is achieved by the sealing membrane, since the mechanical strength is not necessarily high, it is preferable to provide such a protective film or a protective plate. Regarding the material that can be used for this, the same glass plate, polymer plate film, metal plate film, and the like as those used for sealing as described above can be used, but it is preferable to use a polymer film from the viewpoint of weight reduction and thickness reduction.

### <<Light extraction>>

It is generally said that an organic EL element emits light in the interior of a layer having higher refractive index than that of air (the refractive index is about 1.7 to 2.1), and only about 15% to 20% of light out of the light generated in the light emitting layer can be extracted. This is because any light entering to the interface (interface between a transparent substrate and air) at angle θ, which is larger than or equal to the critical angle, undergoes total reflection and thus cannot be extracted to the outside of the element, or because light undergoes total reflection between a transparent electrode or a light emitting layer and a transparent substrate, light is wave-guided through the transparent electrode or the light emitting layer, and as a result, light escapes in the direction of the lateral side of the element.

Examples of the technique of increasing the efficiency of this light extraction include a method of forming surface unevenness on the transparent substrate surface and preventing total reflection at the interface between the transparent and air (US Patent No. 4,774,435 A); a method of increasing the efficiency by imparting light-harvesting properties to the substrate (JP S63-314795 A); a method of forming a reflective surface on the lateral surfaces of the element or the like (JP H01-220394 A); a method of introducing a flattening layer having an intermediate refractive index between the substrate and a luminescent body, and forming an antireflective film (JP S62-172691 A); a method of introducing a flattening layer having a lower refractive index than that of the substrate, between the substrate and a luminescent body (JP 2001-202827 A); and a method of forming a diffraction lattice between any of the layers (included, between the substrate and an external system) such as the substrate, a transparent electrode layer and a light emitting layer (JP H11-283751 A).

According to the present invention, these methods can be used in combination of the organic EL element of the present invention. However, a method of introducing a flattening layer having a lower refractive index than that of the substrate between the substrate and a luminescent body, or a method of forming a diffraction lattice between any of the layers (included, between the substrate and an external system) such as the substrate, a transparent electrode layer and a light emitting layer, can be suitably used.

In the present invention, an element having high luminance or excellent durability can be obtained by combining these means.

When a medium having a low refractive index is formed at a thickness longer than the wavelength of light between a transparent electrode and a transparent substrate, in regard to the light coming out from the transparent electrode, as the refractive index of the medium is lower, the efficiency of extraction to the outside is increased.

Examples of the low refractive index layer include layers of an aerogel, porous silica, magnesium fluoride, and a fluorine-based polymer. Since the refractive index of the transparent substrate is generally about 1.5 to 1.7, it is preferable that the refractive index of the low refractive index layer is approximately 1.5 or less, and more preferably 1.35 or less.

Furthermore, it is desirable that the thickness of the low refractive index medium is two or more times the wavelength in the medium. This is because when the thickness of the low refractive index medium is adjusted to about the wavelength of light, and reaches a film thickness at which electromagnetic waves that have been evanescently leaked out infiltrate into the substrate, the effect of the low refractive index layer fades out.

The method of introducing a diffraction lattice into the interface that causes total reflection or into any one of the media, is characterized in that the effect of increasing the light extraction efficiency is high. This method involves diffracting light by introducing a diffraction lattice between any of the layers or within the medium (inside the transparent substrate or inside transparent electrode), which light cannot be extracted by total reflection between layers or the like among the light generated from the light emitting layer, by utilizing the property of changing the direction of light to a particular direction different from refraction as a result of the so-called Bragg diffraction in which the diffraction lattice is primary diffraction or secondary diffraction, and extracting the light out.

It is desirable that the diffraction lattice to be introduced has a two-dimensional periodic refractive index. In this regard, since the light emitted from the light emitting layer is generated randomly in all directions, in a general one-dimensional diffraction lattice having a periodic refractive index distribution in a certain direction only, only the light that travels in a particular direction is diffracted, and the light extraction efficiency does not increase so much.

However, when a two-dimensional distribution is adopted for the refractive index distribution, light that travels in all directions is diffracted, and the light extraction efficiency is increased.

The position for introducing the diffraction lattice may be between any of the layers or within the medium (inside a transparent substrate or inside a transparent electrode) as described above; however, the vicinity of the organic light emitting layer, which is the place where light is generated, is desirable.

At this time, the period of the diffraction lattice is preferably about 1/2 to 3 times the wavelength of light in the medium.

The arrangement of the diffraction lattice is preferably such that the arrangement is two-dimensionally repeated, such as a square lattice shape, a triangular lattice shape, or a honeycomb lattice shape.

### <<Light condensing sheet>>

The organic EL element of the present invention can increase the luminance in a particular direction, by fabricating the element so as to provide, for example, a microlens array-like structure on the light extraction side of the substrate, or by combining with a so-called light condensing sheet, and thereby condensing light in a particular direction, for example, in the front direction with respect to the light emitting surface of the element.

As an example of a microlens array, pyramids each measuring 30 µm on one side and having a vertical angle of 90° are arranged two-dimensionally on the light extraction side of the substrate. The length of one side is preferably 10 µm to 100 µm. If the length is smaller than this, a diffracting effect occurs, and the substrate is colored. If the length is too large, the thickness is increased, which is not preferable.

Regarding the light condensing sheet, for example, those light condensing sheets that are practically used in the LED backlight of liquid crystal display devices can be used. For example, a brightness enhancing film (BEF) manufactured by Sumitomo 3M, Ltd. or the like can be used as such a sheet.

Regarding the shape of the prism sheet, for example, Δ-shaped stripes having a vertical angle of 90° and a pitch of 50 µm formed on the base material may be employed, or a shape in which the vertical angle is rounded, a shape in which the pitch is randomly varied, or any other shape may also be employed.

Also, in order to control the light radiation angle from the luminescent element, a light diffusion plate film may be used in combination with the light condensing sheet. For example, a diffusion film manufactured by Kimoto Co., Ltd. (LIGHT-UP) can be used.

### <<Applications>>

The organic EL element of the present invention can be used as display devices, displays, and various light emitting sources. Examples of the light emitting sources include lighting devices (domestic lighting and in-vehicle lighting), backlight for timepieces or liquid crystal devices, advertising signboards, traffic signals, light sources of optical storage media, light sources of electrophotographic copying machines, light sources of optical communication processors, and light sources of optical sensors. Although the organic EL element of the present invention is not limited to these, the organic EL element can be effectively used in the applications as the backlight of liquid crystal display devices and the light source for lighting.

The organic EL element of the present invention may also be provided with patterning as necessary at the time of film formation, by using a metal mask or by an inkjet printing method. When patterning is performed, only the electrodes may be subjected to patterning, the electrodes and the light emitting layer may be patterned, or all the layers of the element may be patterned. For the production of the element, conventionally known methods can be used.

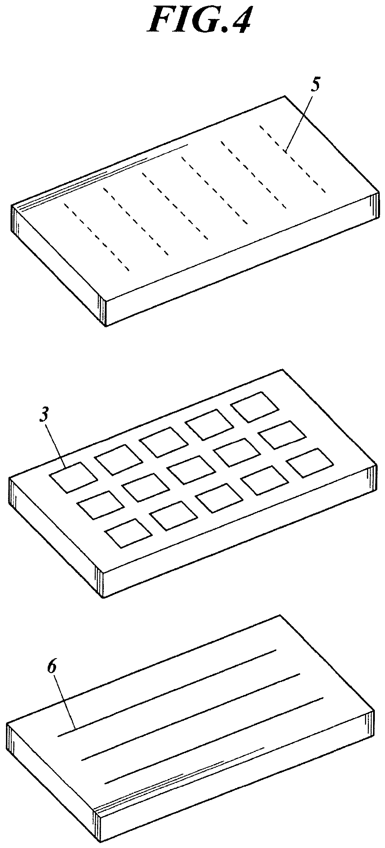

The color of the emitted light of the organic EL element of the present invention or the compound related to the present invention is determined as the color obtainable by applying the results of measurement made using a spectral radiance luminance meter CS-1000 (manufactured by Konica Minolta Sensing, Inc.) to the CIE chromaticity coordinates in Fig. 4.16 in "Shinpen Shikisai Kagaku Handobuku (New Edition Color Science Handbook)" (edited by the Color Science Association of Japan, University of Tokyo Press, 1985), p. 108.

Furthermore, when the organic EL element of the present invention is a white color element, the white color means that when the front luminance at a viewing angle of 2° is measured by the method described above, the chromaticity in the CIE1931 colorimetric system at 1000 cd/m² is in the region of X = 0.33 ± 0.07 and Y = 0.33 ± 0.1.

### <<Display device>>

The display device of the present invention will be explained. The display device of the present invention includes the organic EL element of the present invention. The display device of the present invention may be monochromatic or polychromatic, but in this specification, a polychromatic display device will be explained.

In the case of a polychromatic display device, a shadow mask is provided only at the time of forming the light emitting layer, a film can be formed on one surface by a vapor deposition method, a casting method, a spin coating method, an inkjet method a printing method, or the like.

The configuration of the organic EL element included in the display device is selected among the configuration examples of the organic EL element described above, as necessary.

Furthermore, the method for producing the organic EL element is as described above for one embodiment of the production of the organic EL element of the present invention.

In the case of applying a direct current voltage to the polychromatic display device obtained in this manner, light emission can be observed when a voltage of about 2 V to 40 V is applied while taking the positive electrode as positive polarity and the negative electrode as negative polarity. If a voltage is applied in reverse polarities, no electric current flows, and light emission does not occur at all. Furthermore, when an alternating current voltage is applied, light emission occurs only when the positive electrode has positive polarity and the negative electrode has negative polarity. The waveform of the alternating current that is applied may be arbitrary.

A polychromatic display device can be used as display devices, displays, and various light emitting sources. Full color display is enabled by using three kinds of organic EL elements of blue, red and green light emissions in the display devices and displays.

Examples of the display devices and displays include televisions, personal computers, mobile equipment, AV equipment, teletext displays, in-vehicle information displays. Particularly, the display devices and displays may be used as display devices that reproduce static images or video images, and in the case of using them as display devices for video image reproduction, the driving system may be any of a simple matrix (passive matrix) system or an active matrix system.

Examples of the light emitting sources include domestic lighting, in-vehicle lighting, backlight for timepieces and liquid crystal displays, advertising signboards, traffic signals, light sources of optical storage media, light sources of electrophotographic copying machines, light sources of optical communication processors, and light sources of optical sensors. However, the present invention is not intended to be limited to these.

Hereinbelow, an example of the display device having the organic EL element of the present invention will be described based on the drawings.

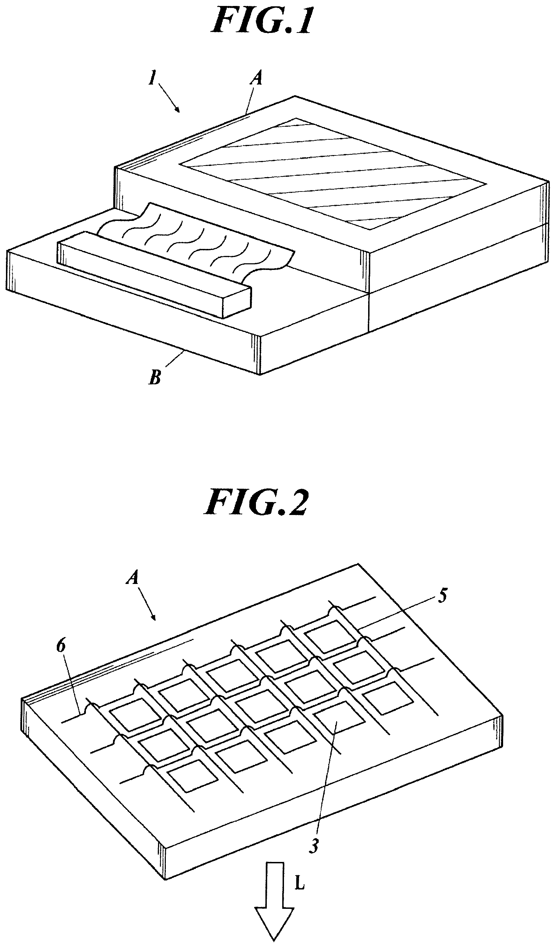

Fig. 1 is a schematic diagram illustrating an example of a display device configured to include an organic EL element. It is a schematic diagram of, for example, the display of a mobile telephone or the like that implements display of image information by means of the light emission of the organic EL element.

A display 1 includes a display unit A having plural pixels, and a control unit B that performs image scanning of the display unit A based on the image information, and the like.

The control unit B is electrically connected to the display unit A, and transmits scan signal and image data signal based on the image information sent from the outside of each of the plural pixels. Then, the pixels of each scan line are caused to sequentially emit light by the scan signal according to the image data signal, thereby image scan is carried out, and thereby the image information is displayed in the display unit A.

Fig. 2 is a schematic diagram of the display unit A.

The display unit A has a wiring unit including a scan line 5 and plural data lines 6, plural pixels 3, and the like on a substrate. Principal members of the display unit A will be explained below.

Fig. 2 describes the case in which the light emitted from a pixel 3 is extracted in the white arrow direction (downward direction).

The scan line 5 and plural data lines 6 of the wiring unit are respectively formed from an electroconductive material, and the scan line 5 and the data line 6 intersect perpendicularly in a lattice form and are connected to the pixels 3 at the positions of intersection (the details are not shown in the diagram).

A pixel 3 receives image data signal from the data lines 6 when a scan signal is applied from the scan line 5, and emits light according to the received image data.

When pixels giving emitted light color in the red region, pixels giving emitted light color in the green region, and pixels giving emitted light color in the blue region are appropriately arranged in parallel on the same substrate, full color display is enabled.

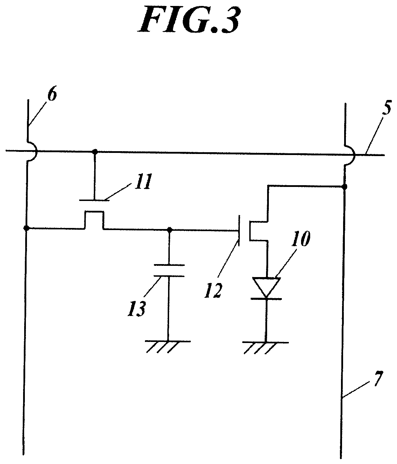

Next, the light emission process of the pixels is explained. Fig. 3 is a schematic diagram of pixels.

A pixel includes an organic EL element 10, a switching transistor 11, a drive transistor 12, a condenser 13, and the like. Organic EL elements emitting red light, green light, and blue light are used as the organic EL element 10 in plural pixels, and when these are arranged in parallel on the same substrate, full color display can be carried out.

In Fig. 3, an image data signal is applied to the drain of the switching transistor 11 from the control unit B through the data lines 6. When a scan signal is applied to the gate of the switching transistor 11 from the control unit B through the scan line 5, driving of the switching transistor 11 is turned on, and the image data signal applied to the drain is transferred to the condenser 13 and the gate of the drive transistor 12.

As a result of the transfer of the image data signal, the condenser 13 is charged according to the potential of the image data signal, and the driving of the drive transistor 12 is turned on. In the drive transistor 12, the drain is connected to the power supply line 7, the source is connected to the electrodes of the organic EL element 10, and an electric current is supplied to the organic EL element 10 from the power supply line 7 according to the image data signal applied to the gate.

When the scan signal passes to the next scan line 5 as a result of sequential scanning of the control unit B, the driving of the switching transistor 11 is turned off. However, the condenser 13 maintains the charged potential of the image data signal even if the driving of the switching transistor 11 is turned off, the driving of the drive transistor 12 is maintained in a turned-on state, and light emission of the organic EL element 10 is continued until the next scan signal is applied. When the next scan signal is applied by the sequential scanning, the drive transistor 12 is driven according to the potential of the next image data signal that has been synchronized to the scan signal, and the organic EL element 10 emits light.

That is, in regard to the light emission of the organic EL element 10, for the organic EL element 10 of each of the plural pixels, a switching transistor 11 and a drive transistor 12 are provided as active elements, and light emission of the organic EL element 10 of each of the plural pixels 3 is carried out. Such a light emission method is called the active matrix.

Here, the light emission of the organic EL element 10 may be gradational light emission in plural stages according to the image data signals of multiple values having plural gradational potentials, or may be an on-off type emission in a predetermined amount of light emission based on two values of image data signals. Also, regarding the maintenance of the potential of the condenser 13, the potential may be continuously maintained until the application of the next scan signal, or the potential may be discharged immediately before the next scan signal is applied.

The present invention is not limited to the active matrix described above, and light emission driving of the passive matrix system in which the organic EL element is caused to emit light according to the data signal only when the scan signal is scanned, may also be employed.

Fig. 4 is a schematic diagram of a display device based on the passive matrix system. In Fig. 4, plural scan lines 5 and plural image data lines 6 are provided in a lattice shape so as to face each other across pixels 3.

When the scan signal of the scan lines 5 are applied by sequential scanning, the pixels 3 that are connected to the scan lines 5 emit light according to the image data signal.

In the passive matrix system, the pixels 3 have no active elements, and reduction of the production cost can be expected.

### <<Lighting device>>

The lighting device of the present invention is explained. The lighting device of the present invention includes the organic EL element described above.

An organic EL element produced by providing a resonator structure to the organic EL element of the present invention may be used, and examples of the purpose of use of such an organic EL element having a resonator structure include, but are not limited to, a light source of an optical storage medium, a light source of an electrophotographic copying machine, a light source of an optical communication processor, and a light source of an optical sensor. Such an organic EL element may also be used for the applications described above by laser oscillation.

Furthermore, the organic EL element of the present invention may also be used as a kind of lamp such as a light source for lighting or exposure light source, or may also be used as a projection device of a type that projects images, or as a display device (display) of a type that visualizes static images or moving images.

The driving system in the case of using the organic EL element as a display device for moving image reproduction may be any of a simple matrix (passive matrix) system or an active matrix system. Alternatively, a full color display device can be produced by using two or more kinds of the organic EL elements of the present invention having different emitted light colors.

Furthermore, the organic EL material of the present invention can be applied to an organic EL element that emits substantial white light, as a lighting device. Plural emitted light colors are simultaneously emitted by plural luminescent materials, and white light emission is obtained by the mixed color. The combination of plural emitted light colors may be a combination including three maximum emission wavelengths of the three primary colors of red, green and blue, or may be a combination including two maximum emission wavelengths utilizing the relationship of complementary colors such as blue and yellow, or cyan and orange.

Furthermore, the combination of luminescent materials for obtaining plural emitted light colors may be any of a combination of plural materials that emit plural kinds of phosphorescent light or fluorescent light, or a combination of a luminescent material that emits fluorescent light or phosphorescent light, with a colorant material that emits light from a luminescent material as excitation light. However, in the white organic EL element related to the present invention, it is acceptable to only combine and mix plural luminescent dopants.

A mask may be provided only at the time of forming the light emitting layer, the hole transport layer or the electron transport layer, and the layers may be simply disposed by dividing the coating by the mask. Since other layers are shared in common, patterning of the mask or the like is unnecessary, and for example, an electrode film can be formed on one surface by a vapor deposition method, a casting method, a spin coating method, an inkjet method, a printing method or the like. Thus, productivity is also enhanced.

According to this method, unlike a white organic EL device in which luminescent elements of plural colors are arranged in parallel in an array form, the element itself emits white light.

There are no particular limitations on the luminescent material that is used in the light emitting layer, and for example, in the case of the backlight in a liquid crystal display element, the metal complexes related to the present invention and any arbitrary materials selected from known luminescent materials may be combined so as to be suitable for the wavelength range corresponding to the CF (color filter) characteristics, and thereby white light may be produced.

### <<Embodiment of lighting device of present invention>>

An embodiment of the lighting device of the present invention, which includes the organic EL element of the present invention, will be explained.

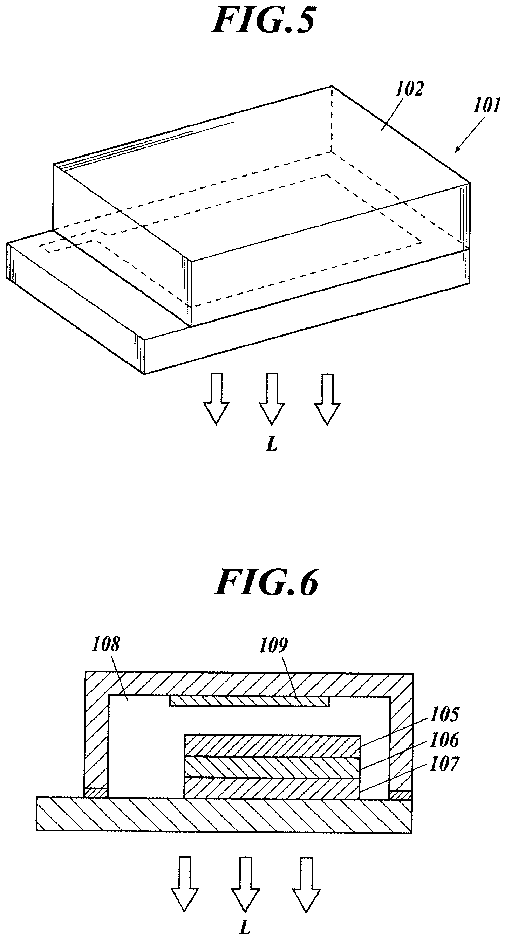

A lighting device illustrated in Fig. 5 or Fig. 6 can be formed by covering a non-light emitting surface of the organic EL element of the present invention with a glass case, using a glass substrate having a thickness of 300 µm as a substrate for sealing, applying an epoxy-based photocurable adhesive (LUXTRACK LC0629B manufactured by Toagosei Co., Ltd.) to the periphery as a sealing material, overlapping this on the negative electrode to adhere the glass substrate to the transparent supporting substrate, irradiating UV light through the glass substrate side to cure the adhesive, and thereby sealing the assembly.

Fig. 5 illustrates an outline diagram of a lighting device, and the organic EL element 101 of the present invention is covered with a glass cover 102 (incidentally, the operation of sealing with the glass cover was carried out in a glove box in a nitrogen atmosphere (in an atmosphere of high purity nitrogen gas having a purity of 99.999% or more), without bringing the organic EL element 101 into contact with air).

Fig. 6 illustrates a cross-sectional diagram of a lighting device, and in Fig. 6, reference numeral 105 represents a negative electrode; 106 represents an organic EL layer; and 107 represents a transparent electrode-attached glass substrate. The interior of the glass cover 102 is filled with nitrogen gas 108, and a moisture capturing agent 109 is provided therein.

### Examples

Hereinafter, the present invention will be described in detail by way of Examples, but the present invention is not intended to be limited to these.

Furthermore, the structures of compounds used in the Examples described below are shown below.

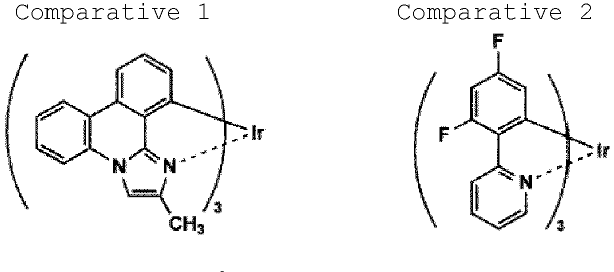

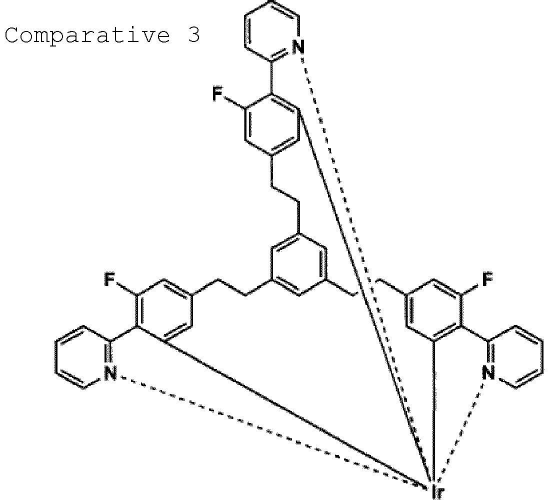

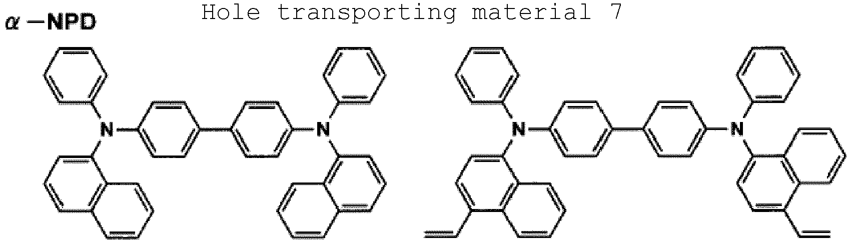

### Example 1

### Example 1

### (Exciton resistance test)

### <<Production of organic EL element 1-1>>

A quartz substrate having a size of 100 mm × 100 mm × 1.1 mm was fixed to a substrate holder of a commercially available vacuum deposition apparatus. OC-11 as a host compound and Comparative 1 as a dopant compound were introduced into resistance heating boats made of molybdenum, and then the heating boats were heated by passing an electric current. The compounds were co-deposited on the quartz substrate at rates of deposition of 0.1 nm/second and 0.006 nm/second, respectively, and thereby a layer having a film thickness of 80 nm was provided.

### <<Production of organic EL elements 1-2 to 1-8>>

In regard to the production of the organic EL element 1-1, the host compound and the dopant compound for the light emitting layer were changed to the compounds described in Table 1.

Except for this, the same procedure was followed, and organic EL elements 1-2 to 1-8 were respectively produced.

### <<Evaluation of organic EL elements 1-1 to 1-8>>

On the occasion of evaluating the organic EL elements 1-1 to 1-8 thus obtained, lighting devices illustrated in Fig. 5 and Fig. 6 were respectively produced by covering a non-light emitting surface of each of the produced organic EL elements with a glass case, using a glass substrate having a thickness of 300 µm as a substrate for sealing, applying an epoxy-based photocurable adhesive (LUXTRACK LC0629B manufactured by Toagosei Co., Ltd.) to the periphery as a sealing material, overlapping this on the organic layers described above to adhere the glass substrate to the transparent supporting substrate, irradiating UV light through the glass substrate side to cure the adhesive, and sealing the assembly. Thus, evaluation was carried out with the lighting devices.

The following evaluations were carried out for each of the samples thus produced. The evaluation results are presented in Table 1.

### [Maximum emission wavelength]

A dopant compound to be analyzed was dissolved in 2-methyltetrahydrofuran solvent that had been thoroughly deoxygenated, and the solution was introduced into a cell for phosphorescence measurement. Subsequently, excitation light was irradiated thereto, and the light emission spectrum was analyzed. In the light emission spectrum thus obtained, the maximum wavelength appearing on the shortest wavelength side was designated as the maximum emission wavelength.

### [Residual ratio of luminance]

The distance between a UV-LED (5 W/cm²) light source and the sample was set to 10 mm, and the residual ratio of luminance obtainable when the sample was irradiated with light for 20 minutes was measured.

The residual ratio of luminance was indicated as a relative value with respect to the organic EL element 1-1 as 100.

Residual ratio of luminance = (initial luminance - luminance after 20 minutes) / initial luminance

**[Table 1]**

| Element No. | Dopant compound | Host compound | Maximum emission wavelength (nm) | Residual ratio of luminance | Remarks |
|---|---|---|---|---|---|
| 1-1 | Comparative 1 | 1 | 465 | 100 | Comparative Example |
| 1-2 | Comparative 2 | 1 | 472 | 130 | Comparative Example |
| 1-3 | Comparative 3 | 1 | 472 | 138 | Comparative Example |
| 1-4 | Compound Example 41 | 1 | 465 | 175 | Reference Example |
| 1-5 | Compound Example 2 | 1 | 455 | 187 | Reference Example |
| 1-6 | Compound Example 21 | 1 | 466 | 160 | Present Invention |
| 1-7 | Compound Example 24 | 1 | 463 | 170 | Present Invention |
| 1-8 | Compound Example 33 | 1 | 464 | 164 | Present Invention |

### [Conclusions]

When an exciton durability test by light irradiation was carried out, it was found that as shown in Table 1, since the compounds related to the present invention have high residual ratios of luminance compared with the comparative compounds, the compounds related to the present invention have excellent exciton durability.

### Example 2

### <<Production of organic EL element 2-1>>

### (Production of hole-only element)

A substrate (NA45 manufactured by NH Techno Glass Corp.) obtained by forming a film of ITO (indium tin oxide) having a thickness of 100 nm as a positive electrode on a glass substrate having a size of 100 mm × 100 mm × 1.1 mm, was subjected to patterning. Subsequently, this transparent supporting substrate provided with an ITO transparent electrode was ultrasonically cleaned with isopropyl alcohol, dried with a dry nitrogen gas, and subjected to UV ozone cleaning for 5 minutes.

On this transparent supporting substrate, a thin film was formed using a solution prepared by diluting poly(3,4-ethylenedioxythiophene)-polystyrene sulfonate (PEDOT/PSS, manufactured by H.C. Starck GmbH, CLEVIO P VP AI 4083) with pure water to 70%, by a spin coating method under the conditions of 3000 rpm and 30 seconds. Subsequently, the coating was dried for one hour at 200°C, and thus a first hole transport layer having a film thickness of 20 nm was provided.

This transparent supporting substrate was fixed to a substrate holder of a commercially available vacuum deposition apparatus. Meanwhile, 200 mg of α-NPD as a hole transporting material was introduced into a resistance heating boat made of molybdenum, 200 mg of OC-11 as a host compound was introduced into another resistance heating boat made of molybdenum, and 100 mg of Comparative 1 as a dopant compound was introduced into another resistance heating boat made of molybdenum. The resistance heating boats were mounted in the vacuum deposition apparatus.

Next, the pressure inside the vacuum chamber was reduced to 4 × 10⁻⁴ Pa, subsequently the heating boat containing α-NPD was heated by passing an electric current, and α-NPD was vapor deposited on the first hole transport layer at a rate of deposition of 0.1 nm/second. Thus, a second hole transport layer having a film thickness of 20 nm was provided.

Furthermore, the aforementioned heating boats containing OC-11 as a host compound and Comparative 1 as a dopant compound were heated by passing an electric current, and the compounds were co-deposited on the second hole transport layer at rates of deposition of 0.1 nm/second and 0.006 nm/second, respectively. Thus, a light emitting layer having a film thickness of 80 nm was provided.

The heating boat containing α-NPD was heated by passing an electric current, and α-NPD was deposited on the light emitting layer at a rate of deposition of 0.1 nm/second. Thus, an electron blocking layer having a film thickness of 20 nm was provided.

The substrate temperature at the time of deposition was room temperature.

Subsequently, aluminum was vapor deposited thereon to form a negative electrode having a film thickness of 110 nm, and thus an organic EL element 2-1 was produced.

### <<Production of organic EL elements 2-2 to 2-10>>

In regard to the production of the organic EL element 2-1, the host compound and the dopant compound for the light emitting layer were changed to the compounds described in Table 2.

Except for this, the same procedure was followed, and thus organic EL elements 2-2 to 2-10 were respectively produced.

### <<Evaluation of organic EL elements 2-1 to 2-10>>

On the occasion of evaluating the organic EL elements 2-1 to 2-10 thus obtained, a lighting device illustrated in Fig. 5 and Fig. 6 was produced by covering a non-light emitting surface of each of the produced organic EL elements with a glass case, using a glass substrate having a thickness of 300 µm as a substrate for sealing, applying an epoxy-based photocurable adhesive (LUXTRACK LC0629B manufactured by Toagosei Co., Ltd.) to the periphery as a sealing material, overlapping this on the negative electrode described above to adhere the glass substrate to the transparent supporting substrate, irradiating UV light through the glass substrate side to cure the adhesive, and sealing the assembly. Thus, evaluation was carried out with the lighting devices.

The following evaluation was carried out for the various samples thus produced. The evaluation results are presented in Table 2.

### [Voltage increase upon driving]

The voltage obtained at the time of driving each of the organic EL elements by passing an electric current for 100 hours under the conditions of a constant current of 2.5 mA/cm² at room temperature (about 23°C to 25°C), was measured, and the measurement results were calculated by the calculation formula described below. The results thus obtained are presented in Table 2.

The voltage was indicated as a relative value with respect to the organic EL element 2-1 as 100.

Voltage increase upon driving (relative value) = driving voltage upon luminance reduction by half - initial driving voltage

Meanwhile, a smaller value represents a smaller voltage increase upon driving for comparison.

**[Table 2]**

| Element No. | Dopant compound | Host compound | Voltage increase | Remarks |
|---|---|---|---|---|
| 2-1 | Comparative 1 | OC-11 | 100 | Comparative Example |
| 2-2 | Comparative 2 | OC-11 | 73 | Comparative Example |
| 2-3 | Comparative 3 | OC-11 | 65 | Comparative Example |
| 2-4 | Compound Example 1 | OC-11 | 33 | Reference Example |
| 2-5 | Compound Example 8 | 52 | 38 | Reference Example |
| 2-6 | Compound Example 10 | OC-29 | 40 | Reference Example |
| 2-7 | Compound Example 13 | OC-30 | 39 | Reference Example |
| 2-8 | Compound Example 22 | 26 | 42 | Present Invention |
| 2-9 | Compound Example 28 | 30 | 39 | Present Invention |
| 2-10 | Compound Example 34 | OC-29 | 38 | Present Invention |

### [Conclusions]

A durability test at the time of hole conduction by hole-only element driving was carried out, and it was found that as shown in Table 2, the compounds related to the present invention have lower voltage increases upon driving, and have enhanced stability at the time of hole conduction, compared with the comparative compounds.

### Example 3

### <<Production of organic EL element 3-1>>

### (Production of electron-only element)

A substrate (NA45 manufactured by NH Techno Glass Corp.) obtained by forming a film of ITO (indium tin oxide) having a thickness of 100 nm as a positive electrode on a glass substrate having a size of 100 mm × 100 mm × 1.1 mm, was subjected to patterning. Subsequently, this transparent supporting substrate provided with an ITO transparent electrode was ultrasonically cleaned with isopropyl alcohol, dried with a dry nitrogen gas, and subjected to UV ozone cleaning for 5 minutes.

This transparent supporting substrate was fixed to a substrate holder of a commercially available vacuum deposition apparatus. Meanwhile, 200 mg of Ca was introduced into a resistance heating boat made of molybdenum, 200 mg of OC-11 as a host compound was introduced into another resistance heating boat made of molybdenum, and 100 mg of Comparative 1 as a dopant compound was introduced into another resistance heating boat made of molybdenum. The resistance heating boats were mounted in the vacuum deposition apparatus.

Next, the pressure of the vacuum chamber was reduced to 4 × 10⁻⁴ Pa, subsequently the heating boat containing Ca was heated by passing an electric current, and Ca was vapor deposited on the transparent supporting substrate at a rate of deposition of 0.1 nm/second. Thus, a hole blocking layer having a film thickness of 10 nm was provided.

Furthermore, the aforementioned heating boats containing OC-11 as a host compound and Comparative 1 as a dopant compound were heated by passing an electric current, and the compounds were co-deposited on the hole blocking layer at rates of deposition of 0.1 nm/second and 0.006 nm/second, respectively. Thus, a light emitting layer having a film thickness of 80 nm was provided.

The heating boat containing Ca was heated by passing an electric current, and Ca was deposited on the light emitting layer at a rate of deposition of 0.1 nm/second.

The substrate temperature at the time of deposition was room temperature.

Subsequently, aluminum was vapor deposited thereon to form a negative electrode having a film thickness of 110 nm, and thus an organic EL element 3-1 was produced.

### <<Production of organic EL elements 3-2 to 3-10>>

In regard to the production of the organic EL element 3-1, the host compound and the dopant compound for the light emitting layer were changed to the compounds described in Table 3.

Except for this, the same procedure was followed, and organic EL elements 3-2 to 3-10 were respectively produced.

### <<Evaluation of organic EL elements 3-1 to 3-10>>

On the occasion of evaluating the organic EL elements 3-1 to 3-10 thus obtained, a lighting device illustrated in Fig. 5 and Fig. 6 was produced by covering a non-light emitting surface of each of the produced organic EL elements with a glass case, using a glass substrate having a thickness of 300 µm as a substrate for sealing, applying an epoxy-based photocurable adhesive (LUXTRACK LC0629B manufactured by Toagosei Co., Ltd.) to the periphery as a sealing material, overlapping this on the negative electrode described above to adhere the glass substrate to the transparent supporting substrate, irradiating UV light through the glass substrate side to cure the adhesive, and sealing the assembly. Thus, evaluation was carried out with the lighting devices.

The following evaluation was carried out for the various samples thus produced. The evaluation results are presented in Table 3.

### [Voltage increase upon driving]

The voltage obtained at the time of driving each of the organic EL elements by passing an electric current for 100 hours under the conditions of a constant current of 2.5 mA/cm² at room temperature (about 23°C to 25°C), was measured, and the measurement results were calculated by the calculation formula described below. The results thus obtained are presented in Table 3.

The voltage was indicated as a relative value with respect to the organic EL element 3-1 as 100.

Voltage increase upon driving (relative value) = driving voltage upon luminance reduction by half - initial driving voltage

Meanwhile, a smaller value represents a smaller voltage increase upon driving for comparison.

**[Table 3]**

| Element No. | Dopant compound | Host compound | Voltage increase | Remarks |
|---|---|---|---|---|
| 3-1 | Comparative 1 | OC-11 | 100 | Comparative Example |
| 3 - 2 | Comparative 2 | OC-11 | 81 | Comparative Example |
| 3-3 | Comparative 3 | OC-11 | 77 | Comparative Example |
| 3-4 | Compound Example 1 | OC-30 | 30 | Reference Example |
| 3-5 | Compound Example 2 | 52 | 29 | Reference Example |
| 3-6 | Compound Example 7 | OC-29 | 45 | Reference Example |
| 3-7 | Compound Example 21 | OC-11 | 40 | Present Invention |
| 3-8 | Compound Example 27 | 28 | 38 | Present Invention |
| 3-9 | Compound Example 34 | 30 | 41 | Present Invention |
| 3-10 | Compound Example 40 | OC-29 | 39 | Present Invention |

### [Conclusions]

A durability test at the time of hole conduction by electron-only element driving was carried out, and it was found that as shown in Table 3, the compounds related to the present invention have low voltage increases upon driving, and have enhanced stability at the time of electron conduction, compared with the comparative compounds.

### Example 4

### <<Production of organic EL element 4-1>>

A substrate (NA45 manufactured by NH Techno Glass Corp.) obtained by forming a film of ITO (indium tin oxide) having a thickness of 100 nm as a positive electrode on a glass substrate having a size of 100 mm × 100 mm × 1.1 mm, was subjected to patterning. Subsequently, this transparent supporting substrate provided with an ITO transparent electrode was ultrasonically cleaned with isopropyl alcohol, dried with a dry nitrogen gas, and subjected to UV ozone cleaning for 5 minutes.

On this transparent supporting substrate, a thin film was formed using a solution prepared by diluting poly(3,4-ethylenedioxythiophene)-polystyrene sulfonate (PEDOT/PSS, manufactured by H.C. Starck GmbH, CLEVIO P VP AI 4083) with pure water to 70%, by a spin coating method under the conditions of 3000 rpm and 30 seconds. Subsequently, the coating was dried for one hour at 200°C, and thus a first hole transport layer having a film thickness of 20 nm was provided.

This transparent supporting substrate was fixed to a substrate holder of a commercially available vacuum deposition apparatus. Meanwhile, 200 mg of α-NPD as a hole transporting material was introduced into a resistance heating boat made of molybdenum, 200 mg of OC-30 as a host compound was introduced into another resistance heating boat made of molybdenum, 200 mg of ET-8 as an electron transporting material was introduced into another resistance heating boat made of molybdenum, and 100 mg of Comparative 1 as a dopant compound was introduced into another resistance heating boat made of molybdenum. The resistance heating boats were mounted in the vacuum deposition apparatus.

Next, the pressure inside the vacuum chamber was reduced to 4 × 10⁻⁴ Pa, subsequently the heating boat containing α-NPD was heated by passing an electric current, and α-NPD was vapor deposited on the first hole transport layer at a rate of deposition of 0.1 nm/second. Thus, a second hole transport layer having a film thickness of 20 nm was provided.

Furthermore, the aforementioned heating boats containing OC-30 as a host compound and Comparative 1 as a dopant compound were heated by passing an electric current, and the compounds were co-deposited on the second hole transport layer at rates of deposition of 0.1 nm/second and 0.006 nm/second, respectively. Thus, a light emitting layer having a film thickness of 40 nm was provided.

Furthermore, the heating boat containing ET-8 was heated by passing an electric current, and ET-8 was vapor deposited on the light emitting layer at a rate of deposition of 0.1 nm/second. Thus, an electron transport layer having a film thickness of 30 nm was provided.

The substrate temperature at the time of deposition was room temperature.

Subsequently, lithium fluoride was vapor deposited thereon the form a negative electrode buffer layer having a film thickness of 0.5 nm, and aluminum was vapor deposited thereon to form a negative electrode having a film thickness of 110 nm. Thus, an organic EL element 4-1 was produced.

### <<Production of organic EL elements 4-2 to 4-10>>

In regard to the production of the organic EL element 4-1, the host compound and the dopant compound for the light emitting layer were changed to the compounds described in Table 4.

Except for this, the same procedure was followed, and thus organic EL elements 4-2 to 4-10 were respectively produced.

### <<Evaluation of organic EL elements 4-1 to 4-10>>

On the occasion of evaluating the organic EL elements 4-1 to 4-10 thus obtained, a lighting device illustrated in Fig. 5 and Fig. 6 was produced by covering a non-light emitting surface of each of the produced organic EL elements with a glass case, using a glass substrate having a thickness of 300 µm as a substrate for sealing, applying an epoxy-based photocurable adhesive (LUXTRACK LC0629B manufactured by Toagosei Co., Ltd.) to the periphery as a sealing material, overlapping this on the negative electrode described above to adhere the glass substrate to the transparent supporting substrate, irradiating UV light through the glass substrate side to cure the adhesive, and sealing the assembly. Thus, evaluation was carried out with the lighting devices.

The following evaluations were carried out for the various samples thus produced. The evaluation results are presented in Table 4.

### (1) External extraction quantum efficiency (also simply referred to as efficiency)

An organic EL element was lighted under the conditions of a constant current of 2.5 mA/cm² at room temperature (about 23°C to 25°C) , and the emission luminance (L) [cd/m²] immediately after the initiation of lighting was measured. Thereby, the external extraction quantum efficiency (η) was calculated.

Here, measurement of the emission luminance was carried out using a CS-1000 (manufactured by Konica Minolta Sensing, Inc.), and the external extraction quantum efficiency was indicated as a relative value with respect to the organic EL element 4-1 as 100.

### (2) Half-life

An evaluation of the half-life was carried out according to the measurement method described below.

Each of the organic EL elements was constant current-driven at a current that gives an initial luminance of 1000 cd/m², and the time taken by the initial luminance to reach a half (500 cd/m²) was determined. This was designated as the measure of the half-life.

The half-life was indicated as a relative value with respect to the organic EL element 4-1 as 100.

### (3) Voltage increase upon driving

The voltage obtainable when each of the organic EL elements was driven under the conditions of a constant current of 2.5 mA/cm² at room temperature (about 23°C to 25°C) was measured, and the measurement results were calculated by the calculation formula shown below. The results thus obtained are presented in Table 4.

The voltage was indicated as a relative value with respect to the organic EL element 4-1 as 100.

Voltage increase upon driving (relative value) = driving voltage upon luminance reduction by half - initial driving voltage

Meanwhile, a smaller value represents a smaller voltage increase upon driving for comparison.

### (4) Evaluation of thermal stability

For each of the organic EL elements 4-1 to 4-10, five elements each of the elements having the same configuration were produced using the same vapor deposition boats (resistance heating boats made of molybdenum) (for example, organic EL elements 4-1, 4-1b, 4-1c, 4-1d, and 4-1e).

For each of the element produced in the first round (for example, organic EL element 4-1), the element produced in the third round (for example, organic EL element 4-1c), and the element produced in the fifth round (for example, organic EL element 4-1e), the half-life was measured by the same method as described above . The half-life of each element was indicated as a relative value with respect to the organic EL element 4-1 produced in the first time as 100.

**[Table 4]**

| Element No. | Dopant compound | Maximum emission wavelength (nm) | External extraction quantum efficiency | Half-life | Voltage increase upon driving | Evaluation of thermal stability | | Remarks |
|---|---|---|---|---|---|---|---|---|
| | | | | | | Half-life (third round) | Half-life (fifth round) | Comparative Example |
| 4-1 | Comparative 1 | 465 | 100 | 100 | 100 | 85 | 70 | Comparative Example |
| 4-2 | Comparative 2 | 472 | 130 | 55 | 130 | 130 | 129 | Comparative Example |
| 4-3 | Comparative 3 | 472 | 129 | 70 | 110 | 130 | 130 | Comparative Example |
| 4-4 | Compound Example 2 | 455 | 140 | 1355 | 78 | 140 | 141 | Reference Example |
| 4-5 | Compound Example 21 | 466 | 145 | 150 | 80 | 144 | 144 | Present Invention |
| 4-6 | Compound Example 24 | 463 | 149 | 144 | 82 | 148 | 150 | Present Invention |
| 4-7 | Compound Example 33 | 464 | 151 | 146 | 79 | 150 | 151 | Present Invention |
| 4-8 | Compound Example 41 | 465 | 144 | 139 | 81 | 143 | 145 | Reference Example |

### (5) Conclusions

From Table 4, it is understood that the organic EL elements 4-4 to 4-8 of the present invention have satisfactory luminescence efficiency and lifetime and have enhanced characteristics as elements, as compared with the organic EL elements 1-1 to 1-3 of Comparative Examples. Furthermore, the organic EL element 4-1 of Comparative Example was such that the element produced in the first round, the element produced in the third round, and the element produced in the fifth round had gradually decreasing half-lives; whereas the organic EL elements 4-4 to 4-8 of the present invention were such that the elements produced in the first round, the elements produced in the third round, and the elements produced in the fifth round have half-lives that are almost non-decreasing, and the dopant compounds used in the organic EL elements of the present invention have excellent thermal stability.

### Example 5

### <<Production of white light emitting organic EL element 5-1>>

A substrate (NA45 manufactured by NH Techno Glass Corp.) obtained by forming a film of ITO (indium tin oxide) having a thickness of 100 nm as a positive electrode on a glass substrate having a size of 100 mm × 100 mm × 1.1 mm, was subjected to patterning. Subsequently, this transparent supporting substrate provided with an ITO transparent electrode was ultrasonically cleaned with isopropyl alcohol, dried with a dry nitrogen gas, and subjected to UV ozone cleaning for 5 minutes.

This transparent supporting substrate was fixed to a substrate holder of a commercially vacuum deposition apparatus. Meanwhile, 200 mg of α-NPD as a hole transporting material was introduced into a resistance heating boat made of molybdenum, 200 mg of OC-11 as a host compound was introduced into another resistance heating boat made of molybdenum, 200 mg of ET-11 as an electron transporting material was introduced into another resistance heating boat made of molybdenum, 100 mg of Comparative 1 as a dopant compound was introduced into another resistance heating boat made of molybdenum, and 100 mg of D-10 as a dopant compound was introduced into another resistance heating boat made of molybdenum. The resistance heating boats were mounted in the vacuum deposition apparatus.

Next, the pressure inside the vacuum chamber was reduced to 4 × 10⁻⁴ Pa, subsequently the heating boat containing α-NPD was separately heated by passing an electric current, and α-NPD was vapor deposited on the transparent supporting substrate at a rate of deposition of 0.1 nm/second. Thus, a hole transport layer having a film thickness of 20 nm was provided.

Furthermore, the heating boat containing OC-11 as a host compound and the heating boats containing Comparative 1 and D-10 as dopant compounds were subjected to current conduction, the rates of deposition of OC-11, Comparative 1 and D-10 were adjusted so as to be 100:5:0.6, and the compounds were vapor deposited to a film thickness of 30 nm. Thus, a light emitting layer was provided.

Furthermore, the heating boat containing ET-11 was heated by passing an electric current, and ET-11 was vapor deposited on the light emitting layer at a rate of deposition of 0.1 nm/second. Thus, an electron transport layer having a film thickness of 30 nm was provided.

The substrate temperature at the time of deposition was room temperature.

Subsequently, lithium fluoride was vapor deposited thereon to form a negative electrode buffer layer having a film thickness of 0.5 nm, and aluminum was vapor deposited thereon to form a negative electrode having a film thickness of 110 nm. Thus, an organic EL element 5-1 was produced.

When an electric current was passed through the organic EL element 5-1 thus produced, light that was almost white in color was obtained. Thus, it was found that the organic EL element can be used as a lighting device. It was also found that when the compounds were replaced with other compounds given as examples, white light emission is similarly achieved.

### <<Production of organic EL elements 5-2 to 5-10>>

In regard to the production of the organic EL element 5-1, the host compound and the dopant compound for the light emitting layer were changed to the compounds indicated in Table 5.

Except for this, the same procedure was followed, and organic EL elements 5-2 to 5-10 were respectively produced.

### <<Evaluation of organic EL elements 5-1 to 5-10>>

On the occasion of evaluating the organic EL elements 5-1 to 5-10 thus obtained, a lighting device illustrated in Fig. 5 and Fig. 6 was produced by sealing each of the relevant organic EL elements in the same manner as in the case of the organic EL elements 2-2 to 2-10 of Example 2. Thus, evaluation was carried out with the lighting devices.

For each of the samples produced in this manner, evaluations on the external extraction quantum efficiency, the half-life, and the voltage increase upon driving were carried out in the same manner as in Example 4. The evaluation results are presented in Table 5. Meanwhile, the measurement results for the external extraction quantum efficiency, the luminescence lifetime, and the voltage increase upon driving in Table 5 are indicated as relative values with respect to the measurement values for the organic EL element 5-1 as 100.

**[Table 5]**

| Element No. | Dopant compound | Host compound | External extraction quantum efficiency | Half-life | Voltage increase upon driving | Remarks |
|---|---|---|---|---|---|---|
| 5-1 | Comparative 1 | OC-11 | 100 | 100 | 100 | Comparative Example |
| 5-2 | Comparative 2 | OC-11 | 120 | 30 | 120 | Comparative Example |
| 5-3 | Comparative 3 | OC-11 | 118 | 31 | 110 | Comparative Example |
| 5-4 | Compound Example 1 | OC-11 | 130 | 150 | 65 | Reference Example |
| 5-5 | Compound Example 2 | 52 | 131 | 145 | 70 | Reference Example |
| 5-6 | Compound Example 7 | OC-29 | 126 | 140 | 77 | Reference Example |
| 5-7 | Compound Example 20 | OC-30 | 120 | 139 | 78 | Present Invention |
| 5-8 | Compound Example 27 | 26 | 119 | 137 | 81 | Present Invention |
| 5-9 | Compound Example 30 | 30 | 123 | 143 | 82 | Reference Example |
| 5-10 | Compound Example 35 | OC-29 | 125 | 145 | 85 | Reference Example |

From Table 5, it is understood that the organic EL elements 5-4 to 5-10 of the present invention exhibit high luminescence efficiency and long lifetime as compared with the organic EL elements 5-1 to 5-3 of Comparative Examples, and have enhanced characteristics as elements, such as suppressed voltage increase upon driving.

### Example 6

### <<Production of organic EL full color display device>>

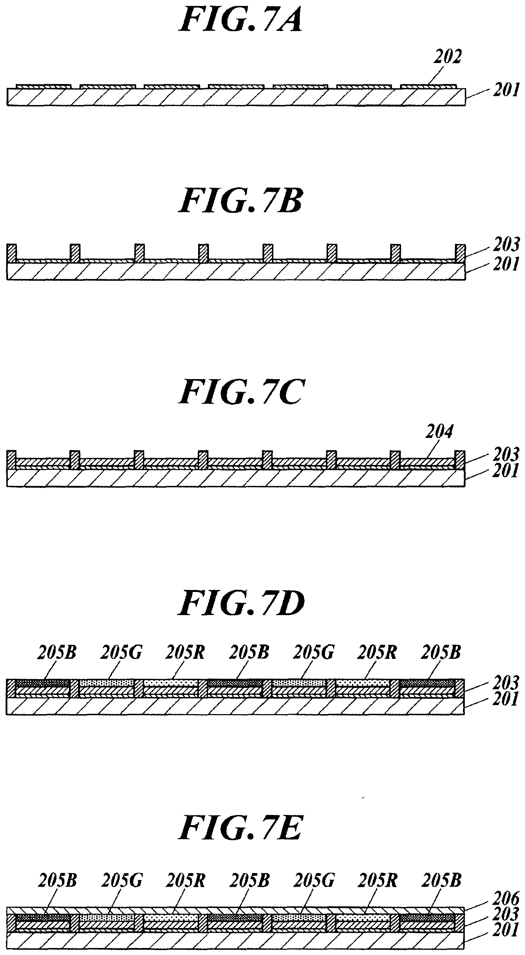

Fig. 7 illustrates an outline configuration diagram of an organic EL full color display device.

A substrate (NA45 manufactured by NH Techno Glass Corp.) obtained by forming ITO transparent electrodes 202 having a thickness of 100 nm as a positive electrode on a glass substrate 201, was subjected to patterning at a pitch of 100 µm (see Fig. 7A). Partition walls 203 (width 20 µm, thickness 2.0 µm) of a non-photosensitive polyimide were formed by photolithography on this glass substrate 201 and between the ITO transparent electrodes 202 (see Fig. 7B).

A hole injection layer composition having the composition described below was discharged and injected using an inkjet head (manufactured by Seiko Epson Corp.; MJ800C) on the ITO transparent electrodes 202 and between the partition walls 203. Ultraviolet radiation was irradiated thereto for 200 seconds, and a drying treatment was carried out at 60°C for 10 minutes. Thereby, hole injection layers 204 having a film thickness of 40 nm were provided (see Fig. 7C).

On this hole injection layers 204, a blue light emitting layer composition, a green light emitting layer composition, and a red light emitting layer composition respectively having the compositions described below were similarly discharged and injected using an inkjet head, and a drying treatment was carried out at 60°C for 10 minutes. Thus, light emitting layers 205B, 205G and 205R of the respective colors were provided (see Fig. 7D).

Next, an electron transporting material (ET-10) was vapor deposited so as to cover the various light emitting layers 205B, 205G and 205R, and thereby electron transport layers (not shown in the diagram) having a film thickness of 20 nm were provided thereon. Lithium fluoride was vapor deposited thereon to provide a negative electrode buffer layer (not shown in the diagram) having a film thickness of 0.6 nm, and Al was vapor deposited thereon to provide a negative electrode 106 having a film thickness of 130 nm. Thus, an organic EL element was produced (see Fig. 7E).

The organic EL element thus produced exhibited emission of blue, green and red light when a voltage was applied to the electrodes of the respective pixels. Thus, it was found that the organic EL element can be utilized as a full color display device.

**(Hole injection layer composition)**

| | |
|---|---|
| Hole transporting material 7 | 20 parts by mass |
| Cyclohexylbenzene | 50 parts by mass |
| Isopropylbiphenyl | 50 parts by mass |

**(Blue light emitting layer composition)**

| | |
|---|---|
| Host material 1 | 0.7 parts by mass |
| Compound Example 1 | 0.04 parts by mass |
| Cyclohexylbenzene | 50 parts by mass |
| Isopropylbiphenyl | 50 parts by mass |

**(Green light emitting layer composition)**

| | |
|---|---|
| Host material 1 | 0.7 parts by mass |
| D-1 | 0.04 parts by mass |
| Cyclohexylbenzene | 50 parts by mass |
| Isopropylbiphenyl | 50 parts by mass |
| (Red light emitting layer composition) | |
| Host material 1 | 0.7 parts by mass |
| D-10 | 0.04 parts by mass |
| Cyclohexylbenzene | 50 parts by mass |
| Isopropylbiphenyl | 50 parts by mass |

### Industrial Applicability

As described above, the present invention is suitable for providing an organic electroluminescent element having high luminescence efficiency and a long lifetime, a lighting device and a display device, both including the element, by enhancing the thermal stability of the organic electroluminescent element materials, stability of excitons, and stability of carriers at the time of electricity conduction, and by ameliorating the waveform of the emission spectrum.

### Reference Signs List

1 DISPLAY
3 PIXEL
5 SCAN LINE
6 DATA LINE
7 POWER SUPPLY LINE
10 ORGANIC EL ELEMENT
11 SWITCHING TRANSISTOR
12 DRIVE TRANSISTOR
13 CONDENSER
101 ORGANIC EL ELEMENT
102 GLASS COVER
105 NEGATIVE ELECTRODE
106 ORGANIC EL LAYER
107 TRANSPARENT-ELECTRODE-ATTACHED GLASS SUBSTRATE
108 NITROGEN GAS
109 MOISTURE CAPTURING AGENT
201 GLASS SUBSTRATE
202 ITO TRANSPARENT ELECTRODE
203 PARTITION WALL
204 HOLE INJECTION LAYER
205B, 205G, 205R LIGHT EMITTING LAYERS
206 NEGATIVE ELECTRODE
A DISPLAY UNIT
B CONTROL UNIT

## Claims

1. An organic electroluminescent element (10) comprising at least one organic layer including a light emitting layer (205B, 205G, 205R) interposed between a positive electrode and a negative electrode (105, 206), wherein the light emitting layer (205B, 205G, 205R) contains an iridium complex compound represented by any one of the following formulas (2) to (4) : 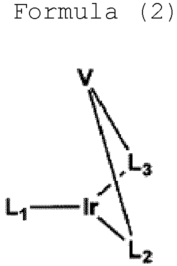 wherein in formula (2), V represents a divalent linking group and is linked to L₂ and L₃ by covalent bonding; and L₁ to L₃ are respectively represented by the following formula (5) ; 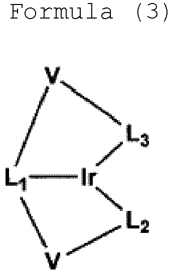 wherein in formula (3), V's each represent a divalent linking group and are respectively linked to L₁, L₂ and L₃ by covalent bonding; and L₁ to L₃ are each represented by the following formula (5); 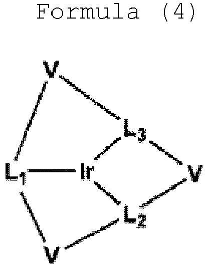 wherein in formula (4), V's each represent a divalent linking group and are respectively linked to L₁, L₂ and L₃ by covalent bonding; and L₁ to L₃ are respectively represented by the following formula (5); 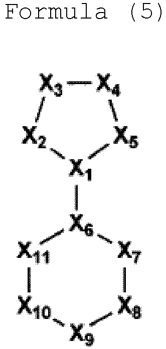 wherein in formula (5), X₁ to X₅ are a group of elements that form a nitrogen-containing heterocyclic ring, and are selected from a carbon atom or a nitrogen atom; at least one of X₄ and X₅ represents a nitrogen atom; X₅ forms a coordination bond with Ir in the formulas (2) to (4); X₆ to X₁₁ are a group of elements that form a 6-membered aromatic ring, and are selected from a carbon atom or a nitrogen atom; X₇ forms a covalent bond with Ir in the formulas (2) to (4),
**characterized in that**
(a) the maximum emission wavelength of the iridium complex compound is 470 nm or less, as determined in accordance with the method disclosed in the description, and, regarding at least one of L₁ to L₃ among L₁ to L₃ in formulas (2) to (4), formula (5) is represented by the following formula (6) or the following formula (8): 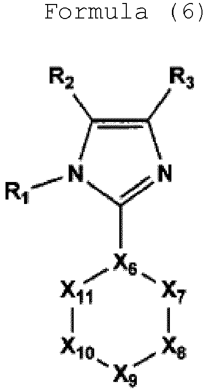 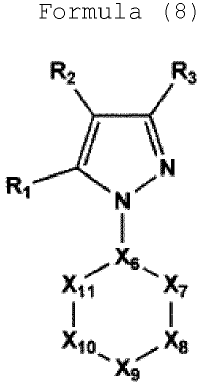 wherein in formulas (6) and (8), X₆ to X₁₁ have the same meanings as defined for X₆ to X₁₁ in the formula (5); R₁, R₂ and R₃ each represent a hydrogen atom or a substituent; and R₁ and X₁₁ may form a ring; or
(b) the maximum emission wavelength of the iridium complex compound is 460 nm or less, as determined in accordance with the method disclosed in the description, and in at least one of L₁ to L₃ among L₁ to L₃ in formulas (2) to (4), the nitrogen-containing heterocyclic ring formed by X₁ to X₅ in the formula (5) is a triazole ring.

2. The organic electroluminescent element according to claim 1 or 2, **characterized in that** regarding at least one of L₁ to L₃ in the formulas (2) to (4), the formula (5) is represented by the following formula (7): 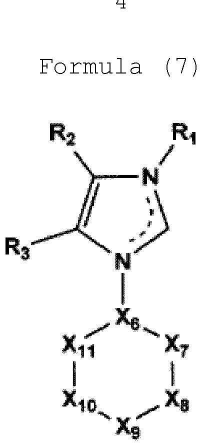 wherein in formula (7), X₆ to X₁₁ have the same meanings as defined for X₆ to X₁₁ in the formula (5); R₁, R₂ and R₃ each represent a hydrogen atom or a substituent; and R₃ and X₁₁ may form a ring.

3. The organic electroluminescent element according to claim 1 or 2, **characterized in that** regarding at least one of L₁ to L₃ in the formulas (2) to (4), the formula (5) is represented by the following formula (9): 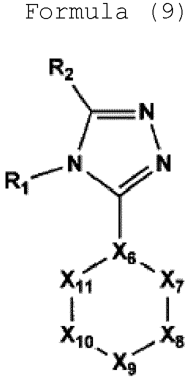 wherein in formula (9), X₆ to X₁₁ have the same meanings as defined for X₆ to X₁₁ in the formula (5); R₁ and R₂ each represent a hydrogen atom or a substituent; and R₁ and X₁₁ may form a ring.

4. The organic electroluminescent element according to any one of claims 1 to 3, **characterized in that**, when the iridium complex compound is as defined in option (a) of claim 1, the maximum emission wavelength of the iridium complex compound represented by any one of the formulas (2) to (4) is 465 nm or less.

5. The organic electroluminescent element according to any one of claims 1 to 4, **characterized in that**, when the iridium complex compound is as defined in option (a) of claim 1, the maximum emission wavelength of the iridium complex compound represented by any one of the formulas (2) to (4) is 460 nm or less.

6. The organic electroluminescent element according to any one of claims 1 to 5, **characterized in that** V in the formulas (2) to (4) is linked to L₁ to L₃ via X₉ in the formulas (5), (6), (8) or (9).

7. The organic electroluminescent element according to any one of claims 1 to 6, **characterized in that** the emitted light color is white.

8. A lighting device comprising the organic electroluminescent element (10) according to any one of claims 1 to 7.

9. A display device comprising the organic electroluminescent element (10) according to any one of claims 1 to 7.

## Patentansprüche

1. Organisches Elektrolumineszenzelement (10), umfassend zumindest eine organische Schicht, welche eine zwischen einer positiven Elektrode und einer negativen Elektrode (105, 206) angeordnete lichtemittierende Schicht (205B, 205G, 205R) umfasst, wobei die lichtemittierende Schicht (205B, 205G, 205R) eine Iridiumkomplexverbindung enthält, welche durch eine der nachfolgenden Formeln (2) bis (4) dargestellt wird: 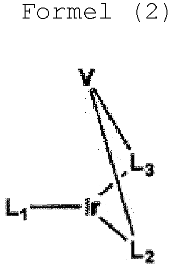 wobei in Formel (2) das V für eine zweiwertige Verknüpfungsgruppe steht und über kovalente Bindungen mit L₂ und L₃ verknüpft ist; und L₁ bis L₃ jeweils durch nachfolgende Formel (5) dargestellt werden; 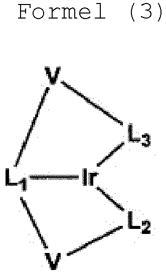 wobei in Formel (3) die V's jeweils für eine zweiwertige Verknüpfungsgruppe stehen und jeweils über kovalente Bindungen mit L₁, L₂ und L₃ verknüpft sind; und L₁ bis L₃ jeweils durch nachfolgende Formel (5) dargestellt werden; 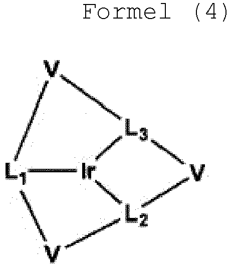 wobei in Formel (4) die V's jeweils für eine zweiwertige Verknüpfungsgruppe stehen und jeweils über kovalente Bindungen mit L₁, L₂ und L₃ verknüpft sind; und L₁ bis L₃ jeweils durch nachfolgende Formel (5) dargestellt werden; 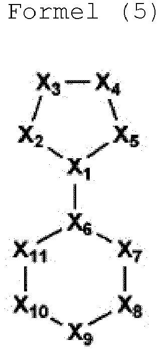 wobei in Formel (5) X₁ bis X₅ für eine Gruppe von Elementen stehen, welche einen stickstoffhaltigen heterozyklischen Ring ausbilden, und aus einem Kohlenstoffatom oder einem Stickstoffatom ausgewählt sind; zumindest eines von X₄ und X₅ für ein Stickstoffatom steht; X₅ zusammen mit Ir in den Formeln (2) bis (4) eine Koordinationsbindung ausbildet; X₆ bis X₁₁ für eine Gruppe von Elementen stehen, welche einen 6-gliedrigen aromatischen Ring ausbilden, und aus einem Kohlenstoffatom oder einem Stickstoffatom ausgewählt sind; X₇ zusammen mit Ir in den Formeln (2) bis (4) eine kovalente Bindung ausbildet,
**dadurch gekennzeichnet, dass**
(a) die maximale Emissionswellenlänge der Iridiumkomplexverbindung 470 nm oder weniger beträgt, wie in Übereinstimmung mit dem in der Beschreibung offenbarten Verfahren bestimmt, und, was zumindest eines von L₁ bis L₃ aus der Reihe von L₁ bis L₃ in den Formeln (2) bis (4) betrifft, die Formel (5) durch nachfolgende Formel (6) oder nachfolgende Formel (8) dargestellt wird: 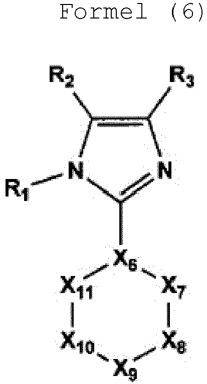 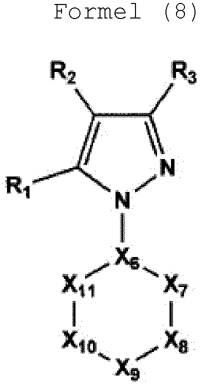 wobei in den Formeln (6) und (8) X₆ bis X₁₁ die gleichen Bedeutungen besitzen, wie es für X₆ bis X₁₁ in Formel (5) definiert ist; R₁, R₂ und R₃ jeweils für ein Wasserstoffatom oder einen Substituenten stehen; und R₁ und X₁₁ einen Ring ausbilden können; oder
(b) die maximale Emissionswellenlänge der Iridiumkomplexverbindung 460 nm oder weniger beträgt, wie in Übereinstimmung mit dem in der Beschreibung offenbarten Verfahren bestimmt, und in zumindest einem von L₁ bis L₃ aus der Reihe von L₁ bis L₃ in den Formeln (2) bis (4) der von X₁ bis X₅ in Formel (5) ausgebildete stickstoffhaltige heterozyklische Ring ein Triazolring ist.

2. Organisches Elektrolumineszenzelement gemäß Anspruch 1 oder 2, **dadurch gekennzeichnet, dass**, was zumindest eines von L₁ bis L₃ in den Formeln (2) bis (4) betrifft, die Formel (5) durch nachfolgende Formel (7) dargestellt wird: 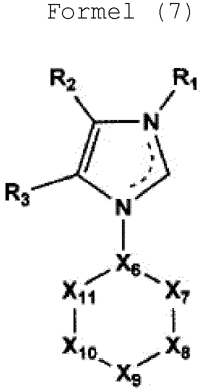 wobei in Formel (7) X₆ bis X₁₁ die gleichen Bedeutungen besitzen, wie es für X₆ bis X₁₁ in Formel (5) definiert ist; R₁, R₂ und R₃ jeweils für ein Wasserstoffatom oder einen Substituenten stehen; und R₃ und X₁₁ einen Ring ausbilden können.

3. Organisches Elektrolumineszenzelement gemäß Anspruch 1 oder 2, **dadurch gekennzeichnet, dass**, was zumindest eines von L₁ bis L₃ in den Formeln (2) bis (4) betrifft, die Formel (5) durch nachfolgende Formel (9) dargestellt wird: 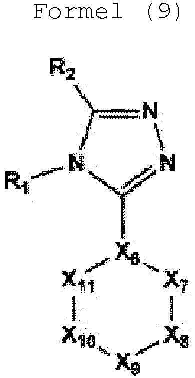 wobei in Formel (9) X₆ bis X₁₁ die gleichen Bedeutungen besitzen, wie es für X₆ bis X₁₁ in Formel (5) definiert ist; R₁ und R₂ jeweils für ein Wasserstoffatom oder einen Substituenten stehen; und R₁ und X₁₁ einen Ring ausbilden können.

4. Organisches Elektrolumineszenzelement gemäß einem der Ansprüche 1 bis 3, **dadurch gekennzeichnet, dass**, wenn die Iridiumkomplexverbindung wie in Variante (a) von Anspruch 1 definiert ist, die maximale Emissionswellenlänge der durch eine der Formeln (2) bis (4) dargestellten Iridiumkomplexverbindung 465 nm oder weniger beträgt.

5. Organisches Elektrolumineszenzelement gemäß einem der Ansprüche 1 bis 4, **dadurch gekennzeichnet, dass**, wenn die Iridiumkomplexverbindung wie in Variante (a) von Anspruch 1 definiert ist, die maximale Emissionswellenlänge der durch eine der Formeln (2) bis (4) dargestellten Iridiumkomplexverbindung 460 nm oder weniger beträgt.

6. Organisches Elektrolumineszenzelement gemäß einem der Ansprüche 1 bis 5, **dadurch gekennzeichnet, dass** das V in den Formeln (2) bis (4) über X₉ in den Formeln (5), (6), (8) oder (9) mit L₁ bis L₃ verknüpft ist.

7. Organisches Elektrolumineszenzelement gemäß einem der Ansprüche 1 bis 6, **dadurch gekennzeichnet, dass** die Farbe des emittierten Lichts weiß ist.

8. Beleuchtungsvorrichtung, welche das organische Elektrolumineszenzelement (10) gemäß einem der Ansprüche 1 bis 7 umfasst.

9. Anzeigevorrichtung, welche das organische Elektrolumineszenzelement (10) gemäß einem der Ansprüche 1 bis 7 umfasst.

## Revendications

1. Elément électroluminescent organique (10) comprenant au moins une couche organique incluant une couche luminescente (205B, 205G, 205R) interposée entre une électrode positive et une électrode négative (105, 206), dans lequel la couche luminescente (205B, 205G, 205R) contient un composé complexe d'iridium représenté par l'une quelconque des formules (2) à (4) : 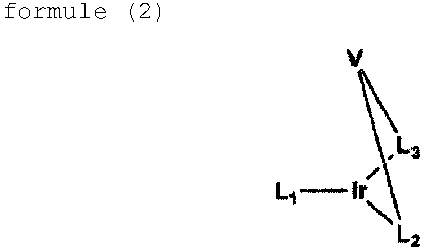 dans lequel, dans la formule (2), V représente un groupe de liaison divalent et est lié à L₂ et L₃ par liaison covalente ; et L₁ à L₃ sont respectivement représentés par la formule (5) qui suit ; 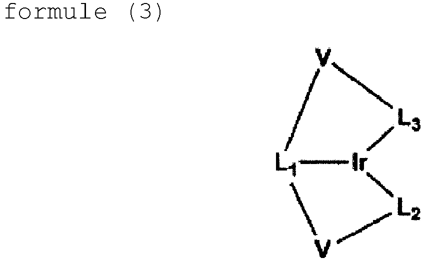 dans lequel, dans la formule (3), chaque V représente un groupe de liaison divalent et est respectivement lié à L₁, L₂ et L₃ par liaison covalente ; et chacun de L₁ à L₃ est représenté par la formule (5) qui suit ; 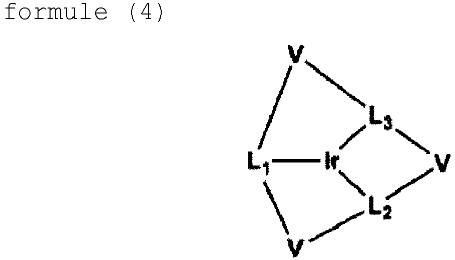 dans lequel, dans la formule (4), chaque V représente un groupe de liaison divalent et est respectivement lié à L₁, L₂ et L₃ par liaison covalente ; et L₁ à L₃ sont respectivement représentés par la formule (5) qui suit ; 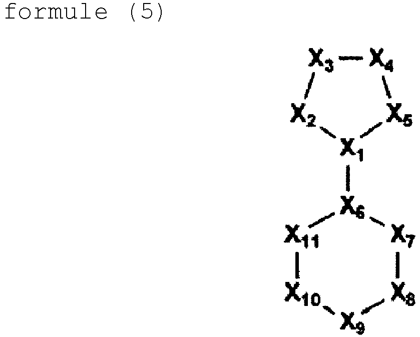 dans lequel, dans la formule (5), X₁ à X₅ sont des groupes d'éléments qui forment un hétérocycle azoté, et sont choisis parmi un atome de carbone et un atome d'azote ; au moins l'un de X₄ et X₅ représente un atome d'azote ; X₅ forme une liaison de coordination avec Ir dans les formules (2) à (4) ; X₆ à X₁₁ sont des groupes d'éléments qui forment un cycle aromatique à 6 chaînons, et sont choisis parmi un atome de carbone et un atome d'azote ; X₇ forme une liaison covalente avec Ir dans les formules (2) à (4),
**caractérisé en ce que**
(a) la longueur d'onde d'émission maximale du composé complexe d'iridium est de 470 nm ou moins, telle que déterminée conformément au procédé divulgué dans la description, et, concernant au moins l'un de L₁ à L₃ parmi L₁ à L₃ dans les formules (2) à (4), la formule (5) est représentée par la formule (6) qui suit ou la formule (8) qui suit : 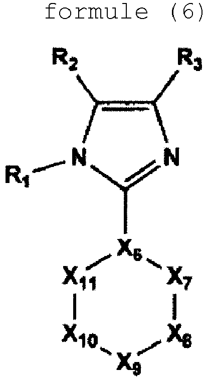 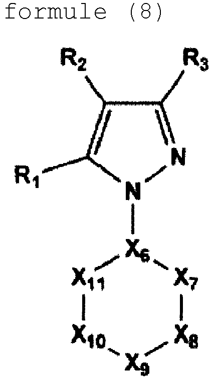 dans lequel, dans les formules (6) à (8), X₆ à X₁₁ ont les mêmes significations que celles définies pour X₆ à X₁₁ dans la formule (5) ; chacun de R₁, R₂ et R₃ représente un atome d'hydrogène ou un substituant ; et R₁ et X₁₁ peuvent former un cycle ; ou
(b) la longueur d'onde d'émission maximale du composé complexe d'iridium est de 460 nm ou moins, telle que déterminée conformément au procédé divulgué dans la description, et, dans au moins l'un de L₁ à L₃ parmi L₁ à L₃ dans les formules (2) à (4), l'hétérocycle azoté formé par X₁ à X₅ dans la formule (5) est un cycle triazole.

2. Elément électroluminescent organique selon la revendication 1 ou 2, **caractérisé en ce que**, concernant au moins l'un de L₁ à L₃ dans les formules (2) à (4), la formule (5) est représentée par la formule (7) qui suit 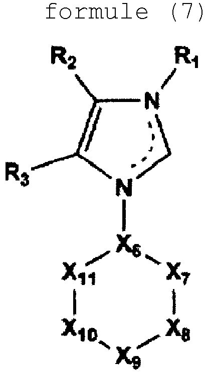 dans lequel, dans la formule (7), X₆ à X₁₁ ont les mêmes significations que celles définies pour X₆ à X₁₁ dans la formule (5) ; chacun de R₁, R₂ et R₃ représente un atome d'hydrogène ou un substituant ; et R₃ et X₁₁ peuvent former un cycle.

3. Elément électroluminescent organique selon la revendication 1 ou 2, **caractérisé en ce que**, concernant au moins l'un de L₁ à L₃ dans les formules (2) à (4), la formule (5) est représentée par la formule (9) qui suit 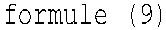 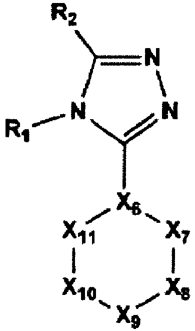 dans lequel, dans la formule (9), X₆ à X₁₁ ont les mêmes significations que celles définies pour X₆ à X₁₁ dans la formule (5) ; chacun de R₁ et R₂ représente un atome d'hydrogène ou un substituant ; et R₁ et X₁₁ peuvent former un cycle.

4. Elément électroluminescent organique selon l'une quelconque des revendications 1 à 3, **caractérisé en ce que**, lorsque le composé complexe d'iridium est tel que défini dans l'option (a) de la revendication 1, la longueur d'onde d'émission maximale du composé complexe d'iridium représenté par l'une quelconque des formules (2) à (4) est de 465 nm ou moins.

5. Elément électroluminescent organique selon l'une quelconque des revendications 1 à 4, **caractérisé en ce que**, lorsque le composé complexe d'iridium est tel que défini dans l'option (a) de la revendication 1, la longueur d'onde d'émission maximale du composé complexe d'iridium représenté par l'une quelconque des formules (2) à (4) est de 460 nm ou moins.

6. Elément électroluminescent organique selon l'une quelconque des revendications 1 à 5, **caractérisé en ce que** V dans les formules (2) à (4) est lié à L₁ à L₃ via X₉ dans les formules (5), (6), (8) ou (9).

7. Elément électroluminescent organique selon l'une quelconque des revendications 1 à 6, **caractérisé en ce que** la couleur de la lumière émise est le blanc.

8. Dispositif d'éclairage comprenant l'élément électroluminescent organique (10) de l'une quelconque des revendications 1 à 7.

9. Dispositif d'affichage comprenant l'élément électroluminescent organique (10) de l'une quelconque des revendications 1 à 7.
